# EUROPEAN PATENT SPECIFICATION

(11) **EP 4 210 450 B1**
(45) Date of publication and mention of the grant of the patent: **02.12.2026**
(21) Application number: 22199476.7
(22) Date of filing: 04.10.2022
(51) Int. Cl.: H10K 50/858, H10K 50/12, H10K 59/38, H10K 85/30, H10K 50/80, H10K 59/40, H10K 85/60, C07F 15/00

(54) **LIGHT-EMITTING DEVICE AND ELECTRONIC APPARATUS INCLUDING THE SAME**
LICHTEMITTIERENDE VORRICHTUNG UND ELEKTRONISCHE VORRICHTUNG DAMIT
DISPOSITIF ÉLECTROLUMINESCENT ET APPAREIL ÉLECTRONIQUE LE COMPRENANT

(30) Priority: 10.01.2022 KR 20220003633
(43) Date of publication of application: 12.07.2023
(73) Proprietor: Samsung Display Co., Ltd., Yongin-si, Gyeonggi-Do 17113 (KR)
(72) Inventor: Cho, Sooryun, 17113 Giheung-gu, Yongin-si, Gyeonggi-do (KR); Kim, Jihye, 17113 Giheung-gu, Yongin-si, Gyeonggi-do (KR); Kim, Hoilim, 17113 Giheung-gu, Yongin-si, Gyeonggi-do (KR); Park, Saerom, 17113 Giheung-gu, Yongin-si, Gyeonggi-do (KR); Shim, Yongsub, 17113 Giheung-gu, Yongin-si, Gyeonggi-do (KR); Yoo, Dongsun, 17113 Giheung-gu, Yongin-si, Gyeonggi-do (KR)
(74) Representative: Dr. Weitzel & Partner

(56) References cited:
- EP-A1- 3 929 193
- WO-A1-2021/140896
- BIN WANG ET AL: "Strongly phosphorescent platinum (ii) complexes supported by tetradentate benzazole-containing ligands", JOURNAL OF MATERIALS CHEMISTRY C, vol. 3, no. 31, 1 January 2015 (2015-01-01), GB, pages 8212 - 8218, XP055540969, ISSN: 2050-7526, DOI: 10.1039/C5TC01449B

## Description

### BACKGROUND

### 1. Field

The present invention provides a light-emitting device, an electronic apparatus and a consumer product according to the independent claims. The dependent claims describe preferred embodiments.

One or more embodiments of the present disclosure relate to a light-emitting device and an electronic apparatus including the same.

### 2. Description of the Related Art

From among light-emitting devices, self-emissive devices (for example, organic light-emitting devices, etc.) have wide viewing angles, excellent contrast ratios, fast response time, and excellent characteristics in terms of luminance, driving voltage and response speed.

In a light-emitting device, a first electrode is on a substrate, and a hole transport region, an emission layer, an electron transport region, and a second electrode are sequentially on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition from an excited state to a ground state to thereby generate light.

Reference is made to EP 3 929 193 A1 and WO 2021/140896 A1. Further reference is made to Bing Wang et. al., "Strongly phosphorescent platinum (ii) complexes supported by tetradentate benzazole-containing ligands", Journal of materials chemistry C, vol. 3, no. 31, 1. January 2015 (2015-01-01), pages 8212-8218.

### SUMMARY

One or more embodiments of the present disclosure include a light-emitting device having frontal luminescence efficiency and lateral luminescence efficiency at the same time, and an electronic apparatus including the light-emitting device.

The invention provides a light emitting device according to independent claim 1. Advantageous embodiements are disclosed by the dependent claims
Additional aspects of embodiments will be set forth in part in the description which follows and, in part, will be apparent from the description, or may be learned by practice of the presented embodiments of the present disclosure.

Another aspect of embodiments of the present disclosure provides an electronic apparatus including the light-emitting device.

Another aspect of embodiments of the present disclosure provides a consumer product including the light-emitting device.

### BRIEF DESCRIPTION OF THE DRAWINGS

The above and other aspects and features of certain embodiments of the present disclosure will be more apparent from the following description taken in conjunction with the accompanying drawings, in which:
FIG. 1 shows a schematic view of a light-emitting device according to an embodiment;
FIG. 2 shows a schematic view of an electronic apparatus according to an embodiment; and
FIG. 3 shows a schematic view of an electronic apparatus according to an embodiment.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of embodiments of the present description. As used herein, the term "and/or" includes any and all combinations of one or more of the associated listed items. Throughout the present disclosure, the expression "at least one of a, b or c" indicates only a, only b, only c, both a and b, both a and c, both b and c, all of a, b, and c, or variations thereof.

A light-emitting device according to an aspect of embodiments of the present disclosure may include: a first electrode; a second electrode facing the first electrode; an interlayer between the first electrode and the second electrode, including an emission layer; and a capping layer.

The emission layer may include a first emitter. The first emitter may emit a first light having a first emission spectrum, and the capping layer may be in a path along which the first light travels.

The emission peak wavelength (maximum emission wavelength, or maximum emission peak wavelength) of the first light is from about 520 nm to about 550 nm.

For example, the emission peak wavelength of the first light may be about 520 nm to about 545 nm, about 525 nm to about 550 nm, or about 525 nm to about 545 nm.

A full width at half maximum (FWHM) of the first light may be about 15 nm to about 60 nm.

For example, the FWHM of the first light may be about 20 nm to about 60 nm, or about 25 nm to about 60 nm.

The emission peak wavelength and FWHM of the first light described in the present specification may be evaluated from the emission spectrum of a film including the first emitter (for example, see Evaluation Example 2). The emission peak wavelength in the present specification refers to the peak wavelength having the maximum emission intensity in the emission spectrum or electroluminescence spectrum.

The first light having the emission peak wavelength and FWHM as described above may be green light.

The first emitter includes platinum.

The first emitter is an organometallic compound according to claim 1 containing platinum. The first emitter may be neutral, may include one platinum atom, and may not include transition metals other than platinum. For example, the first emitter may be free of transition metals other than platinum.

The first emitter includes, in addition to the platinum, a first ligand bound to the platinum.

The first emitter satisfies at least one selected from Condition A to Condition C:

### Condition A

The first ligand is a tetradentate ligand, and the number of cyclometallated rings formed by a chemical bond between the platinum and the first ligand is three. Condition B

The platinum is chemically bonded to a carbon, a nitrogen, and an oxygen of the first ligand.

### Condition C

The first ligand includes an imidazole group, a benzimidazole group, a naphthoimidazole group, or any combination thereof.

In an embodiment, the first emitter may satisfy all of Condition A to Condition C.

More details for the first emitter are as described herein.

The capping layer is in a path along which the first light travels and is extracted to the outside of the light-emitting device, thereby increasing the external extraction rate of the first light.

The capping layer includes an amine-containing compound according to claim 1. For example, CBP does not belong to the amine-containing compound described in the present specification.

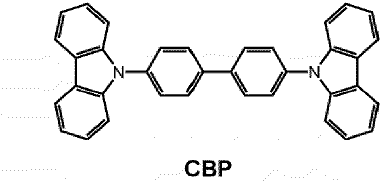

A value of a ratio of CIEy to a reflective index (RCR value) of the first light extracted to the outside through the capping layer may be 38 or less. In this regard, the RCR value is calculated by Equation 1: $CIEy / R \left(cap\right) \times 100$ Equation 1
wherein, in Equation 1,
CIEy is a y coordinate value of CIE color coordinates of the first light extracted to the outside through the capping layer, and
R(cap) is the refractive index of the amine-containing compound with respect to a second light having a wavelength within ± 20 nm of the emission peak wavelength of the first light. For example, the R(cap) may be the refractive index of the amine-containing compound with respect to a second light having a wavelength within ± 15 nm of the emission peak wavelength of the first light (for example, a wavelength within ± 10 nm of the emission peak wavelength of the first light, or a wavelength within ± 5 nm of the emission peak wavelength of the first light).

In an embodiment, the RCR value of the first light extracted through the capping layer may be 32.0 to 38.0, 32.5 to 38.0, 33.0 to 38.0, 33.5 to 38.0, 34.0 to 38.0, 34.5 to 38.0, 35.0 to 38.0, 35.5 to 38.0, 36.0 to 38.0, 32.0 to 37.5, 32.5 to 37.5, 33.0 to 37.5, 33.5 to 37.5, 34.0 to 37.5, 34.5 to 37.5, 35.0 to 37.5, 35.5 to 37.5, or 36.0 to 37.5.

When the emission peak wavelength of the first light is from about 520 nm to about 550 nm, and the RCR value of the first light extracted to the outside through the capping layer satisfies the ranges as described above, the light-emitting device has excellent frontal (0°) luminescence efficiency and lateral luminescence efficiency (for example, at a location moved 45° from the front (0°)) at the same time (e.g., excellent frontal luminescence efficiency at a viewing angle of 90° relative to a display surface of the light-emitting device and/or excellent lateral luminescence efficiency at a viewing angle of 45° relative to the display surface of the light-emitting device). By using such a light-emitting device, a high-quality electronic apparatus can be manufactured.

In an embodiment, the CIEy may be 0.70 to 0.74, 0.70 to 0.735, 0.70 to 0.73, 0.70 to 0.725, 0.705 to 0.74, 0.705 to 0.735, 0.705 to 0.73, 0.705 to 0.725, 0.71 to 0.74, 0.71 to 0.735, 0.71 to 0.73, 0.71 to 0.725, 0.715 to 0.74, 0.715 to 0.735, 0.715 to 0.73, or 0.715 to 0.725. CIE is a system developed by the Commission Internationale de L'Eclairage (CIE, the International Commission on Illumination).

The R(cap) may be evaluated by actually measuring the refractive index of a film consisting of the amine-containing compound (see, for example, Evaluation Example 3).

In an embodiment, the R(cap) may be the refractive index of the amine-containing compound with respect to a second light having a wavelength of 530 nm.

In an embodiment, the R(cap) may be 1.85 or more.

In an embodiment, the R(cap) may be 1.85 to 2.5, 1.90 to 2.5, 1.95 to 2.5, 1.85 to 2.45, 1.90 to 2.45, 1.95 to 2.45, 1.85 to 2.4, 1.90 to 2.4, 1.95 to 2.4, 1.85 to 2.35, 1.90 to 2.35, 1.95 to 2.35, 1.85 to 2.3, 1.90 to 2.3, 1.95 to 2.3, 1.85 to 2.25, 1.90 to 2.25, 1.95 to 2.25, 1.85 to 2.2, 1.90 to 2.2, 1.95 to 2.2, 1.85 to 2.15, 1.90 to 2.15, 1.95 to 2.15, 1.85 to 2.1, 1.90 to 2.1, or 1.95 to 2.1.

According to another aspect of embodiments, the light-emitting device includes: a first electrode; a second electrode facing the first electrode; an interlayer between the first electrode and the second electrode, including an emission layer; and a capping layer, wherein the emission layer includes a first emitter, the first emitter emits a first light having a first emission spectrum, and the capping layer is in a path along which the first light travels, the first emitter includes platinum and a first ligand bound to the platinum, the first emitter satisfies at least one selected from Condition A to Condition C, the capping layer includes an amine-containing compound, and the amine-containing compound includes a benzoxazole group, a benzothiazole group, a naphthooxazole group, a naphthothiazole group, or any combination thereof.

The first light, the first emitter, and the amine-containing compound are the same as described above.

In an embodiment, the first emitter may satisfy all of Condition A to Condition C.

The emission peak wavelength of the first light is about 520 nm to about 550 nm.

In an embodiment, the emission peak wavelength of the first light may be about 520 nm to about 545 nm, about 525 nm to about 550 nm, or about 525 nm to about 545 nm.

In an embodiment, the full width at half maximum (FWHM) of the first light is 15 nm to 60 nm, 20 nm to 60 nm, or 25 nm to 60 nm.

The first light having the emission peak wavelength and FWHM as described above may be green light.

In an embodiment, the refractive index of the amine-containing compound with respect to the second light having a wavelength within ± 20 nm of the emission peak wavelength of the first light (for example, a wavelength within ± 15 nm of the emission peak wavelength of the first light, a wavelength within ± 10 nm of the emission peak wavelength of the first light, or a wavelength within ± 5 nm of the emission peak wavelength of the first light) may be 1.85 or more, 1.85 to 2.5, 1.90 to 2.5, 1.95 to 2.5, 1.85 to 2.45, 1.90 to 2.45, 1.95 to 2.45, 1.85 to 2.4, 1.90 to 2.4, 1.95 to 2.4, 1.85 to 2.35, 1.90 to 2.35, 1.95 to 2.35, 1.85 to 2.3, 1.90 to 2.3, 1.95 to 2.3, 1.85 to 2.25, 1.90 to 2.25, 1.95 to 2.25, 1.85 to 2.2, 1.90 to 2.2, 1.95 to 2.2, 1.85 to 2.15, 1.90 to 2.15, 1.95 to 2.15, 1.85 to 2.1, 1.90 to 2.1, or 1.95 to 2.1.

As described above, a light-emitting device concurrently (e.g., simultaneously) including i) an emission layer including a first emitter which includes platinum and a first ligand bound to the platinum, and satisfies at least one selected from Condition A to Condition C, and ii) a capping layer including an amine-containing compound, wherein the amine-containing compound includes a benzoxazole group, a benzothiazole group, a naphthooxazole group, a naphthothiazole group, or any combination thereof, may have excellent frontal luminescence efficiency and lateral luminescence efficiency at the same or substantially the same time, and accordingly, a high-quality electronic apparatus can be manufactured by using such a light-emitting device.

In an embodiment, the first emitter may include at least one deuterium.

In an embodiment, the highest occupied molecular orbital (HOMO) energy level of the first emitter may be -5.30 eV to -4.70 eV or -5.25 eV to -4.80 eV. One eV may also be expressed as 1,6022·10-19 Joule.

In an embodiment, the lowest unoccupied molecular orbital (LUMO) energy level of the first emitter may be -2.55 eV to -2.30 eV or -2.45 eV to -1.90 eV.

In an embodiment, the LUMO energy level of the first emitter may be -2.65 eV to -2.00 eV or -2.55 eV to -2.30 eV.

The HOMO and LUMO energy levels may be evaluated through cyclic voltammetry analysis (for example, Evaluation Example 1) of the organometallic compound.

In an embodiment, the triplet (T₁) energy of the first emitter may be 2.10 eV to 2.60 eV or 2.20 eV to 2.50 eV.

The evaluation method for the triplet energy of the first emitter may be understood by referring to, for example, Evaluation Example 2.

The emission layer may further include, in addition to the first emitter, a host, an auxiliary dopant, a sensitizer, a delayed fluorescence material, or any combination thereof. Each of the host, the auxiliary dopant, the sensitizer, the delayed fluorescence material, or any combination thereof may include at least one deuterium.

For example, the emission layer may include the first emitter and the host. The host may be different from the first emitter, and the host may include an electron-transporting compound, a hole-transporting compound, a bipolar compound, or any combination thereof. In some embodiments, the host may not include metal. The electron-transporting compound, the hole-transporting compound, and the bipolar compound are different from each other.

In an embodiment, the emission layer includes the first emitter and a host, and the host may include an electron-transporting compound and a hole-transporting compound. The electron-transporting compound and the hole-transporting compound may form an exciplex.

For example, the electron-transporting compound may include at least one π electron-deficient nitrogen-containing C₁-C₆₀ cyclic group. For example, the electron-transporting compound may include a pyridine group, a pyrimidine group, a pyrazine group, a pyridazine group, a triazine group, or any combination thereof.

In an embodiment, the hole-transporting compound may include at least one π electron-rich C₃-C₆₀ cyclic group, a pyridine group, or a combination thereof, and may not include an electron-transporting group (for example, a π electron-deficient nitrogen-containing C₁-C₆₀ cyclic group, a cyano group, a sulfoxide group, and a phosphine oxide group, not a pyridine group).

In an embodiment, the following compounds may be excluded from the hole-transporting compound.

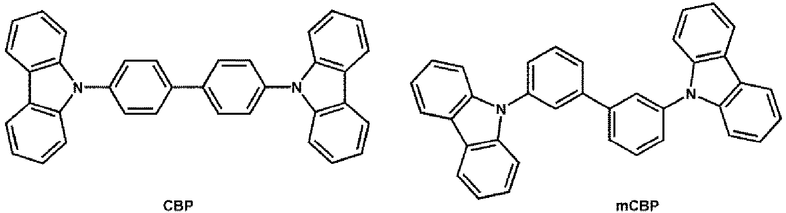

In an embodiment, the electron-transporting compound may include a compound represented by Formula 2-1 or a compound represented by Formula 2-2: 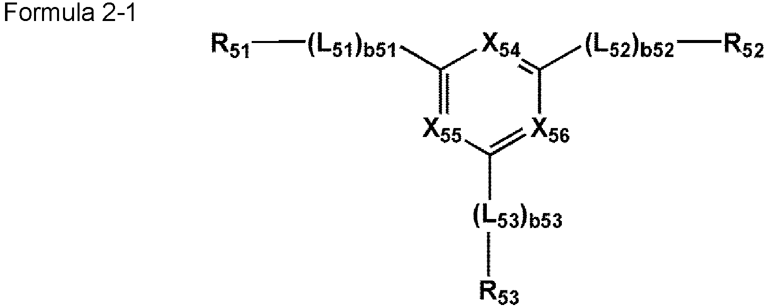 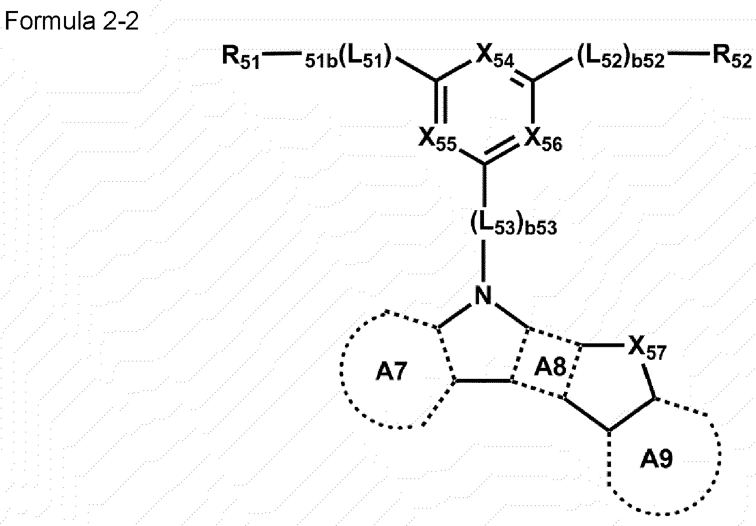 wherein, in Formulae 2-1 and 2-2,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
A7 to A9 may each independently be a C₃-C₆₀ carbocyclic group unsubstituted or substituted with at least one R₁₀ₐ or a C₁-C₆₀ heterocyclic group unsubstituted or substituted with at least one R₁₀ₐ (for example, a benzene group or a naphthalene group, each unsubstituted or substituted with at least one R₁₀ₐ),
X₅₄ is N or C(R₅₄), X₅₅ is N or C(R₅₅), X₅₆ is N or C(R₅₆), and at least one selected from X₅₄ to X₅₆ is N,
X₅₇ may be O, S, N(R₅₇), C(R₅₇ₐ)(R_{57b}), or Si(R₅₇ₐ)(R_{57b}), and
R_{51 to} R₅₇, R₅₇ₐ, R_{57b}, and R₁₀ₐ are each the same as described herein.

In an embodiment, the hole-transporting compound may include a compound represented by Formula 3-1, a compound represented by Formula 3-2, a compound represented by Formula 3-3, a compound represented by Formula 3-4, a compound represented by Formula 3-5, or any combination thereof: 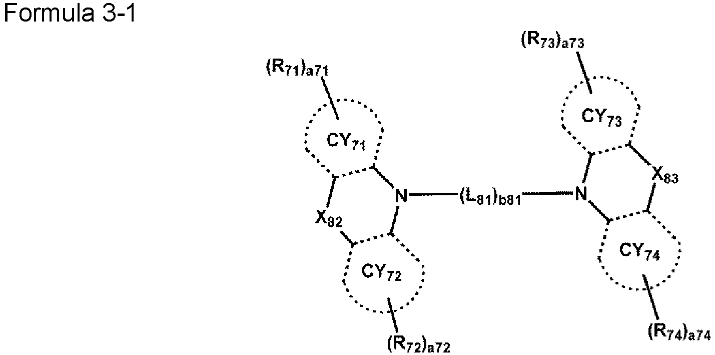 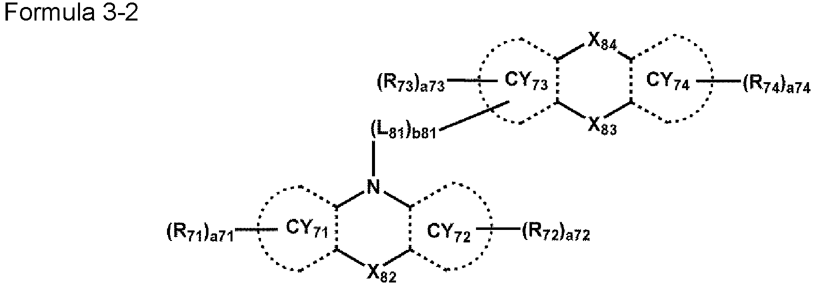 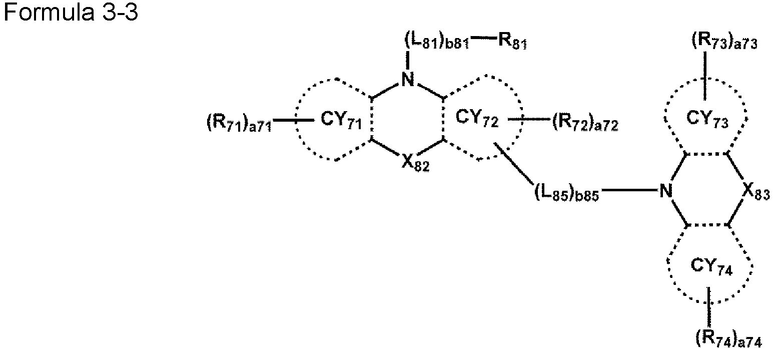 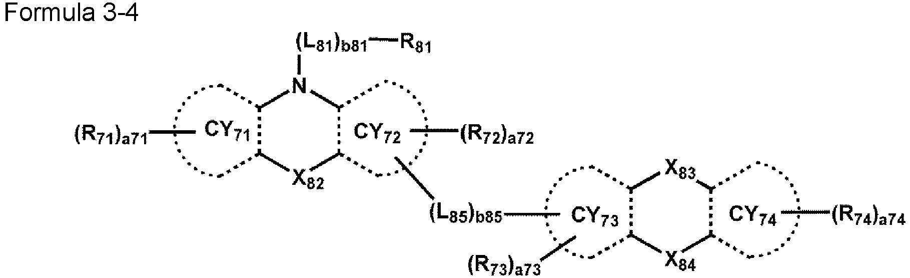 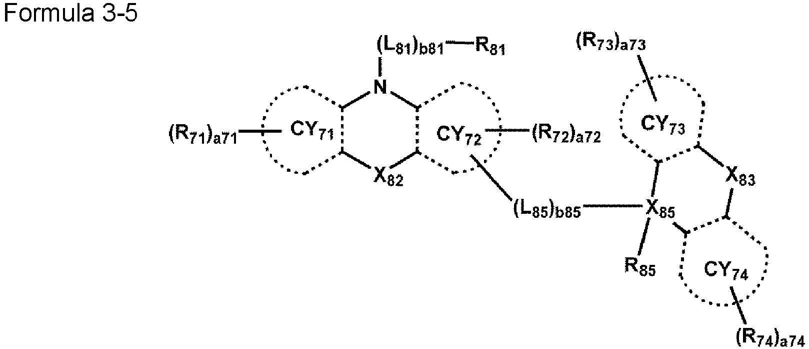 wherein, in Formulae 3-1 to 3-5,
ring CY₇₁ to ring CY₇₄ may each independently be a π electron-rich C₃-C₆₀ cyclic group (for example, a benzene group, a naphthalene group, a fluorene group, a anthracene group, a carbazole group, a dibenzofuran group, or a dibenzothiophene group), or a pyridine group,
X₈₂ may be a single bond, O, S, N-[(L₈₂)_{b82}-R₈₂], C(R₈₂ₐ)(R_{82b}), or Si(R₈₂ₐ)(R_{82b}),
X₈₃ may be a single bond, O, S, N-[(L₈₃)_{b83}-R₈₃], C(R₈₃ₐ)(R_{83b}), or Si(R₈₃ₐ)(R_{83b}),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L_{81 to} L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ (for example, a benzene group, a naphthalene group, a fluorene group, a anthracene group, a carbazole group, a dibenzofuran group, or a dibenzothiophene group, each unsubstituted or substituted with at least one R₁₀ₐ), or a pyridine group unsubstituted or substituted with at least one R₁₀ₐ, wherein Q₄ and Q₅ are the same as described in connection with Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each be the same as described herein,
a71 to a74 may each independently be an integer from 0 to 20, and
R₁₀ₐ may be understood by referring to the description of R₁₀ₐ provided herein.

The capping layer of the light-emitting device may be outside the first electrode and/or outside the second electrode.

In an embodiment, the light-emitting device may include at least one selected from a first capping layer outside of the first electrode and a second capping layer outside of the second electrode, wherein at least one selected from the first capping layer and the second capping layer may include the amine-containing compound described in the present specification.

In an embodiment, the light-emitting device may include:
a first capping layer outside the first electrode and including the amine-containing compound described in the present specification;
a second capping layer outside the second electrode and including the amine-containing compound described in the present specification; or
the first capping layer and the second capping layer.

In an embodiment, the light-emitting device may further include a third capping layer, and the third capping layer may include a compound which is different from the amine-containing compound described in the present specification. The third capping layer may be in a path along which the first light emitted from the first emitter travels.

In an embodiment, the third capping layer may include a material having a refractive index (at a wavelength 589 nm) of 1.6 or more.

In an embodiment, the third capping layer may be an organic capping layer including an organic material, an inorganic capping layer including an inorganic material, or an organic-inorganic composite capping layer including an organic material and an inorganic material.

For example, the third capping layer may include a carbocyclic compound, a heterocyclic compound, an amine group-containing compound, a porphine derivative, a phthalocyanine derivative, a naphthalocyanine derivative, an alkali metal complex, an alkaline earth-metal complex, or any combination thereof. Optionally, the carbocyclic compound, the heterocyclic compound, and the amine group-containing compound may each be substituted with a substituent including O, N, S, Se, Si, F, Cl, Br, I, or any combination thereof.

For example, the third capping layer may include a compound represented by Formula 201, a compound represented by Formula 202, or any combination thereof.

In an embodiment, the third capping layer may include one selected from Compounds HT28 to HT33, one selected from Compounds CP1 to CP6 (Compound CP3 is identical to Compound B02 and Compounds CP1 to CP6 are distinguishable from Compounds CP01 to CP06 described in the present specification, respectively), β-NPB, or any compound thereof:

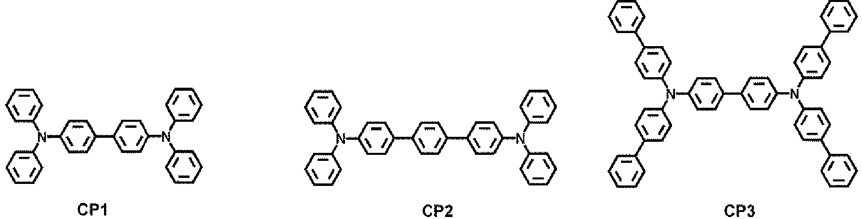

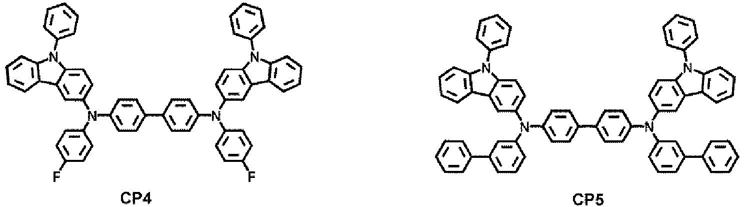

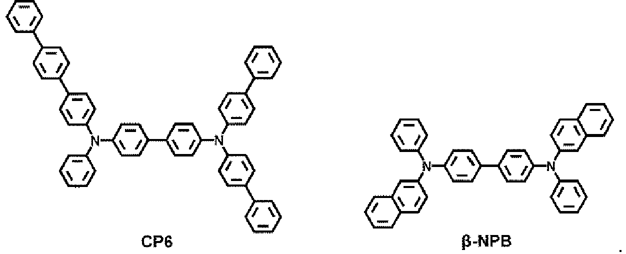

In one or more embodiments, the light-emitting device may further include:
i) a structure in which the first electrode, the interlayer, the second electrode, and the second capping layer (including the amine-containing compound described in the present specification) are sequentially stacked;
ii) a structure in which the first electrode, the interlayer, the second electrode, the third capping layer (containing a compound different from the amine-containing compound described in the present specification), and the second capping layer (including the amine-containing compound described in the present specification) are sequentially stacked, or
iii) a structure in which the first electrode, the interlayer, the second electrode, the second capping layer (including the amine-containing compound described in the present specification), and the third capping layer (containing a compound different from the amine-containing compound described in the present specification) are sequentially stacked.

In this regard, the first light emitted from the first emitter of the emission layer included in the interlayer may be extracted to the outside of the light-emitting device through the second electrode and then the second capping layer (or the second capping layer and the third capping layer), and the second electrode may be a semi-transmissive electrode or a transmissive electrode.

The wording "the interlayer (or, a capping layer) includes a first emitter (or an amine-containing compound)" refers to "the interlayer (or a capping layer) may include one type (or kind) of a compound belonging to the category of the first emitter or two or more types (or kinds) of different compounds belonging to the first emitter (or one type (or kind) of compound belonging to an amine-containing compound or two or more different compounds belonging to an amine-containing compound).

The term "interlayer," as used herein, refers to a single layer and/or all of a plurality of layers between the first electrode and the second electrode of the light-emitting device.

Another aspect of embodiments provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. In an embodiment, the electronic apparatus may further include a color filter, a color conversion layer, a touch screen layer, a polarizing layer, or any combination thereof. For more details on the electronic apparatus, related descriptions provided herein may be referred to.

Another aspect of embodiments of the present disclosure provides a consumer product including the light-emitting device.

For example, the consumer product may be one selected from a flat panel display, a curved display, a computer monitor, a medical monitor, a TV, a billboard, indoor or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual and/or augmented reality displays, vehicles, a video wall including multiple displays tiled together, a theater and/or stadium screen, a phototherapy device, and a signage.

### Description of Formulae

The first emitter is an organometallic compound represented by Formula 1. In addition, the amine-containing compound is a compound represented by Formula 8: 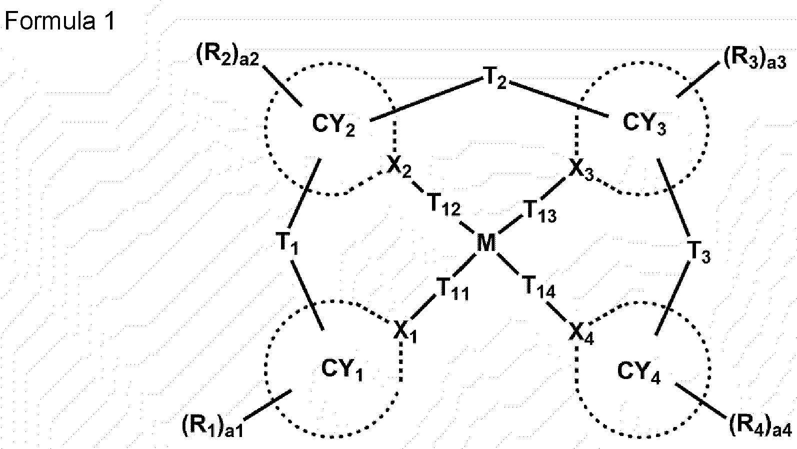 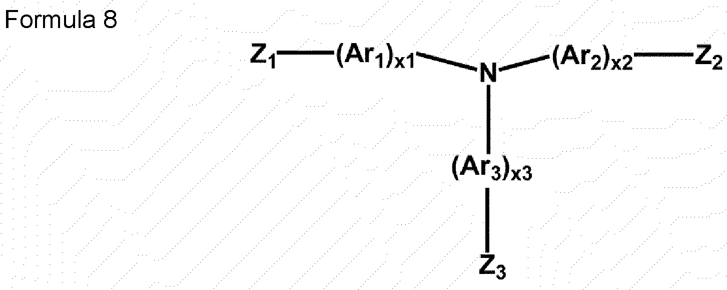 wherein, in Formulae 1 and 8,
M is Pt,
X₁ to X₄ are each independently N or C,
T₁₁ to T₁₄ is each independently a chemical bond (e.g., a single bond or a coordinate covalent bond, which is also be referred to as a dative bond), O, S, B(R'), N(R'), P(R'), C(R')(R"), Si(R')(R"), Ge(R')(R"), C(=O), B(R')(R"), N(R')(R"), or P(R')(R"),
When T₁₁ is a chemical bond, X₁ and M is directly bonded to each other, when T₁₂ is a chemical bond, X₂ and M is directly bonded to each other, when T₁₃ is a chemical bond, X₃ and M is directly bonded to each other, when T₁₄ is a chemical bond, X₄ and M is directly bonded to each other,
Two of the bonds selected from a bond between X₁ or T₁₁ and M, a bond between X₂ or T₁₂ and M, a bond between X₃ or T₁₃ and M, and a bond between X₄ or T₁₄ and M is coordinate bonds (e.g., coordinate covalent bonds, which may also be referred to as dative bonds), and the other two bonds are covalent bonds,
T₁ is a single bond, a double bond, *-N(R₅)-*', *-B(R₅)-*', *-P(R₅)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(R₅)=*', *=C(R₅)-*', *-C(R₅ₐ)=C(R_{5b})-*', *-C(=S)-*', or *-C≡C-*',
T₂ is a single bond, a double bond, *-N(R₆)-*', *-B(R₆)-*', *-P(R₆)-*', *-C(R₆ₐ)(R_{6b})-*', *-Si(R₆ₐ)(R_{6b})-*', *-Ge(R₆ₐ)(R_{6b})-*', *-S-*', *-Se-*', *-O-*', *-C(=O)-*', *-S(=O)-*', *-S(=O)₂-*', *-C(R₆)=*', *=C(R₆)-*', *-C(R₆ₐ)=C(R_{6b})-*', *-C(=S)-*', or *-C≡C-*',
T₃ is a single bond, a double bond, *-N(R₇)-*', *-B(R₇)-*', *-P(R₇)-*', *-C(R₇ₐ)(R_{7b})-*', *-Si(R₇ₐ)(R_{7b})-*', *-Ge(R₇ₐ)(R_{7b})-*', *-S-*', *-Se-*', *-O-*', *-C(=O)-*', *-S(=O)-*', *-S(=O)₂-*', *-C(R₇)=*', *=C(R₇)-*', *-C(R₇ₐ)=C(R_{7b})-*', *-C(=S)-*', or *-C≡C-*',
ring CY₁ to ring CY₄ are each independently a C₃-C₆₀ carbocyclic group or a C₁-C₆₀ heterocyclic group,
Ar₁ to Ar₃ and Z₁ to Z₃ are each independently a C₃-C₆₀ carbocyclic group unsubstituted or substituted with at least one R₁₀ₐ, or a C₁-C₆₀ heterocyclic group unsubstituted or substituted with at least one R₁₀ₐ,
x1 to x3 are each independently one selected from an integer from 0 to 10,
i) when x1 is 0, *-(Ar₁)ₓ₁-*' isa single bond, ii) when x2 is 0, *-(Ar₂)ₓ₂-*' is a single bond, and iii) when x3 is 0, *-(Ar₃)ₓ₃-*' is a single bond,
R₁ to R₇, R₅ₐ, R_{5b}, R₆ₐ, R_{6b}, R₇ₐ, R_{7b}, R', and R" are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇₋C₆₀ aryl alkyl group unsubstituted or substituted with at least one R₁₀ₐ, a C₂-C₆₀ heteroaryl alkyl group unsubstituted or substituted with at least one R₁₀ₐ,-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
a1 to a4 are each independently one selected from an integer from 0 to 20,
* and *' each indicate a binding site to an adjacent atom,
Each of i) two groups of R₁(s) in the number of a1, ii) two groups of R₂(s) in the number of a2, iii) two groups of R₃(s) in the number of a3, iv) two groups of R₄(s) in the number of a4, v) R₅ₐ and R_{5b}, vi) R₆ₐ and R_{6b}, and vii) R₇ₐ and R_{7b}, is optionally be bonded to each other via a single bond, a double bond, or a first linking group to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ is:
   deuterium, -F, -Cl, -Br, -I, a hydroxyl group, a cyano group, or a nitro group,
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof,
   a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
   Q₁ to Q₃, Q₁₁ to Q₁₃, Q₂₁ to Q₂₃, and Q₃₁ to Q₃₃ is each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In one or more embodiments, in Formula 1,
i) X₁ and X₃ may be C, and X₂ and X₄ may be N,
ii) X₁ and X₄ may be C, and X₂ and X₃ may be N, or
iii) X₁, X₂, and X₃ may be C, and X₄ may be N.

In one or more embodiments, in Formula 1,
T₁₁ may be O or S, and
T₁₂ to T₁₄ may each be a chemical bond (e.g., a single bond, or a coordinate covalent bond, which may also be referred to as a dative bond).

In one or more embodiments, regarding Formula 1,
T₁₁ may be O or S, and
T₁₂ to T₁₄ may each be a chemical bond (e.g., a single bond, or a coordinate covalent bond, which may also be referred to as a dative bond), and
i) a bond between T₁₁ and M and a bond between X₃ and M may each be a covalent bond, and a bond between X₂ and M and a bond between X₄ and M may each be a coordinate bond (e.g., a coordinate covalent bond, which may also be referred to as a dative bond), or ii) a bond between T₁₁ and M and a bond between X₄ and M may each be a covalent bond, and a bond between X₂ and M and a bond between X₃ and M may each be a coordinate bond (e.g., a coordinate covalent bond, which may also be referred to as a dative bond).

In an embodiment, each of T₁ to T₃ in Formula 1 may be a single bond.

In an embodiment, a ring CY₁ in Formula 1 may be a benzene group, a naphthalene group, a dibenzofuran group, a dibenzothiophene group, a carbazole group, a fluorene group, or a dibenzosilole group.

In an embodiment, a ring CY₂ in Formula 1 may be an imidazole group, a benzimidazole group, a naphthoimidazole group, a pyridine group, a pyrimidine group, a pyrazine group, a pyridazine group, a quinoline group, an isoquinoline group, or a quinoxaline group.

In an embodiment, a ring CY₃ in Formula 1 may be a benzene group, a naphthalene group, a dibenzofuran group, a dibenzothiophene group, a carbazole group, a fluorene group, a dibenzosilole group, a pyridine group, a pyrimidine group, a pyrazine group, a pyridazine group, a quinoline group, an isoquinoline group, a quinoxaline group, an azadibenzofuran group, an azadibenzothiophene group, an azacarbazole group, an azafluorene group, or an azadibenzosilole group.

In an embodiment, a ring CY₄ in Formula 1 may be a benzene group, a naphthalene group, a dibenzofuran group, a dibenzothiophene group, a carbazole group, a fluorene group, a dibenzosilole group, a pyridine group, a pyrimidine group, a pyrazine group, a pyridazine group, a quinoline group, an isoquinoline group, a quinoxaline group, an azadibenzofuran group, an azadibenzothiophene group, an azacarbazole group, an azafluorene group, an azadibenzosilole group, an imidazole group, a benzimidazole group, or a naphthoimidazole group.

In an embodiment, at least one of ring CY₂ and ring CY₄ of Formula 1 may be an imidazole group, a benzimidazole group, or a naphthoimidazole group.

In an embodiment, Ar₁ to Ar₃ and Z₁ to Z₃ in Formula 8 may each independently be a benzene group, a pyridine group, a pyrimidine group, a pyrazine group, a pyridazine group, a triazine group, a benzoxazole group, a benzothiazole group, a naphthooxazole group, or a naphthothiazole group, each unsubstituted or substituted with at least one R₁₀ₐ. For example, at least one selected from Z₁ to Z₃ in Formula 8 may each independently be a benzoxazole group, a benzothiazole group, a naphthooxazole group, or a naphthothiazole group, each unsubstituted or substituted with at least one R₁₀ₐ. In this regard, R₁₀ₐ may be: deuterium; a C₁-C₂₀ alkyl group substituted or unsubstituted with at least one deuterium; a C₃-C₂₀ carbocyclic group, or a C₁-C₂₀ heterocyclic group, each unsubstituted or substituted with deuterium, a C₁-C₂₀ alkyl group, a C₃-C₂₀ carbocyclic group, a C₁-C₂₀ heterocyclic group, or any combination thereof.
x1, x2, and x3 in Formula 8 respectively indicate the number of Ar₁(s), the number of Ar₂(s), and the number of Ar₃(s), and, for example, each independently 0, 1, 2, or 3.

In an embodiment, R_{1 to} R₇, R₅ₐ, R_{5b}, R₆ₐ, R_{6b}, R₇ₐ, R_{7b}, R', and R" in Formula 1 may each independently be:
hydrogen, deuterium, -F, or a cyano group;
a C₁-C₂₀ alkyl group or a C₃-C₁₀ cycloalkyl group, each unsubstituted or substituted with deuterium, -F, a cyano group, or any combination thereof; or
a phenyl group, a biphenyl group, a naphthyl group, a dibenzofuranyl group, or a dibenzothiophenyl group (or a thienyl group), each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

The term "biphenyl group," as used herein, refers to a monovalent substituent having a structure in which two benzene groups are connected to each other through a single bond.
a1 to a4 in Formula 1 respectively indicates the numbers of R₁(s) to R₄(s), and for example, may each independently be 0, 1, 2, 3, 4, 5, or 6.

In one or more embodiments, a group represented by 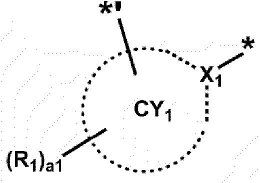 in Formula 1 may be a group represented by one selected from CY1(1) to CY1(16): 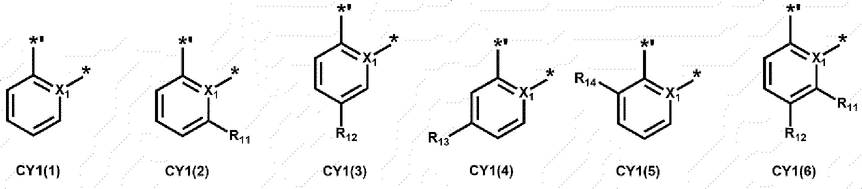 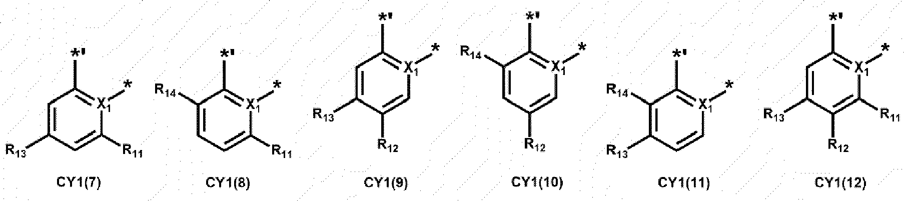 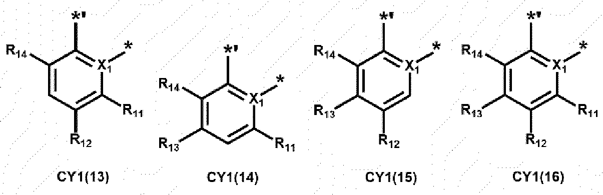 wherein, in Formulae CY1(1) to CY1(16),
X₁ is the same as described herein,
R₁₁ to R₁₄ are each the same as described in connection with R₁ in the present specification, wherein R₁₁ to R₁₄ are each not hydrogen,
* indicates a binding site to T₁₁ in Formula 1, and
*' indicates a binding site to T₁ in Formula 1.

In one or more embodiments, a group represented by 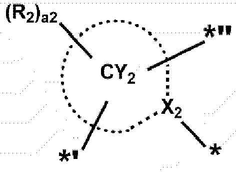 in Formula 1 may be a group represented by one selected from CY2(1) to CY2(21): 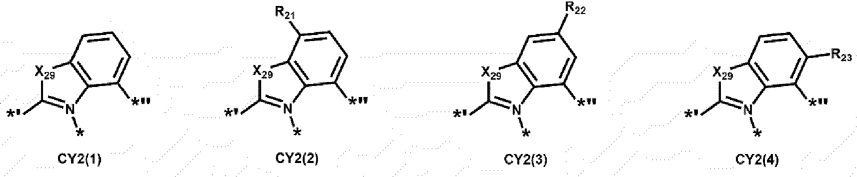 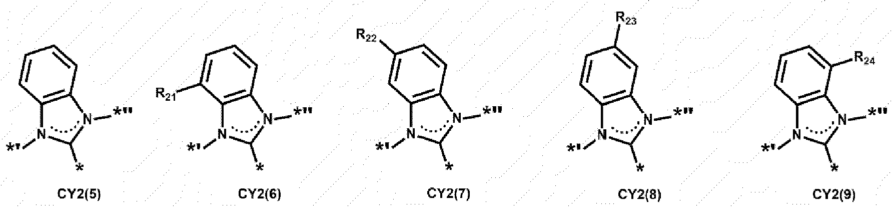 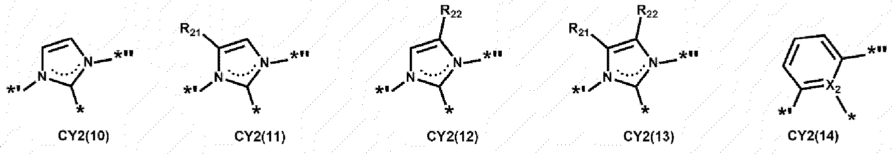 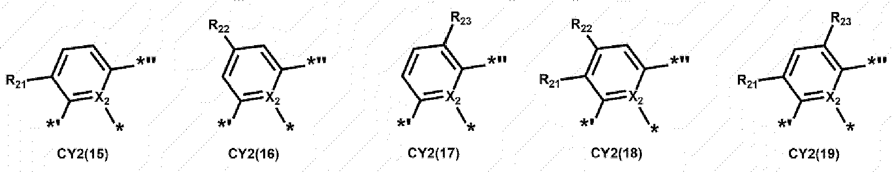 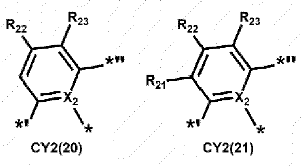 wherein, in Formulae CY2(1) to CY2(21),
X₂ is the same as described in the present specification,
X₂₉ may be O, S, N(R₂₉), C(R₂₉ₐ)(R_{29b}), or Si(R₂₉ₐ)(R_{29b}),
R₂₁ to R₂₄, R₂₉, R₂₉ₐ, and R_{29b} are each the same as described in connection with R₂ in the present specification, wherein R₂₁ to R₂₄ are each not hydrogen,
* indicates a binding site to T₁₂ in Formula 1,
*' indicates a binding site to T₁ in Formula 1, and
*" indicates a binding site to T₂ in Formula 1.

Formulae CY2(1) to CY2(4) belong to a group represented by 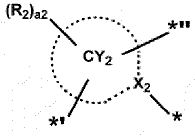 where X₂ is nitrogen, and Formulae CY2(5) to CY2(13) belong to a group represented by 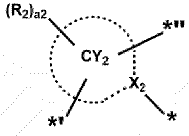 where X₂ is carbon (for example, carbon of a carbene moiety).

In one or more embodiments, a group represented by 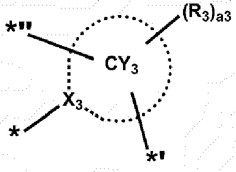 in Formula 1 may be a group represented by one selected from CY3(1) to CY3(12): 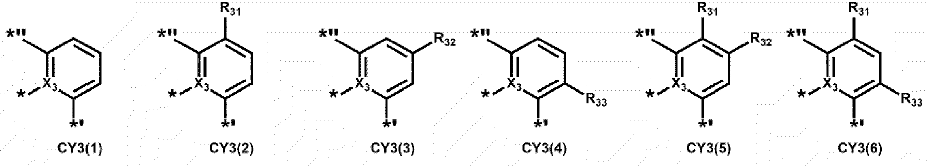 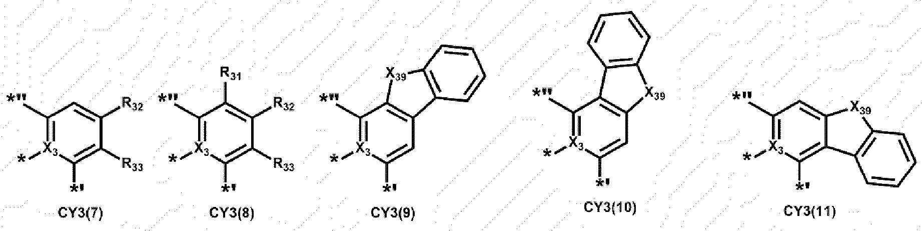 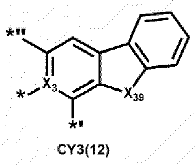 wherein, in Formulae CY3(1) to CY3(12),
X₃ is the same as described in the present specification,
X₃₉ may be O, S, N(R₃₉), C(R₃₉ₐ)(R_{39b}), or Si(R₃₉ₐ)(R_{39b}),
R₃₁ to R₃₃, R₃₉, R₃₉ₐ, and R_{39b} are each the same as described in connection with R₃ in the present specification, wherein R₃₁ to R₃₃ are each not hydrogen,
* indicates a binding site to T₁₃ in Formula 1,
*' indicates a binding site to T₃ in Formula 1, and
*" indicates a binding site to T₂ in Formula 1.

In one or more embodiments, a group represented by 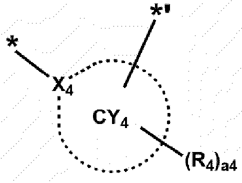 in Formula 1 may be a group represented by one selected from CY4(1) to CY4(27): 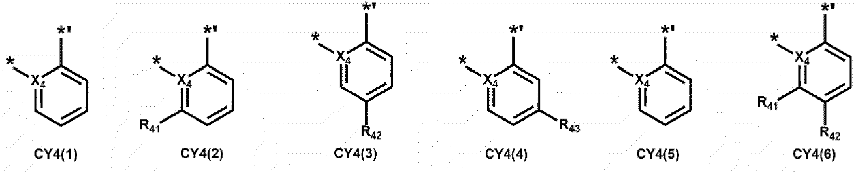 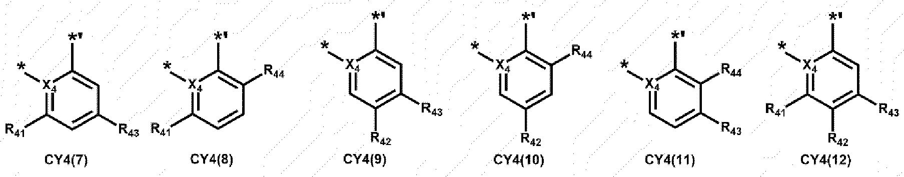 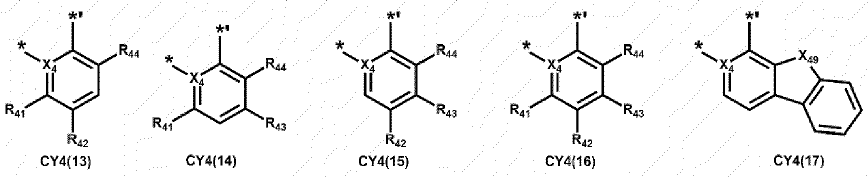 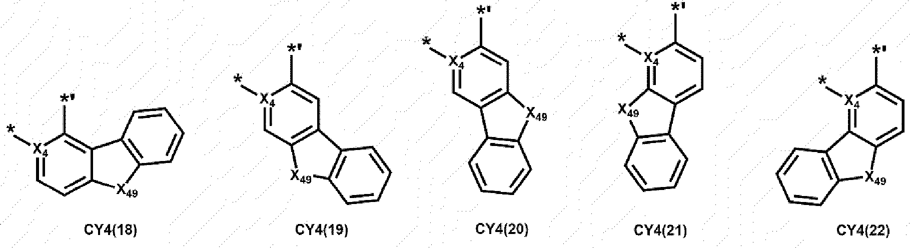 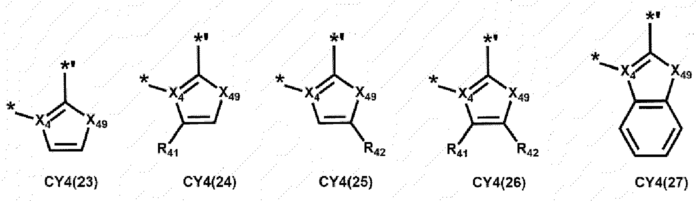 wherein, in Formulae CY4(1) to CY4(27),
X₄ is the same as described in the present specification,
X₄₉ may be O, S, N(R₄₉), C(R₄₉ₐ)(R_{49b}), or Si(R₄₉ₐ)(R_{49b}),
R₄₁ to R₄₄, R₄₉, R₄₉ₐ and R_{49b} are each the same as described in connection with R₄, and R₄₁ to R₄₄ are each not hydrogen,
* indicates a binding site to T₁₄ in Formula 1, and
*' indicates a binding site to T₃ in Formula 1.

In an embodiment, the amine-containing compound may be represented by a compound as Formula 8-1: 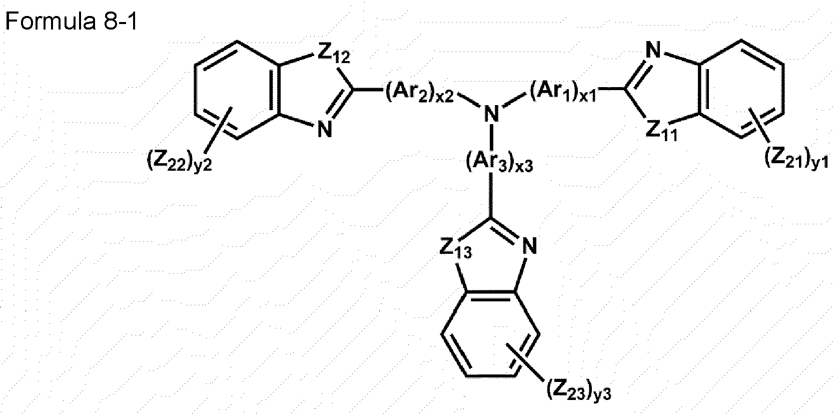 wherein, in Formula 8-1,
Ar₁ to Ar₃ and x1 to x3 are each the same as described herein,
Z₁₁ to Z₁₃ may each independently be O or S,
Z₂₁ to Z₂₃ are each the same as described in connection with R₁₀ₐ,
y1 to y3 may each independently be an integer from 0 to 4.
b51 to b53 in Formulae 2-1 and 2-2 indicate numbers of L₅₁ to L₅₃, respectively, and may each be an integer from 1 to 5. When b51 is 2 or more, two or more of L₅₁(s) may be identical to or different from each other, when b52 is 2 or more, two or more of L₅₂(s) may be identical to or different from each other, and when b53 is 2 or more, two or more of L₅₃(s) may be identical to or different from each other. In an embodiment, b51 to b53 may each independently be 1 or 2.
L₅₁ to L₅₃ in Formulae 2-1 and 2-2 may each independently be
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a oxazole group, a isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzothiazine group, a dibenzothiopyran group, a dibenzocyclohexadiene group, a dibenzodihydropyridine group, a dibenzodihydropyrazine group, an indolocarbazole group, an indolodibenzofuran group, or an indolodibenzothiophene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof,
wherein Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In Formulae 2-1 and 2-2, X₅₄ may be N or C(R₅₄), X₅₅ may be N or C(R₅₅), X₅₆ may be N or C(R₅₆), and at least one selected from X₅₄ to X₅₆ may be N. R₅₄ to R₅₆ are the same as described above. In an embodiment, two or three of X₅₄ to X₅₆ may be N.

R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ aryl alkyl group unsubstituted or substituted with at least one R₁₀ₐ, a C₂-C₆₀ heteroaryl alkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂).. Q₁ to Q₃ are the same as described in the present specification.

For example, i) R₁ to R₇, R₅ₐ, R_{5b}, R₆ₐ, R_{6b}, R₇ₐ, R_{7b}, R', and R" in Formula 1, ii) R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ, and R_{84b} in Formulae 2-1, 2-2 and 3-1 to 3-5, and iii) R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium,-F,-CI,-Br,-I,-CD₃,-CD₂H,-CDH₂,-CF₃,-CF₂H,-CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzisoxazolyl group, a benzisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof: 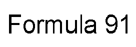 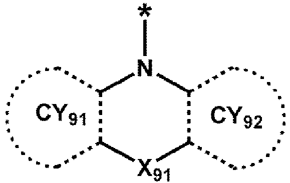
wherein, in Formula 91,
ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
X₉₁ may be a single bond, O, S, N(R₉₁), B(R₉₁), C(R₉₁ₐ)(R_{91b}), or Si(R₉₁ₐ)(R_{91b}),
R₉₁, R₉₁ₐ, and R_{91b} may respectively be understood by referring to the descriptions of R₈₂, R₈₂ₐ, and R_{82b} provided herein,
R₁₀ₐ may be understood by referring to the description of R₁₀ₐ provided herein, and
* indicates a binding site to an adjacent atom.
For example, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ,
R₉₁, R₉₁ₐ, and R_{91b} may each independently be:
   hydrogen or a C₁-C₁₀ alkyl group; or
   a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In an embodiment, i) R₁ to R₇, R₅ₐ, R_{5b}, R₆ₐ, R_{6b}, R₇ₐ, R_{7b}, R', and R" in Formula 1 ii) R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ, and R_{84b} in Formulae 2-1, 2-2, 3-1 to 3-5, 502, and 503, and iii) R₁₀ₐ may each independently be hydrogen, deuterium, -F, a cyano group, a nitro group, -CH₃, -CD₃, - CD₂H, -CDH₂, -CF₃, -CF₂H, -CFH₂, a group represented by one selected from Formulae 9-1 to 9-19, a group represented by one selected from Formulae 10-1 to 10-246, -C(Q₁)(Q₂)(Q₃), -Si(Q₁)(Q₂)(Q₃), or -P(=O)(Q₁)(Q₂) (where Q₁ to Q₃ are the same as described above) (provided that R₁₀ₐ is not hydrogen): 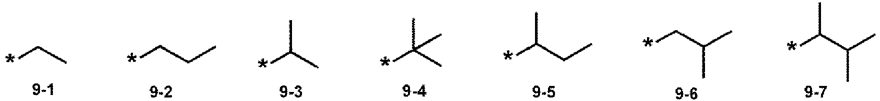 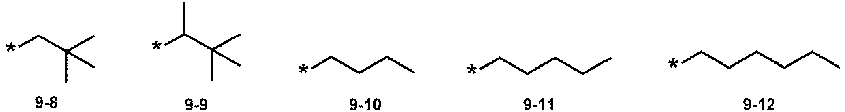 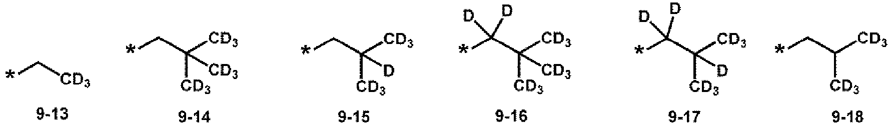 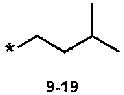 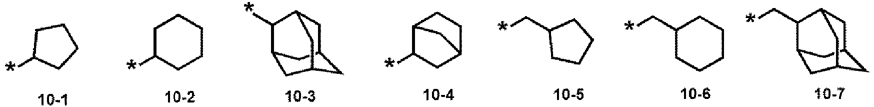 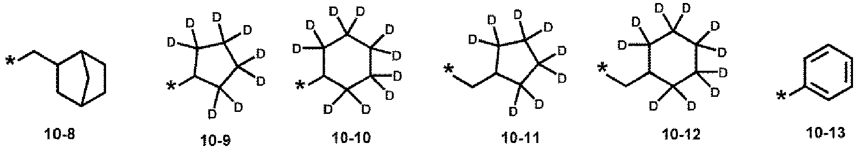 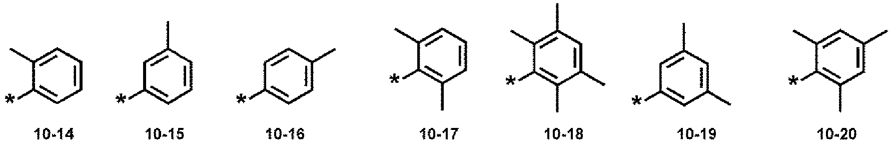 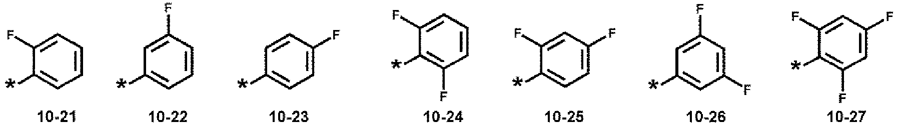 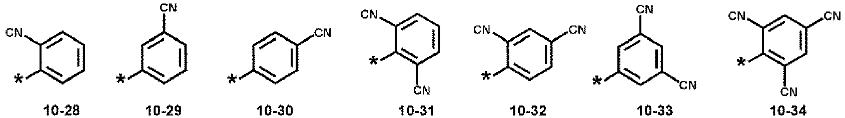 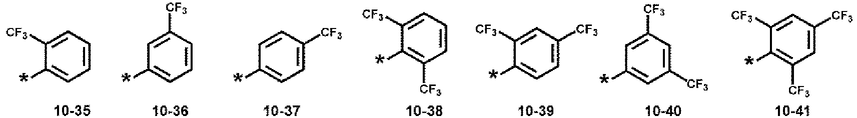 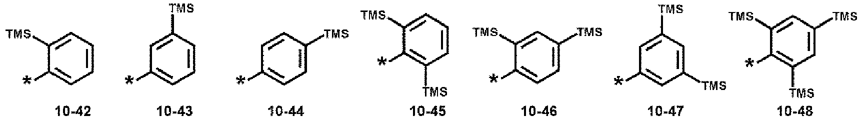 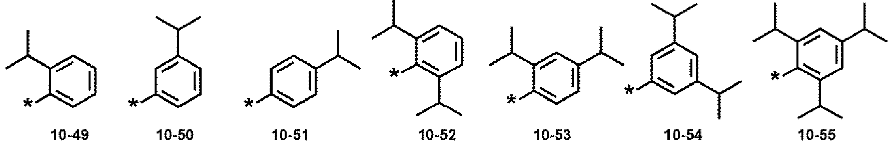 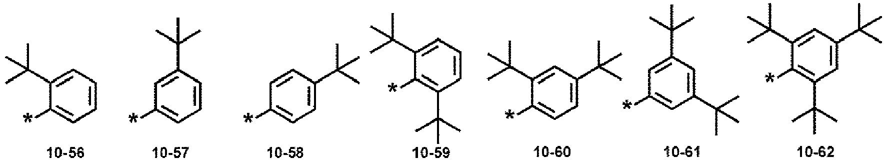 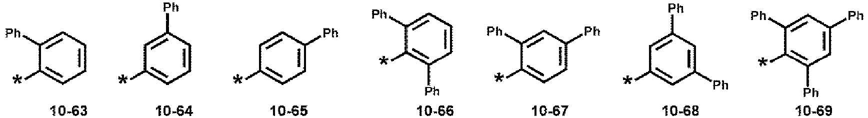 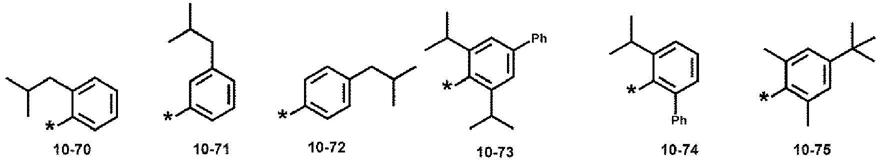 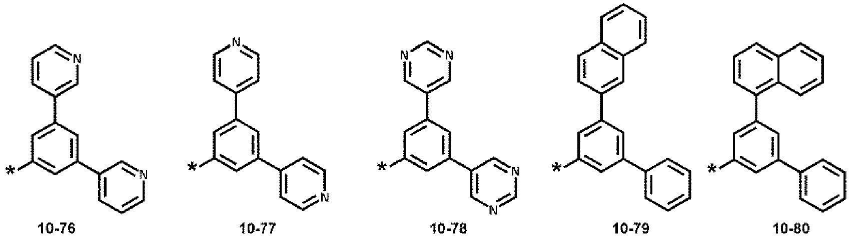 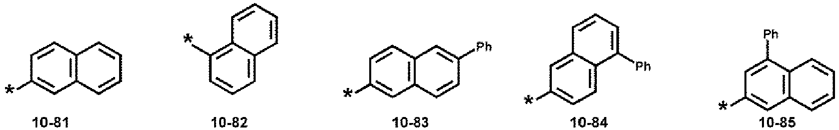 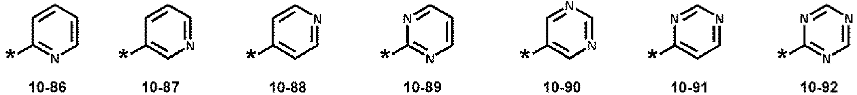 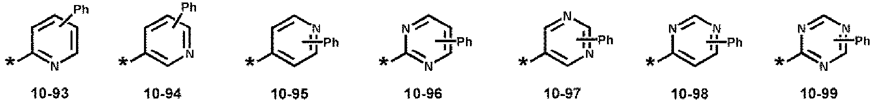 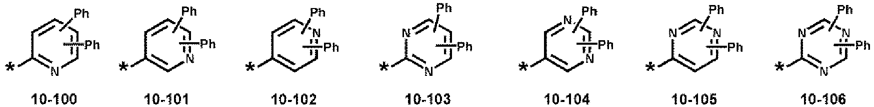 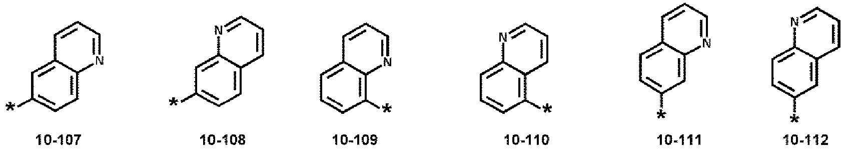 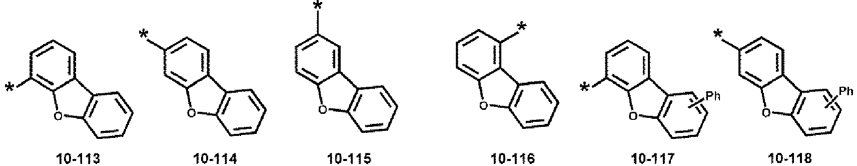 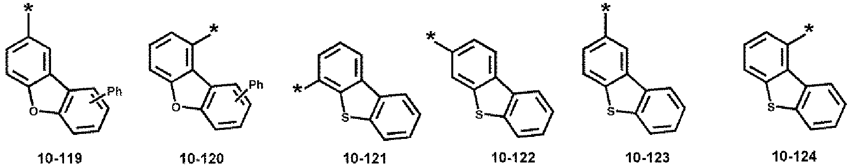 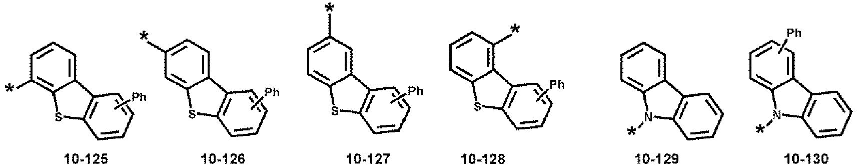 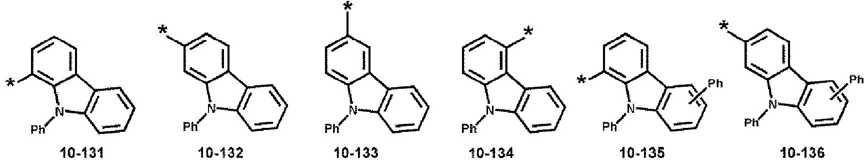 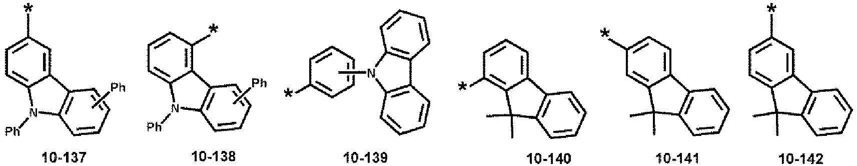 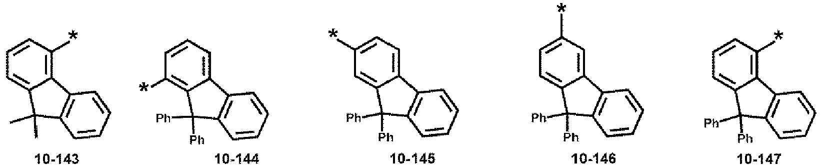 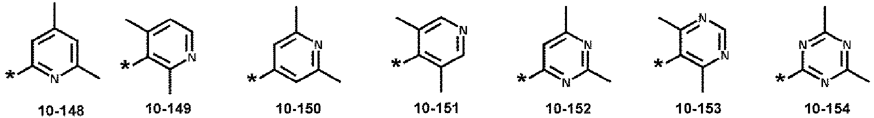 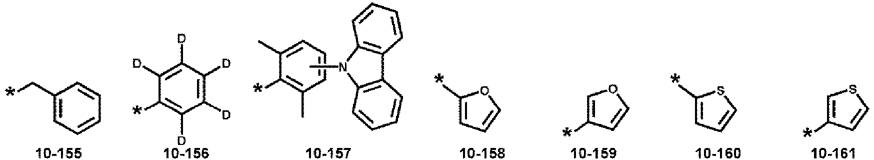 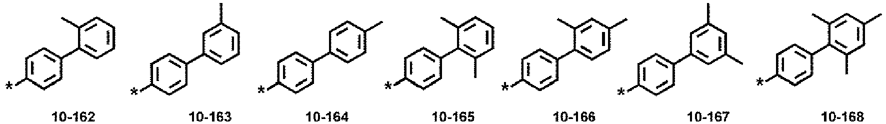 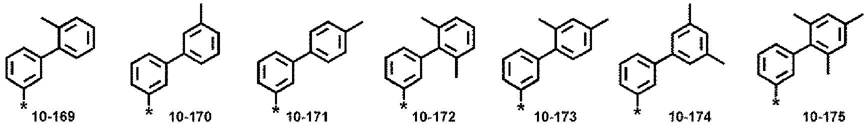 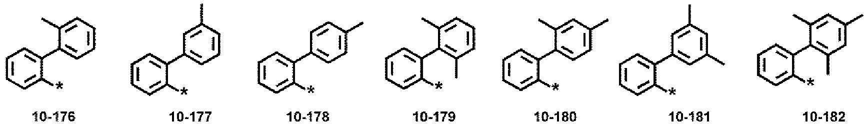 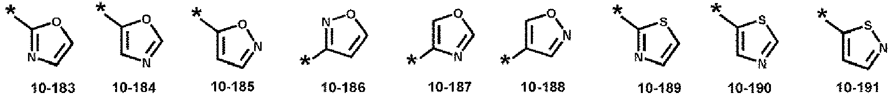 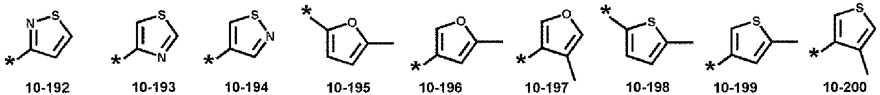 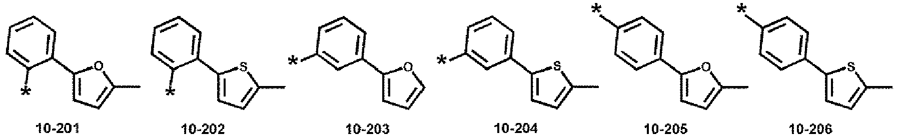 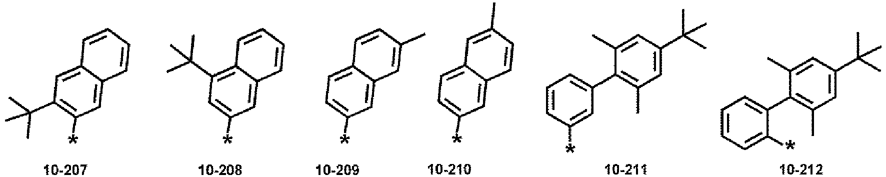 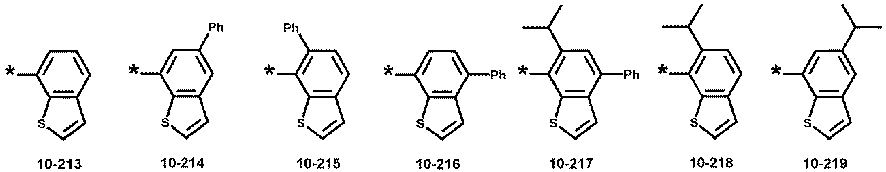 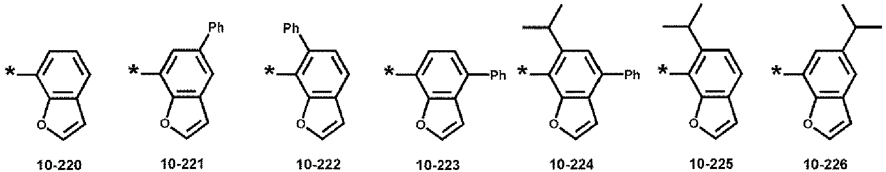 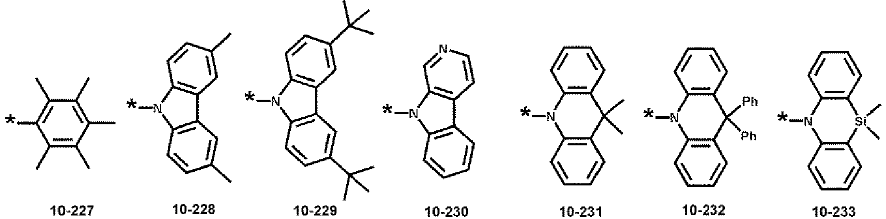 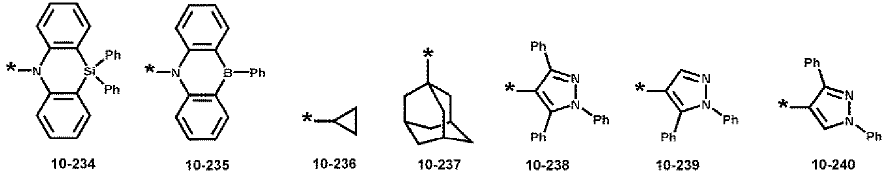 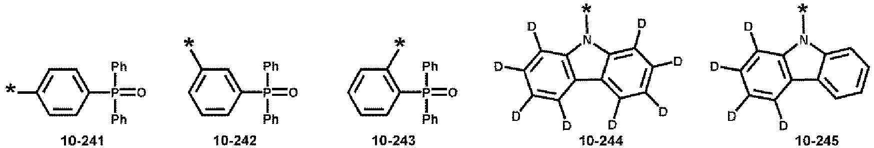 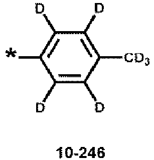
wherein, in Formulae 9-1 to 9-19 and 10-1 to 10-246, * indicates a binding site to an adjacent atom, "Ph" represents a phenyl group, and "TMS" represents a trimethylsilyl group.
a71 to a74 in Formulae 3-1 to 3-5 respectively indicate numbers of R₇₁ to R₇₄, and may each independently be an integer from 0 to 20. When a71 is 2 or more, two or more of R₇₁(s) may be identical to or different from each other, when a72 is 2 or more, two or more of R₇₂(s) may be identical to or different from each other, when a73 is 2 or more, two or more of R₇₃(s) may be identical to or different from each other, and when a74 is 2 or more, two or more of R₇₄(s) may be identical to or different from each other. a71 to a74 may each independently be an integer from 0 to 8.

In Formula 1, i) two or more of R₁(s) in the number of a1 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, ii) two or more of R₂(s) in the number of a2 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, iii) two or more of R₃(s) in the number of a3 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, iv) two or more of R₄(s) in the number of a4 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, v) R₅ₐ and R_{5b} may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, vi) R₆ₐ and R_{6b} may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, vii) R₇ₐ and R_{7b} may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

In Formulae 3-1 to 3-5, L₈₁ to L₈₅ may each independently be:
a single bond; or
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, - F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), - P(=O)(Q₃₁)(Q₃₂), or any combination thereof,
wherein Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In some embodiments, in Formulae 3-1 and 3-2, a group represented by 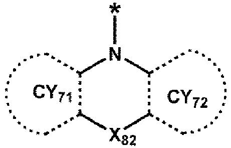 may be represented by one selected from Formulae CY71-1 (1) to CY71-1(8) and/or,
in Formulae 3-1 and 3-3, a group represented by 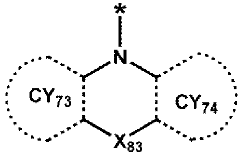 may be represented by one selected from Formulae CY71-2(1) to CY71-2(8) and/or,
in Formulae 3-2 and 3-4, a group represented by 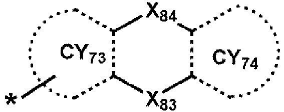 may be represented by one selected from Formulae CY71-3(1) to CY71-3(32) and/or
in Formulae 3-3 to 3-5, a group represented by 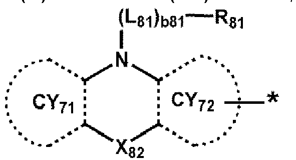 may be represented by one selected from Formulae CY71-4(1) to CY71-4(32), and/or
in Formula 3-5, a group represented by 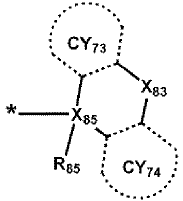 may be represented by one selected from Formulae CY71-5(1) to CY71-5(8): 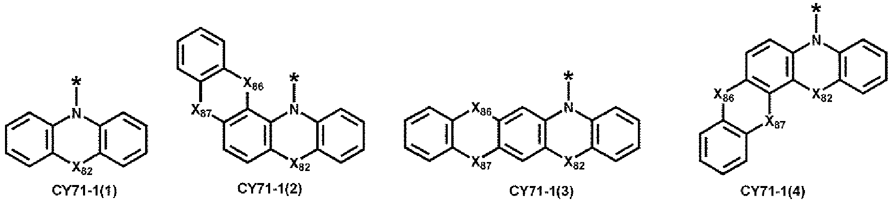 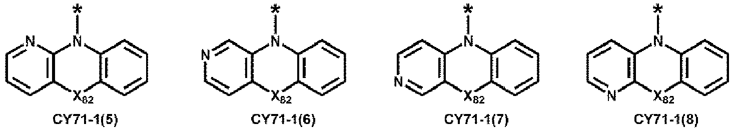 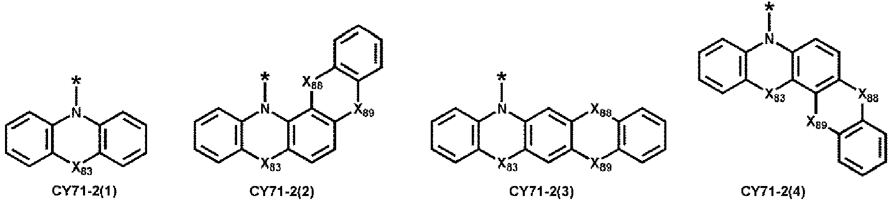 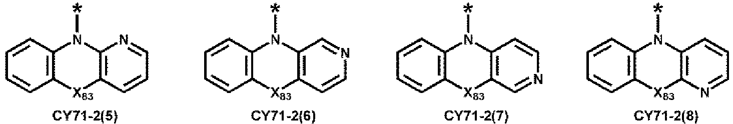 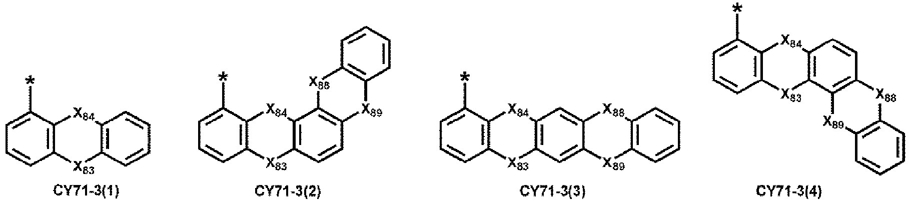 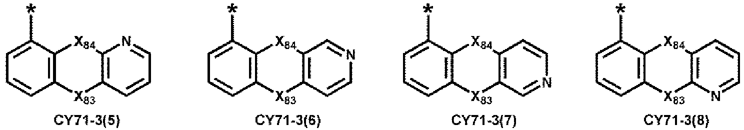 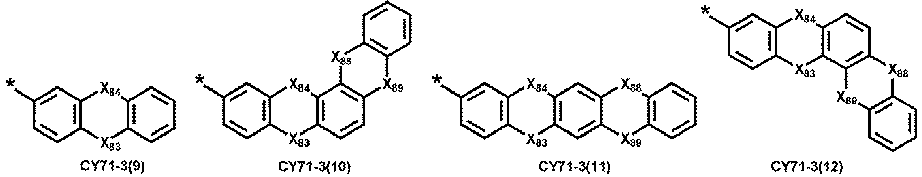 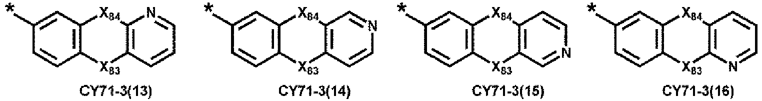 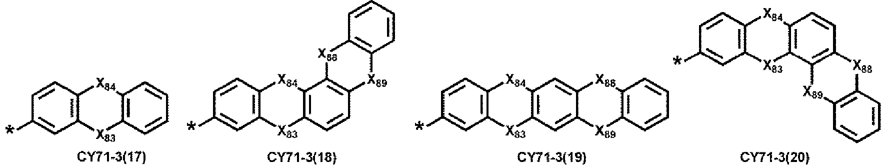 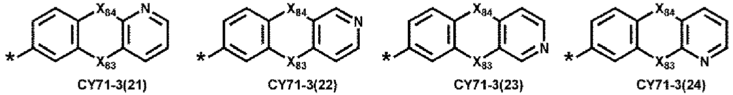 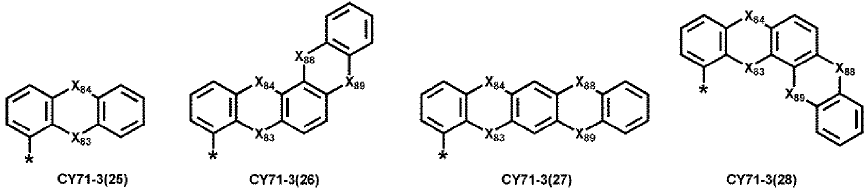 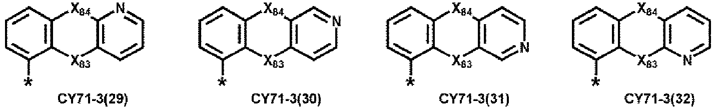 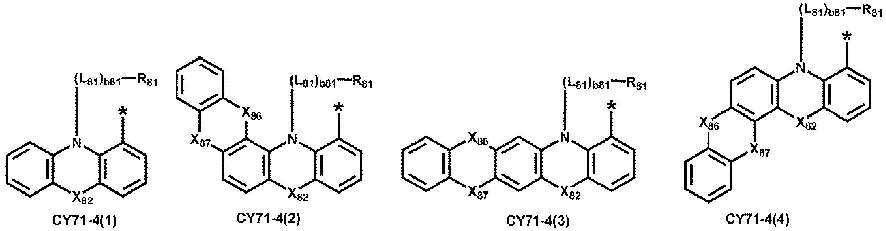 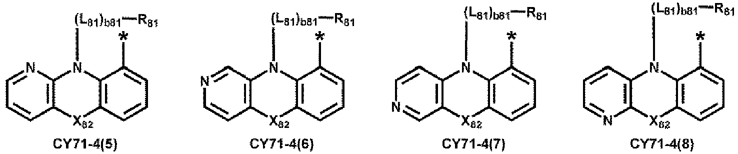 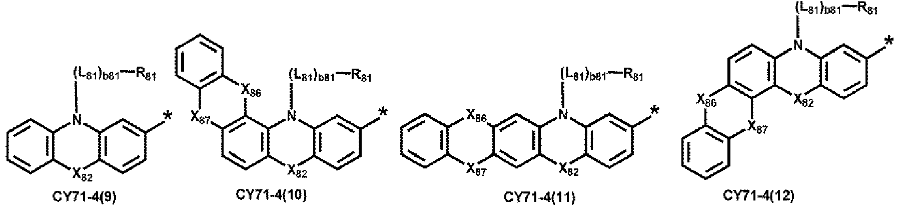 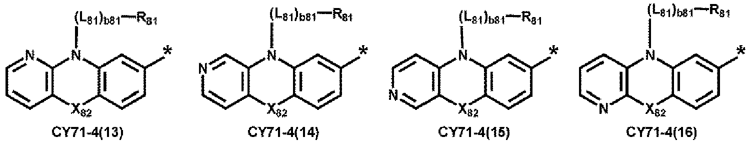 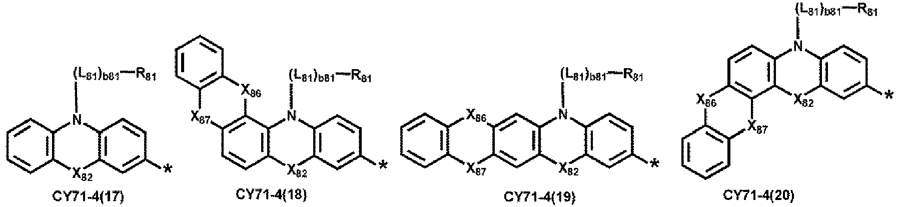 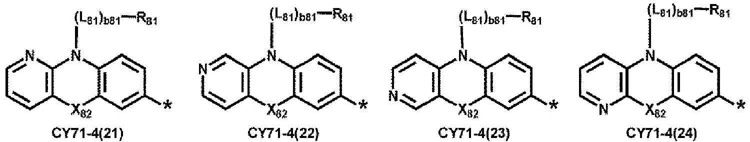 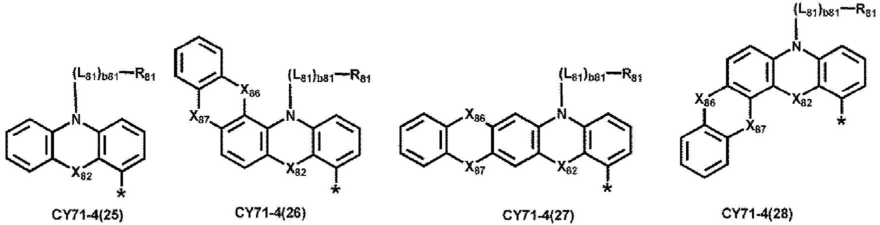 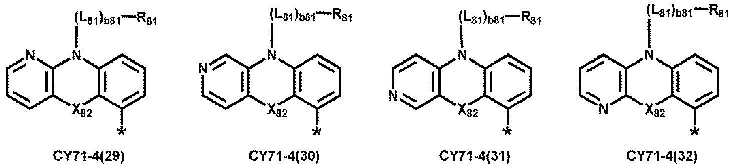 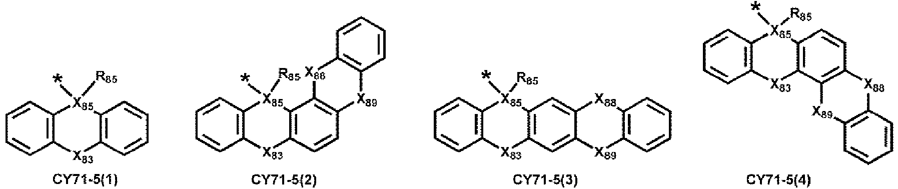 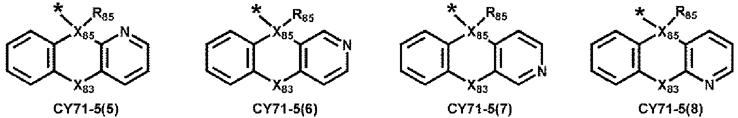
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ may respectively be understood by referring to the descriptions of X₈₁ to X₈₅, L₈₁, b81, R₈₁, and R₈₅ provided herein,
X₈₆ may be a single bond, O, S, N(R₈₆), B(R₈₆), C(R₈₆ₐ)(R_{86b}), or Si(R₈₆ₐ)(R_{86b}),
X₈₇ may be a single bond, O, S, N(R₈₇), B(R₈₇), C(R₈₇ₐ)(R_{87b}), or Si(R₈₇ₐ)(R_{87b}),
in Formulae CY71-1(1) to CY71-1(8) and CY71-4(1) to CY71-4(32), X₈₆ and X₈₇ may not be a single bond at the same time,
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R₈₉ₐ)(R_{89b}),
in Formulae CY71-2(1) to CY71-2(8), CY71-3(1) to CY71-3(32), and CY71-5(1) to CY71-5(8), X₈₈ and X₈₉ may not be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} may each be understood by referring to the description of R₈₁ provided herein.

### Compound Example

In an embodiment, the first emitter or the organometallic compound represented by Formula 1 may be one selected from Compounds PD01 to PD12:

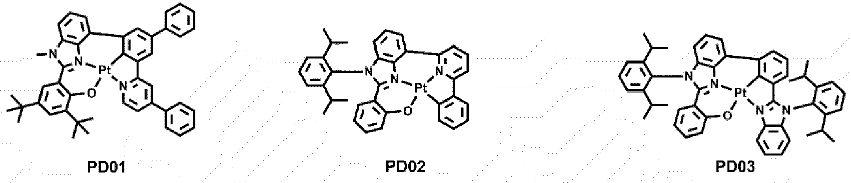

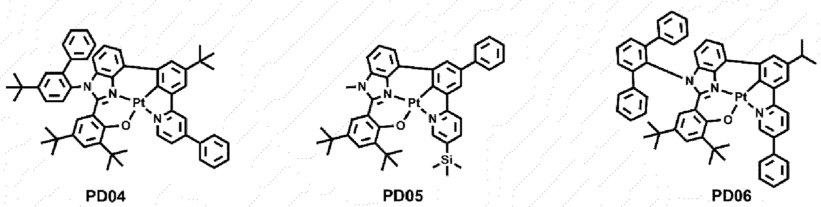

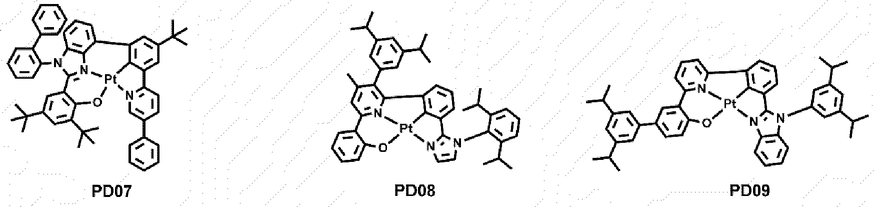

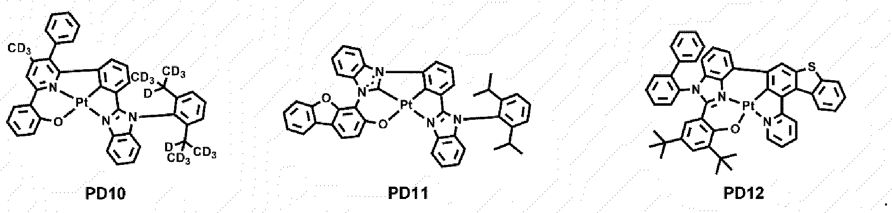

In an embodiment, the amine-containing compound may be one selected from Compounds CP01 to CP12:

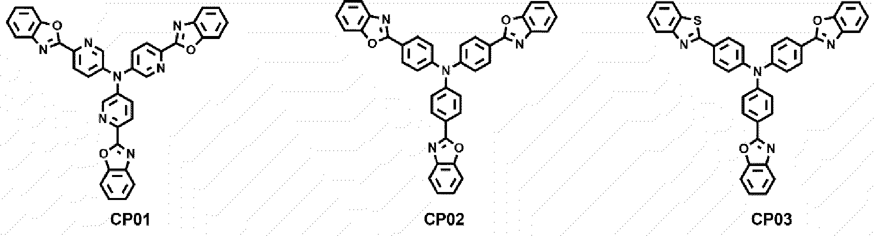

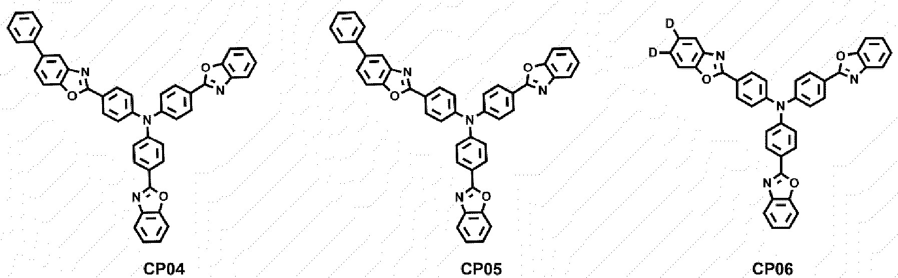

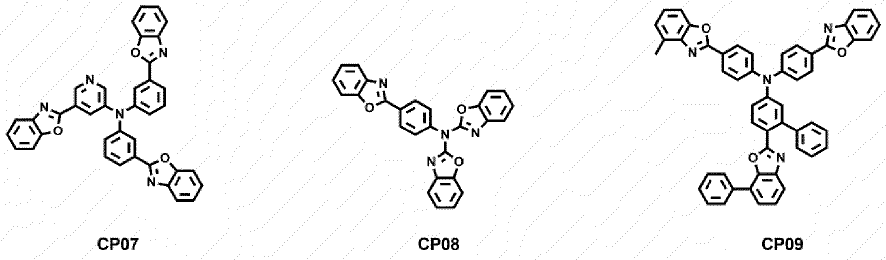

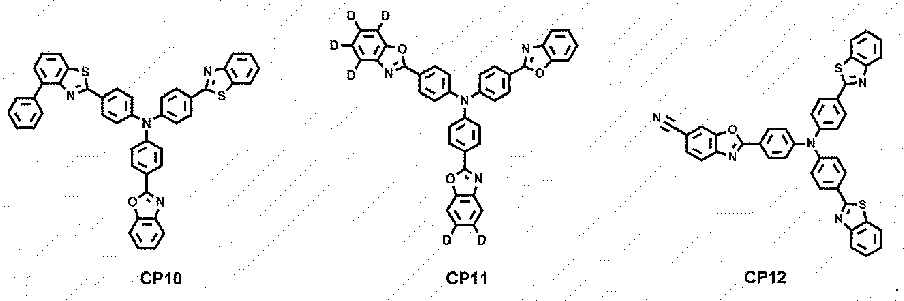

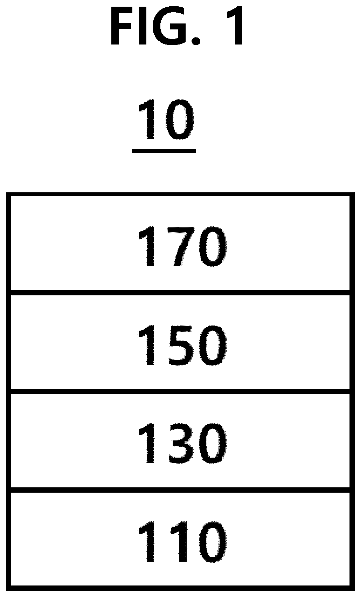

### Description of FIG. 1

FIG. 1 is a schematic cross-sectional view of a light-emitting device 10 according to an embodiment. The light-emitting device 10 includes a first electrode 110, an interlayer 130, a second electrode 150, and a second capping layer 170. The second capping layer 170 may also be called as the capping layer 170.

Hereinafter, the structure of the light-emitting device 10 according to an embodiment and a method of manufacturing the light-emitting device 10 will be described with reference to FIG. 1.

### First electrode 110

Referring to FIG. 1, a substrate may be additionally under the first electrode 110 and/or above the second capping layer 170. As the substrate, a glass substrate and/or a plastic substrate may be used. In one or more embodiments, the substrate may be a flexible substrate, and may include plastics having excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing and/or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layered structure consisting of a single layer or a multi-layered structure including a plurality of layers. For example, the first electrode 110 may have a three-layered structure of ITO/Ag/ITO.

### Interlayer 130

The interlayer 130 is on the first electrode 110. The interlayer 130 includes an emission layer.

The interlayer 130 may further include a hole transport region between the first electrode 110 and the emission layer, and an electron transport region between the emission layer and the second electrode 150.

The interlayer 130 may further include, in addition to various suitable organic materials, a metal-containing compound such as an organometallic compound, an inorganic material such as quantum dots, and/or the like.

In some embodiments, the interlayer 130 may include i) two or more emitting units sequentially stacked between the first electrode 110 and the second electrode 150 and ii) a charge generation layer between neighboring two emitting units. When the interlayer 130 includes emitting units and a charge generation layer as described above, the light-emitting device 10 may be a tandem light-emitting device.

### Hole transport region in interlayer 130

The hole transport region may have: i) a single-layered structure consisting of a single layer consisting of a single material, ii) a single-layered structure consisting of a single layer consisting of a plurality of different materials, or iii) a multi-layered structure including a plurality of layers including different materials.

The hole transport region may include a hole injection layer, a hole transport layer, an emission auxiliary layer, an electron-blocking layer, or any combination thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, the layers of each structure being stacked sequentially from the first electrode 110.

The hole transport region may include a compound represented by Formula 201, a compound represented by Formula 202, or any combination thereof: 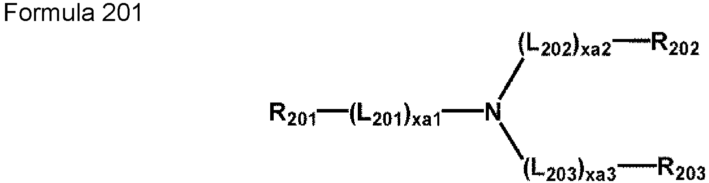 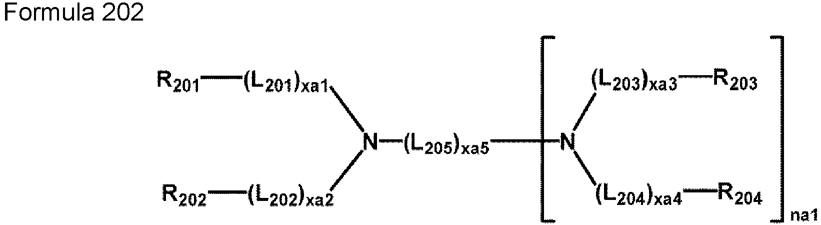 wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
R₂₀₁ and R₂₀₂ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group (for example, a carbazole group or the like) unsubstituted or substituted with at least one R₁₀ₐ (for example, see Compound HT16),
R₂₀₃ and R₂₀₄ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, each of Formulae 201 and 202 may include at least one selected from groups represented by Formulae CY201 to CY217.

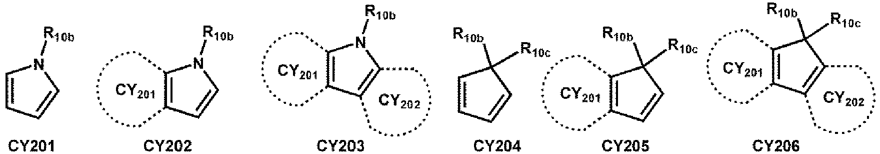

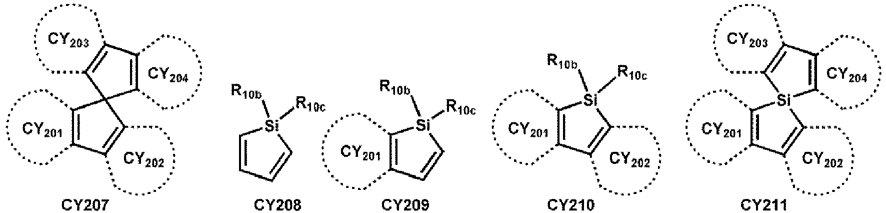

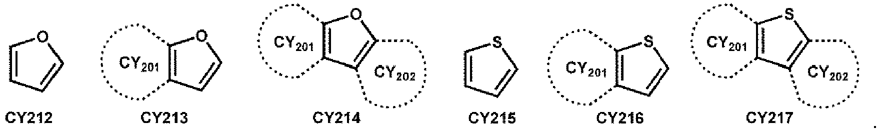

R_{10b} and R_{10c} in Formulae CY201 to CY217 are the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one selected from groups represented by Formulae CY201 to CY203.

In one or more embodiments, Formula 201 may include at least one selected from the groups represented by Formulae CY201 to CY203 and at least one selected from the groups represented by Formulae CY204 to CY217.

In one or more embodiments, in Formula 201, xa1 may be 1, R₂₀₁ may be a group represented by one selected from Formulae CY201 to CY203, xa2 may be 0, and R₂₀₂ may be a group represented by one selected from Formulae CY204 to CY207.

In one or more embodiments, each of Formulae 201 and 202 may not include a group represented by one selected from Formulae CY201 to CY203.

In one or more embodiments, each of Formulae 201 and 202 may not include a group represented by one selected from Formulae CY201 to CY203, and may include at least one selected from the groups represented by Formulae CY204 to CY217.

In one or more embodiments, each of Formulae 201 and 202 may not include a group represented by one selected from Formulae CY201 to CY217.

In an embodiment, the hole transport region may include one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

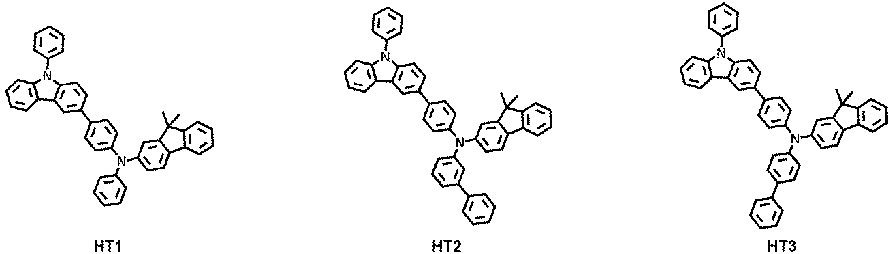

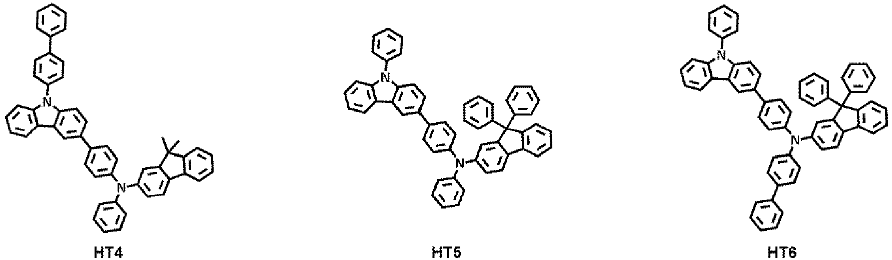

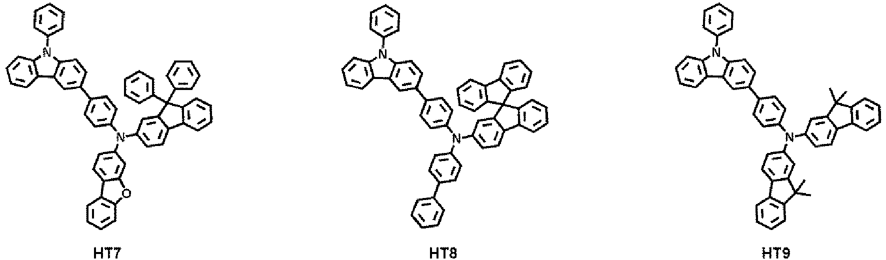

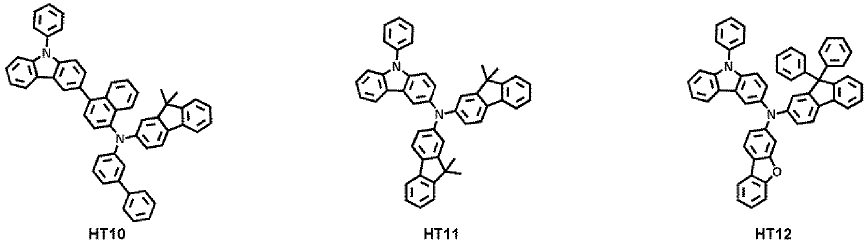

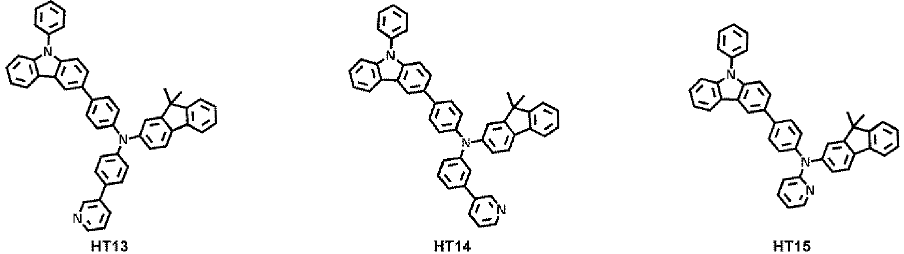

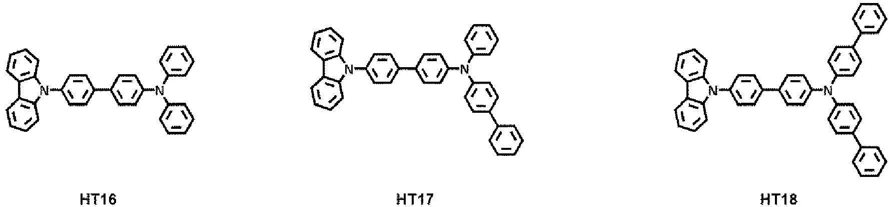

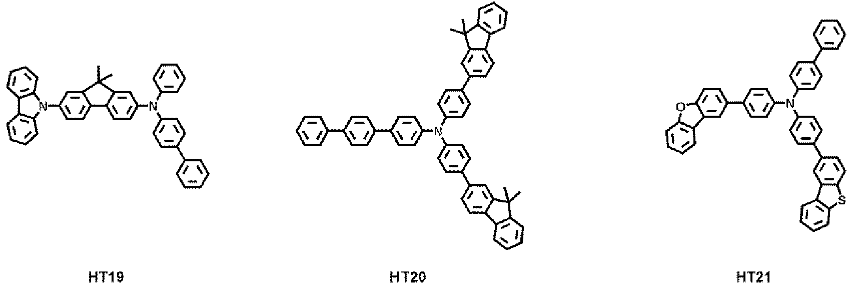

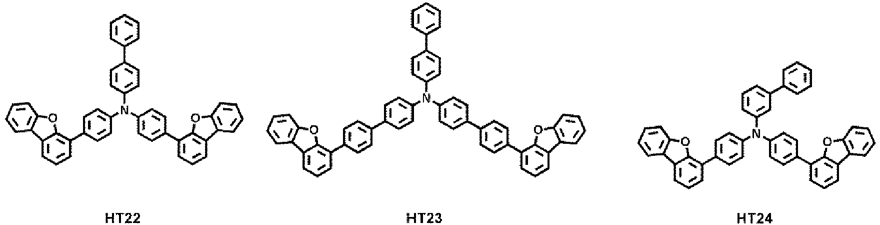

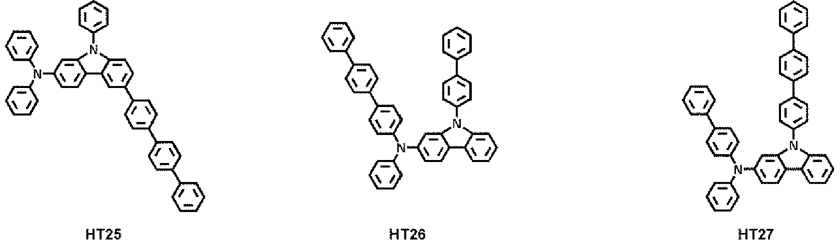

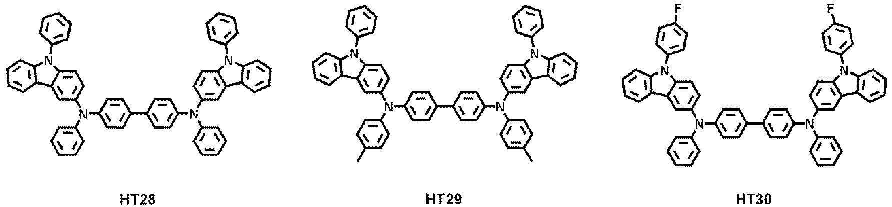

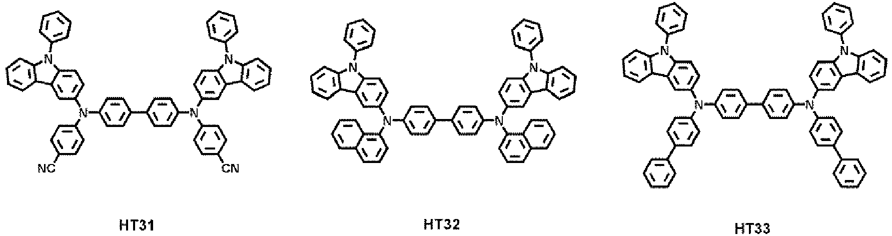

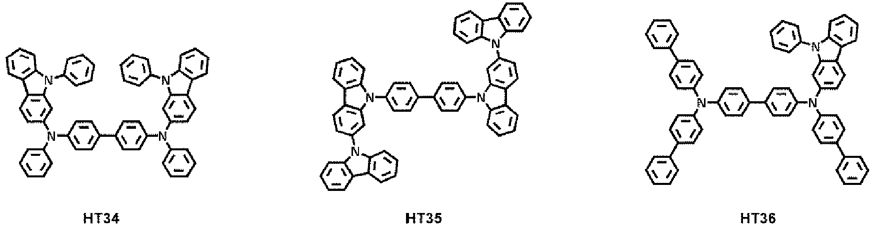

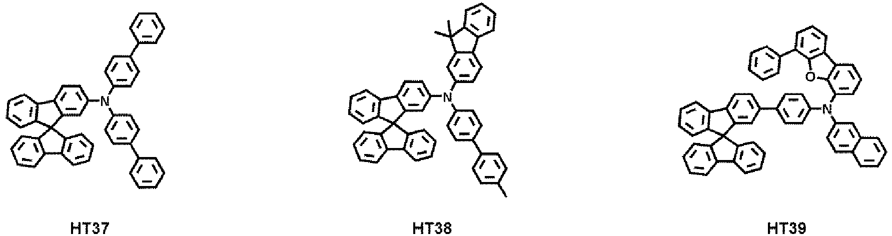

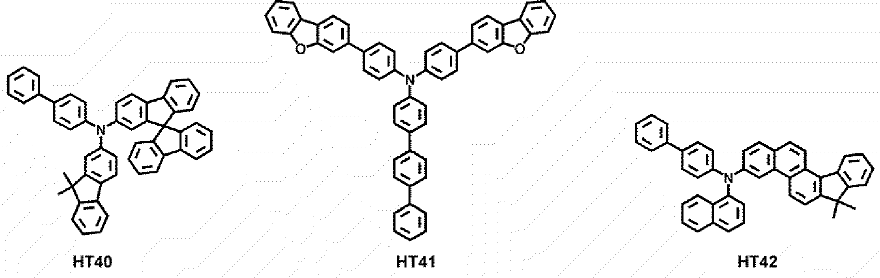

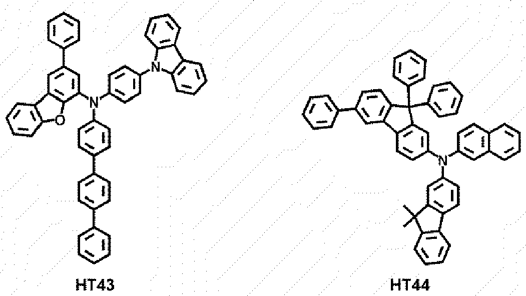

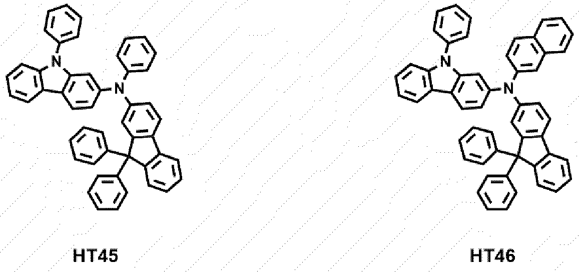

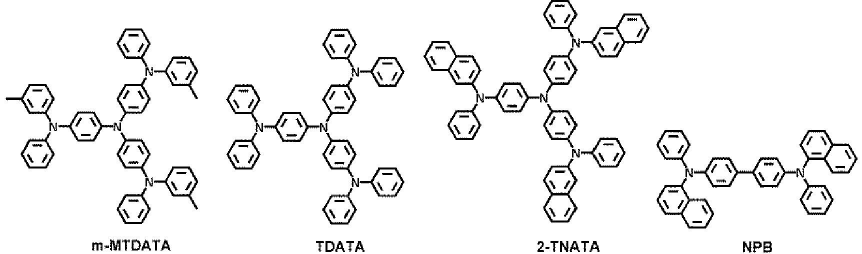

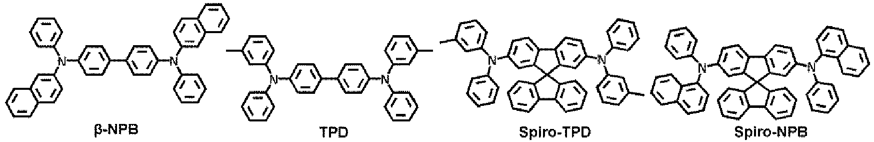

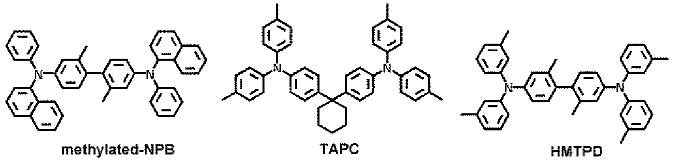

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, suitable or satisfactory hole transporting characteristics may be obtained without a substantial increase in driving voltage.

The emission auxiliary layer may increase luminescence efficiency by compensating for an optical resonance distance according to the wavelength of light emitted by an emission layer, and the electron-blocking layer may block or reduce the leakage of electrons from an emission layer to a hole transport region. Materials that may be included in the hole transport region may be included in the emission auxiliary layer and the electron-blocking layer.

### p-dopant

The hole transport region may further include, in addition to these materials, a charge-generation material for the improvement of conductive properties (e.g., electrically conductive properties). The charge-generation material may be uniformly or non-uniformly dispersed in the hole transport region (for example, in the form of a single layer consisting of a charge-generation material).

The charge-generation material may be, for example, a p-dopant.

For example, the lowest unoccupied molecular orbital (LUMO) energy level of the p-dopant may be -3.5 eV or less.

In one or more embodiments, the p-dopant may include a quinone derivative, a cyano group-containing compound, a compound including element EL1 and element EL2, or any combination thereof.

Examples of the quinone derivative include TCNQ, F4-TCNQ, etc.

Examples of the cyano group-containing compound include HAT-CN, and a compound represented by Formula 221 below.

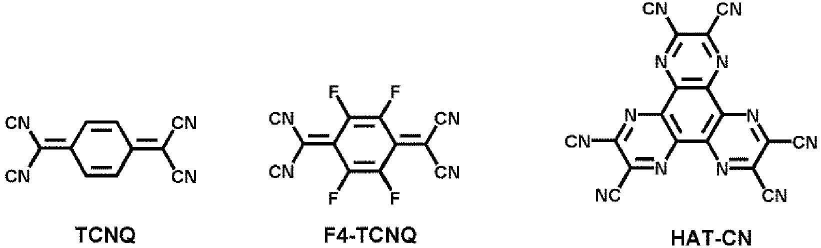

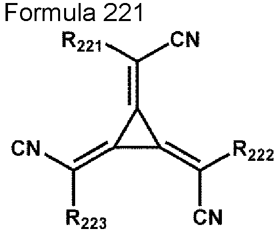

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one selected from R₂₂₁ to R₂₂₃ may each independently be a C₃-C₆₀ carbocyclic group or a C₁-C₆₀ heterocyclic group, each substituted with a cyano group; -F; -Cl; -Br; -I; a C₁-C₂₀ alkyl group substituted with a cyano group, -F, -Cl, -Br, -I, or any combination thereof; or any combination thereof.

In the compound including element EL1 and element EL2, element EL1 may be metal, metalloid, or any combination thereof, and element EL2 may be non-metal, metalloid, or any combination thereof.

Examples of the metal include an alkali metal (for example, lithium (Li), sodium (Na), potassium (K), rubidium (Rb), cesium (Cs), etc.); alkaline earth metal (for example, beryllium (Be), magnesium (Mg), calcium (Ca), strontium (Sr), barium (Ba), etc.); transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (for example, zinc (Zn), indium (In), tin (Sn), etc.); and lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid include silicon (Si), antimony (Sb), and tellurium (Te).

Examples of the non-metal include oxygen (O) and halogen (for example, F, Cl, Br, I, etc.).

Examples of the compound including element EL1 and element EL2 include metal oxide, metal halide (for example, metal fluoride, metal chloride, metal bromide, and/or metal iodide), metalloid halide (for example, metalloid fluoride, metalloid chloride, metalloid bromide, and/or metalloid iodide), metal telluride, or any combination thereof.

Examples of the metal oxide include tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoO₃, Mo₂O₅, etc.), and rhenium oxide (for example, ReO₃, etc.).

Examples of the metal halide include alkali metal halide, alkaline earth metal halide, transition metal halide, post-transition metal halide, and lanthanide metal halide.

Examples of the alkali metal halide include LiF, NaF, KF, RbF, CsF, LiCl, NaCl, KCI, RbCl, CsCl, LiBr, NaBr, KBr, RbBr, CsBr, Lil, Nal, KI, Rbl, and CsI.

Examples of the alkaline earth metal halide include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, Mgl₂, CaI₂, SrI₂, and BaI₂.

Examples of the transition metal halide include titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCI₃, VBr₃, VI₃, etc.), niobium halide (for example, NbF₃, NbCl₃, NbBr₃, NbI₃, etc.), tantalum halide (for example, TaF₃, TaCl₃, TaBr₃, TaI₃, etc.), chromium halide (for example, CrF₃, CrCl₃, CrBr₃, CrI₃, etc.), molybdenum halide (for example, MoF₃, MoCl₃, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCl, CuBr, Cul, etc.), silver halide (for example, AgF, AgCl, AgBr, AgI, etc.), and gold halide (for example, AuF, AuCl, AuBr, Aul, etc.).

Examples of the post-transition metal halide include zinc halide (for example, ZnF₂, ZnCl₂, ZnBr₂, ZnI₂, etc.), indium halide (for example, InI₃, etc.), and tin halide (for example, SnI₂, etc.).

Examples of the lanthanide metal halide include YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, SmI₃, and the like.

An example of the metalloid halide is antimony halide (for example, SbCl₅, etc.).

Examples of the metal telluride include alkali metal telluride (for example, Li₂Te, Na₂Te, K₂Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), and lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact (e.g., physically contact) each other or are separated from each other to emit white light. In one or more embodiments, the emission layer may include two or more materials of a red light-emitting material, a green light-emitting material, and a blue light-emitting material, in which the two or more materials are mixed together with each other in a single layer to emit white light.

In an embodiment, the emission layer may further include a host, an auxiliary dopant, a sensitizer, delayed fluorescence material, or any combination thereof, in addition to the first emitter as described in the present specification.

When the emission layer further includes a host in addition to the first emitter, the amount of the first emitter is about 0.01 to about 15 parts by weight based on 100 parts by weight of the host.

A thickness of the emission layer may be in a range of about 100 A to about 1,000 Å, for example, about 200 Å to about 600 Å. When the thickness of the emission layer is within these ranges, excellent light-emission characteristics may be obtained without a substantial increase in driving voltage.

### Host

The host in the emission layer may include an electron-transporting compound described herein (for example, refer to the compounds represented by Formula 2-1 and/or 2-2), a hole-transporting compound described herein (for example, refer to a compound represented by one selected from Formulae 3-1 to 3-5), or a combination thereof.

In one or more embodiments, the host may include an alkali earth metal complex, a post-transition metal complex, or any combination thereof. For example, the host may include a Be complex (for example, Compound H55), an Mg complex, a Zn complex, or any combination thereof.

In one or more embodiments, the host may include one of Compounds H1 to H130, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof:

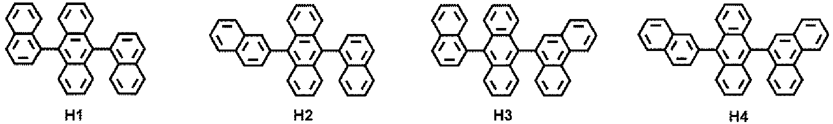

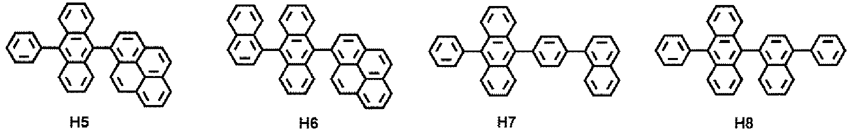

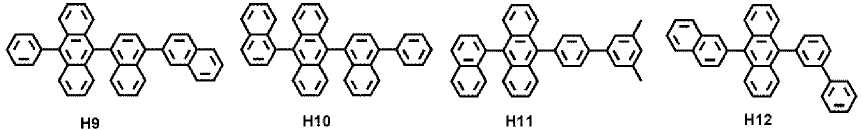

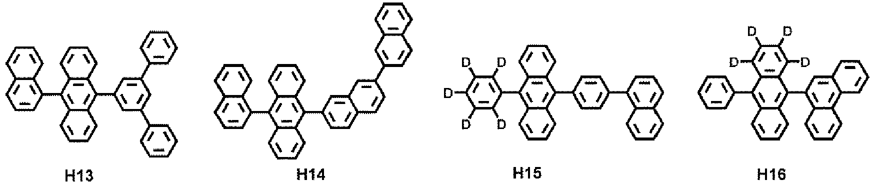

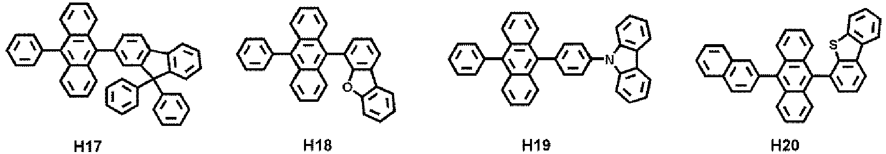

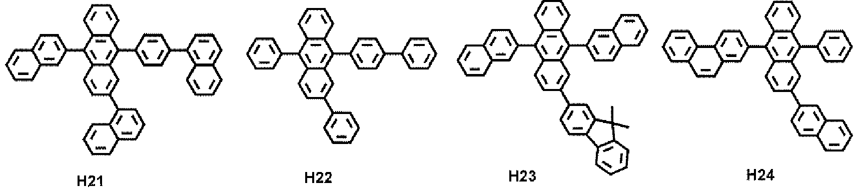

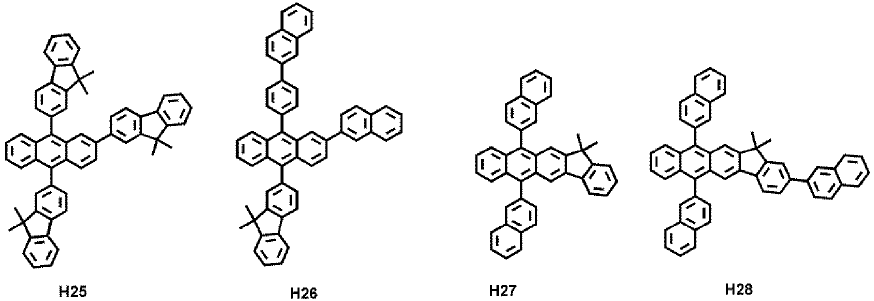

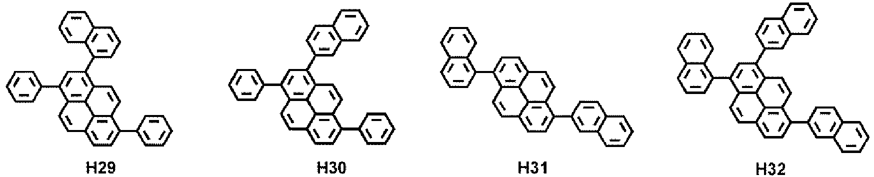

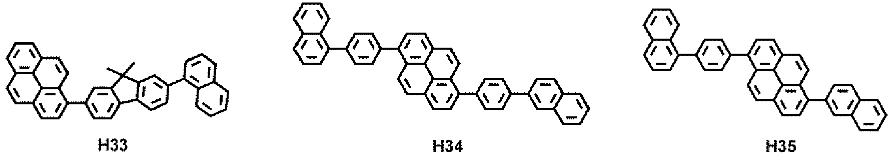

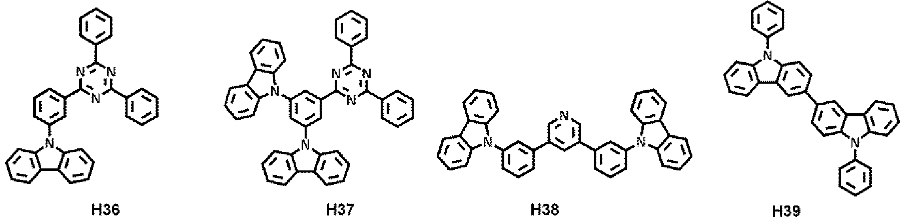

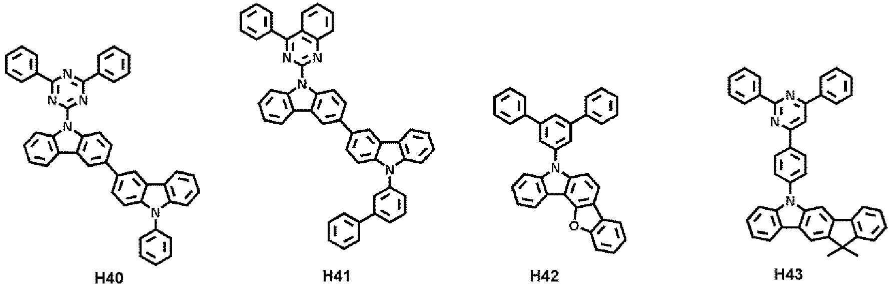

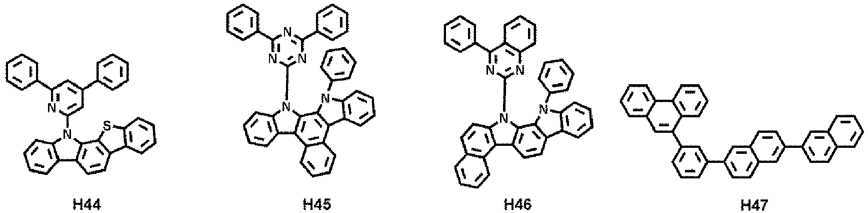

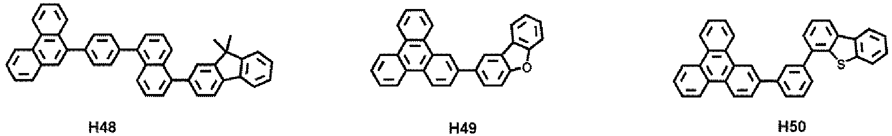

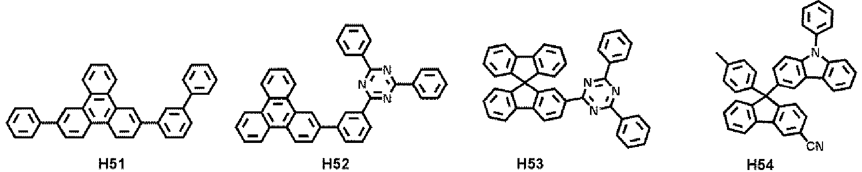

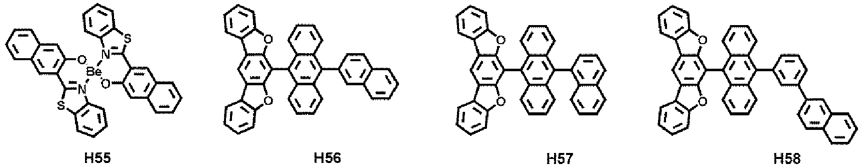

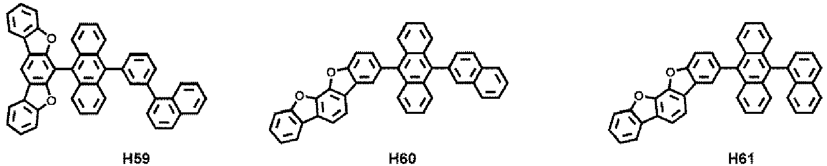

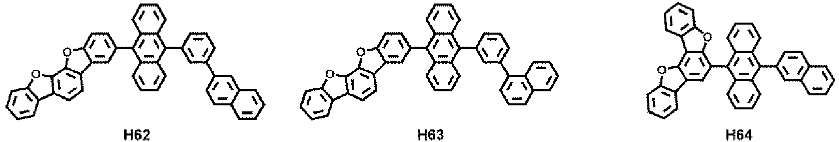

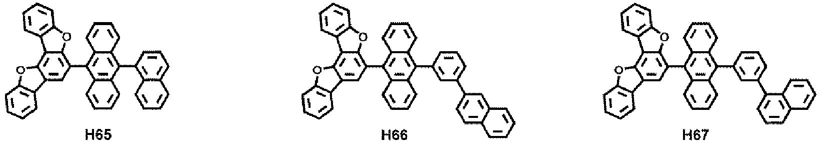

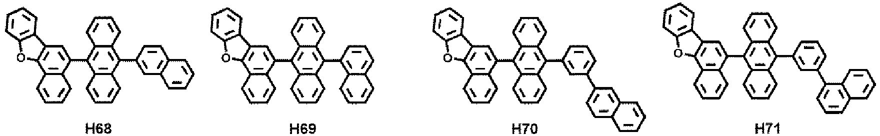

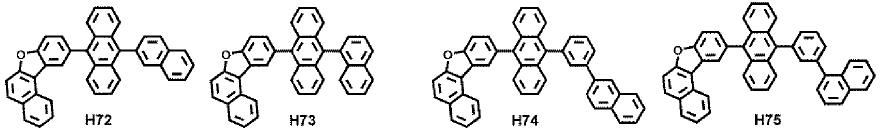

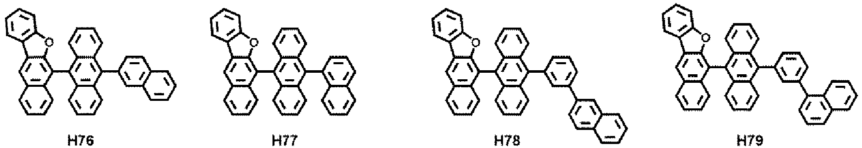

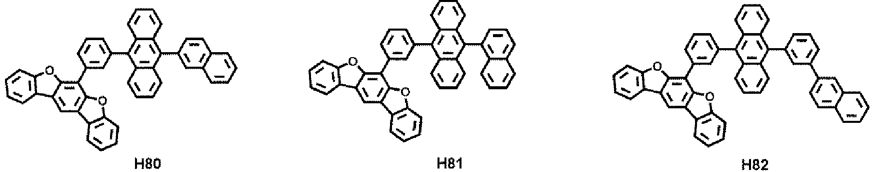

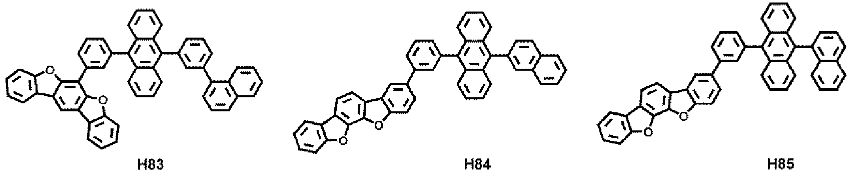

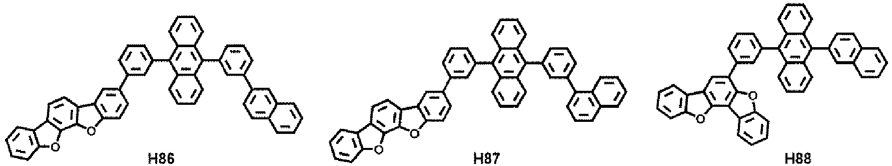

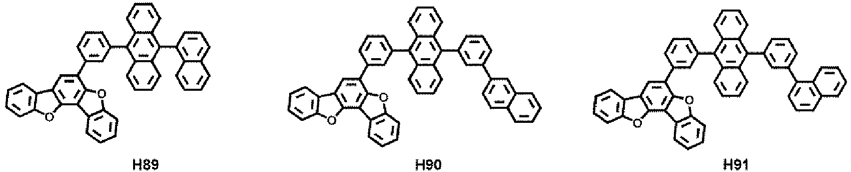

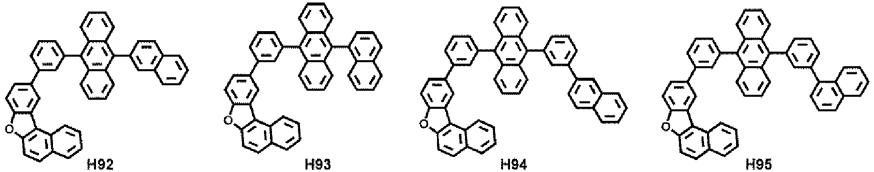

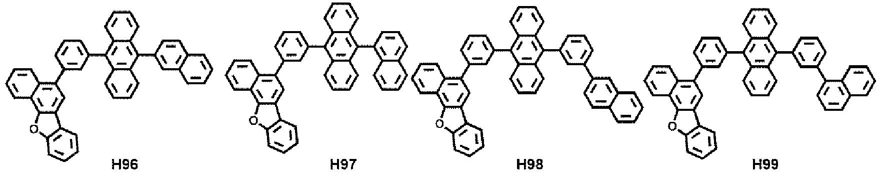

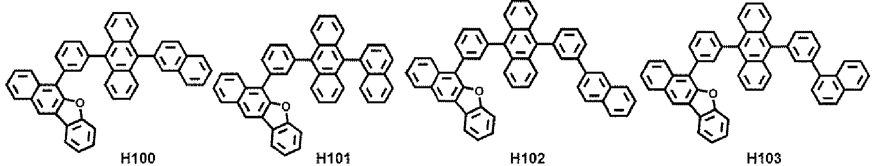

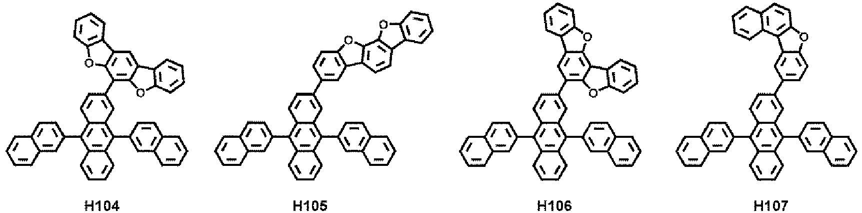

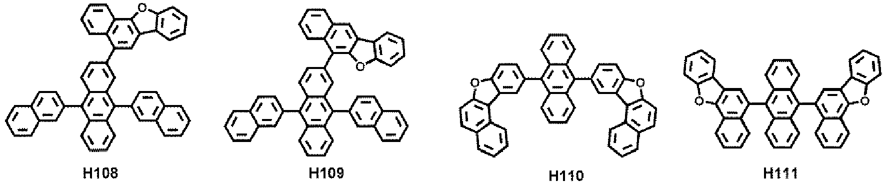

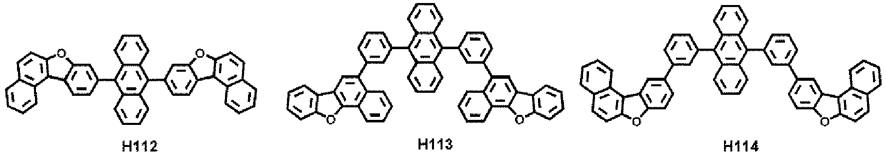

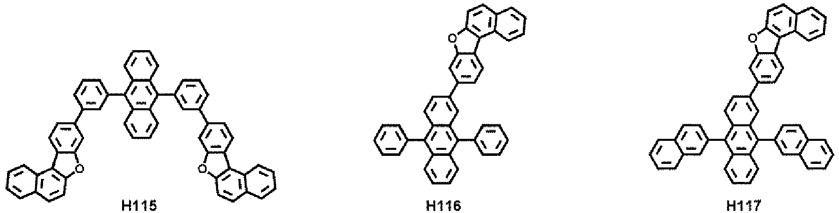

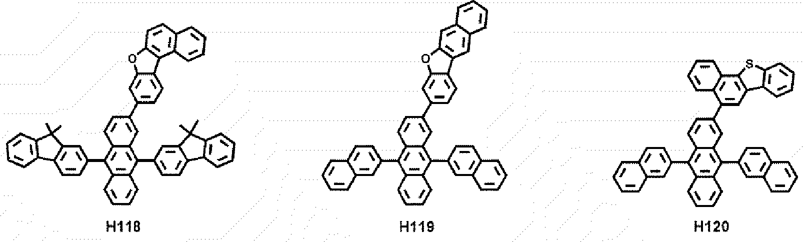

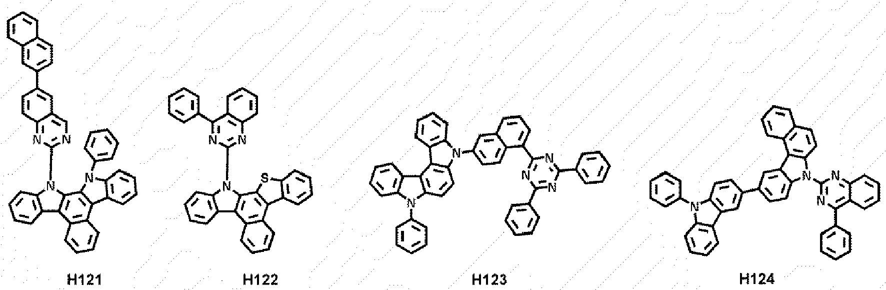

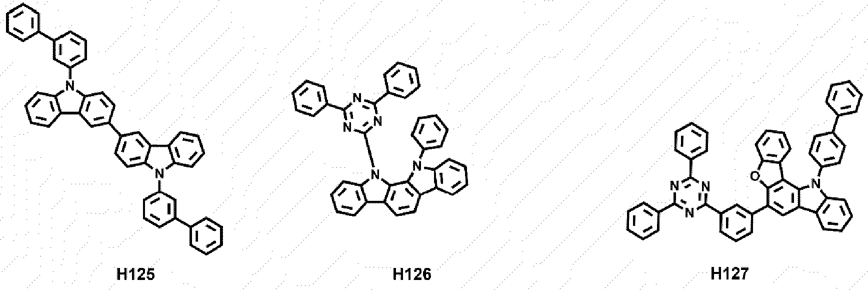

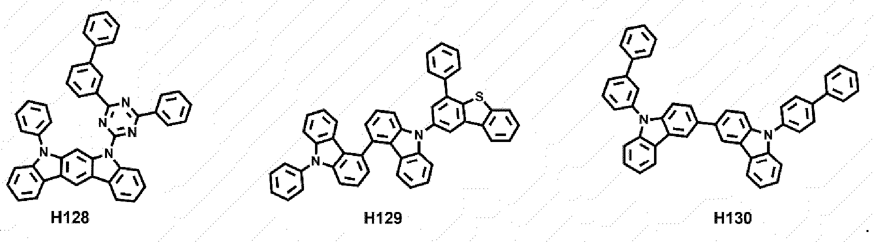

In an embodiment, the host may include a silicon-containing compound, a phosphine oxide-containing compound, or any combination thereof.

The host may have various suitable modifications. For example, the host may include only one kind of compound, or may include two or more kinds of different compounds.

### Phosphorescent dopant

The emission layer may include, as a phosphorescent dopant, the first emitter as described herein.

In an embodiment, the emission layer may further include, in addition to the first emitter as described in the present specification, an organometallic compound represented by Formula 401:

Formula 401 M(L₄₀₁)_{xc1}(L₄₀₂)_{xc2}

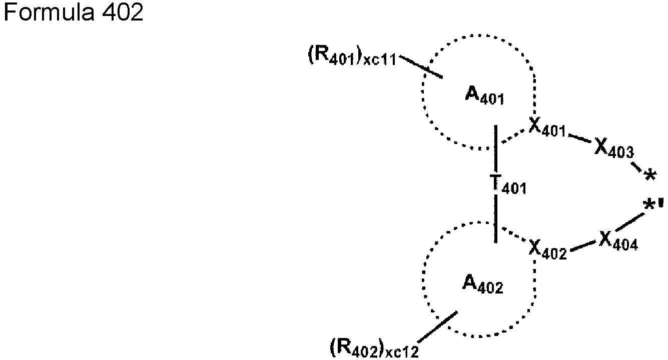

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein when xc1 is two or more, two or more of L₄₀₁(s) may be identical to or different from each other,
L₄₀₂ may be an organic ligand, and xc2 may be 0, 1, 2, 3, or 4, and when xc2 is 2 or more, two or more of L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)=*',
X₄₀₃ and X₄₀₄ may each independently be a chemical bond (for example, a covalent bond or a coordination bond (which may also be referred to as a coordinate covalent bond or dative bond)), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be the same as described herein with respect to Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), or -P(=O)(Q₄₀₁)(Q₄₀₂),
Q₄₀₁ to Q₄₀₃ may each be the same as described herein with respect to Q₁,
xc11 and xc12 may each independently be an integer from 0 to 10, and
* and *' in Formula 402 each indicate a binding site to M in Formula 401.

For example, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 402 is 2 or more, two ring A₄₀₁(s) in two or more of L₄₀₁(s) may be optionally linked to each other via T₄₀₂, which is a linking group, or two ring A₄₀₂(s) may be optionally linked to each other via T₄₀₃, which is a linking group (see Compounds PD1 to PD4 and PD7). T₄₀₂ and T₄₀₃ may each be the same as described herein with respect to T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O), an isonitrile group, -CN group, a phosphorus group (for example, a phosphine group, a phosphite group, etc.), or any combination thereof.

### Fluorescent dopant

The emission layer may further include a fluorescent dopant in addition to the first emitter as described in the present specification.

The fluorescent dopant may include an arylamine compound, a styrylamine compound, a boron-containing compound, or any combination thereof.

For example, the fluorescent dopant may include a compound represented by Formula 501: 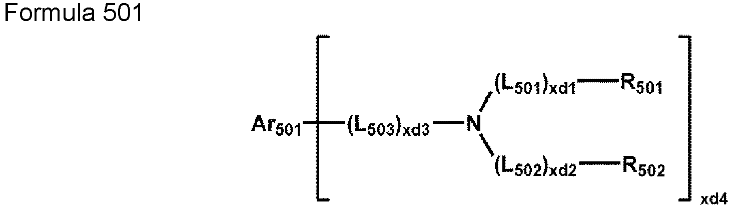 wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (for example, an anthracene group, a chrysene group, or a pyrene group) in which three or more monocyclic groups are condensed together.

In one or more embodiments, xd4 in Formula 501 may be 2.

For example, the fluorescent dopant may include: one of Compounds FD1 to FD36; DPVBi; DPAVBi; or any combination thereof:

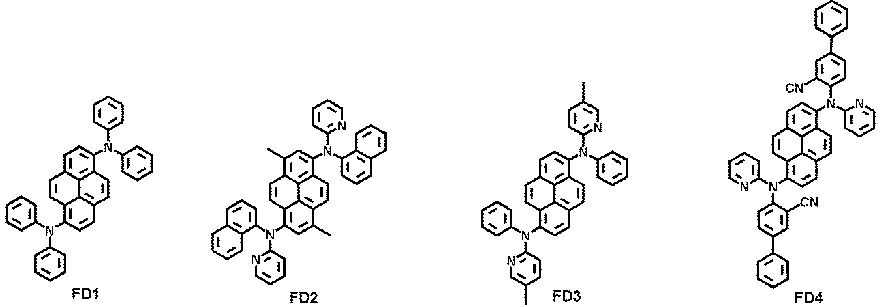

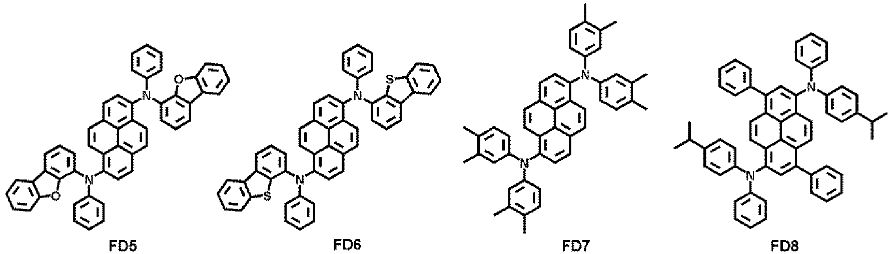

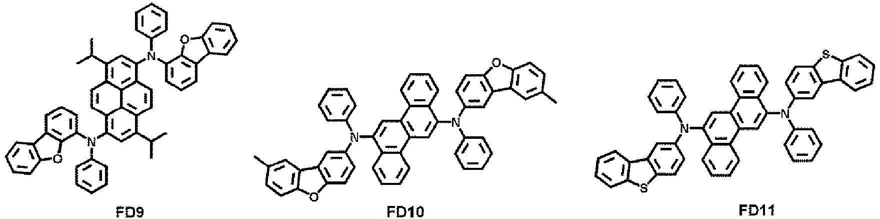

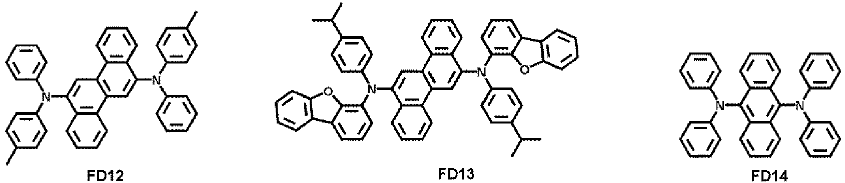

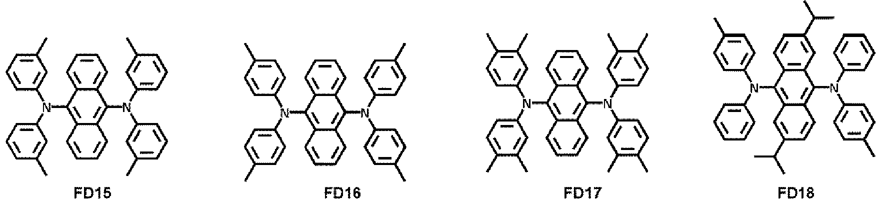

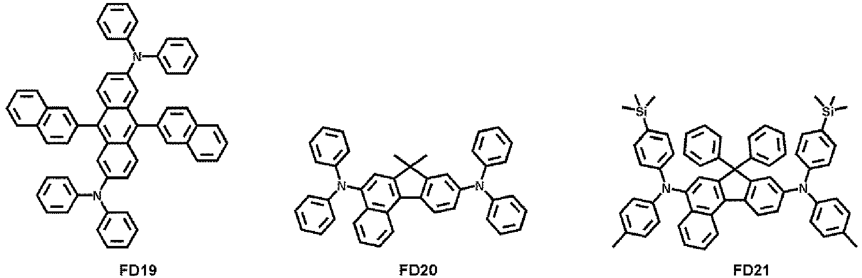

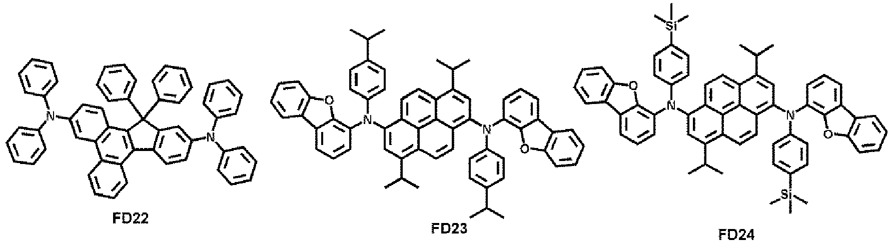

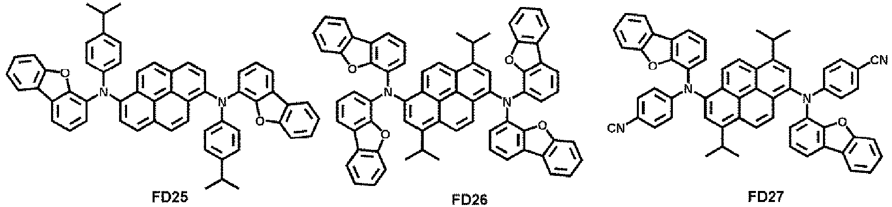

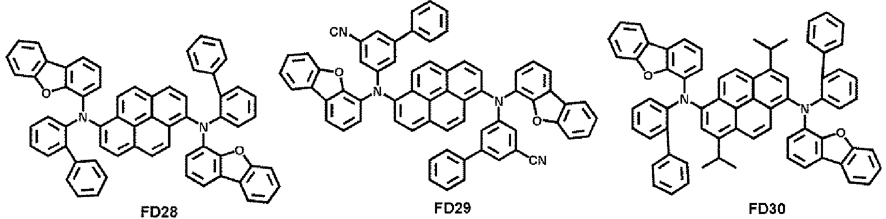

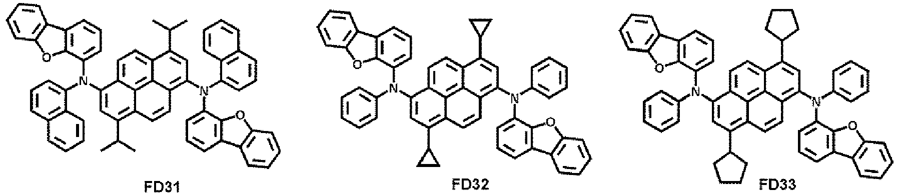

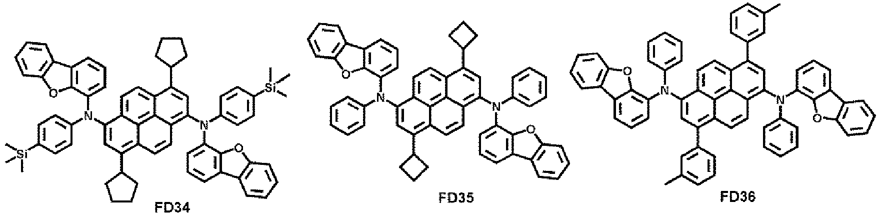

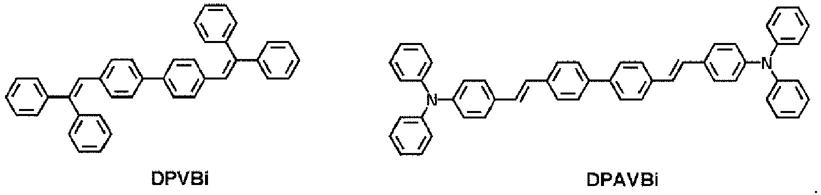

### Delayed fluorescence material

The emission layer may further include a delayed fluorescence material.

In the present specification, the delayed fluorescence material may be selected from compounds capable of emitting delayed fluorescent light based on a delayed fluorescence emission mechanism.

The delayed fluorescence material included in the emission layer may act as a host or a dopant depending on the type (or kind) of other materials included in the emission layer.

In one or more embodiments, the difference between the triplet energy level (eV) of the delayed fluorescence material and the singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material satisfies the above-described range, up-conversion from the triplet state to the singlet state of the delayed fluorescence materials may effectively occur, and thus, the luminescence efficiency of the light-emitting device 10 may be improved.

For example, the delayed fluorescence material may include i) a material including at least one electron donor (for example, a π electron-rich C₃-C₆₀ cyclic group, such as a carbazole group) and at least one electron acceptor (for example, a sulfoxide group, a cyano group, or a π electron-deficient nitrogen-containing C₁-C₆₀ cyclic group), and ii) a material including a C₈-C₆₀ polycyclic group in which two or more cyclic groups are condensed together while sharing boron (B).

Examples of the delayed fluorescence material may include at least one selected from the following compounds DF1 to DF9:

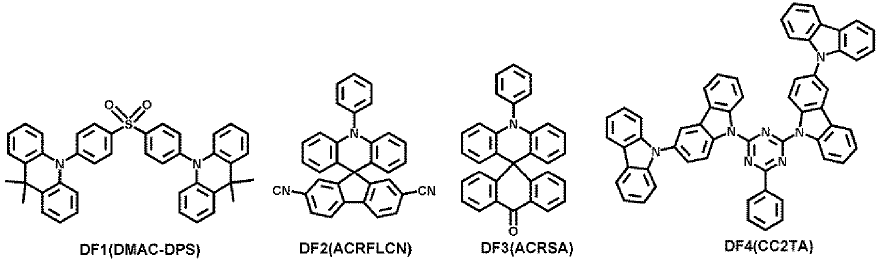

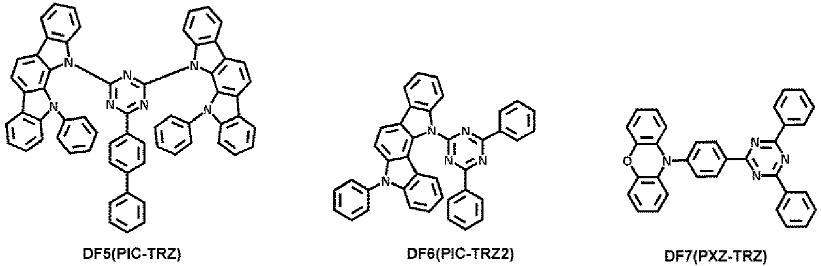

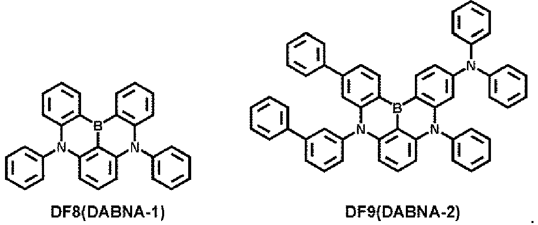

### Electron transport region in interlayer 130

The electron transport region may have: i) a single-layered structure consisting of a single layer consisting of a single material, ii) a single-layered structure consisting of a single layer consisting of a plurality of different materials, or iii) a multi-layered structure including a plurality of layers including different materials.

The electron transport region may include a buffer layer, a hole-blocking layer, an electron control layer, an electron transport layer, an electron injection layer, or any combination thereof.

For example, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer.

In an embodiment, the electron transport region (for example, the buffer layer, the hole-blocking layer, the electron control layer, or the electron transport layer in the electron transport region) may include a metal-free compound including at least one π electron-deficient nitrogen-containing C₁-C₆₀ cyclic group.

For example, the electron transport region may include a compound represented by Formula 601 below:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described herein with respect to Q₁,
xe21 may be 1, 2, 3, 4, or 5,
at least one selected from Ar₆₀₁, L₆₀₁, and R₆₀₁ may each independently be a π electron-deficient nitrogen-containing C₁-C₆₀ cyclic group unsubstituted or substituted with at least one R₁₀ₐ.

For example, when xe11 in Formula 601 is 2 or more, two or more of Ar₆₀₁(s) may be linked to each other via a single bond.

In other embodiments, Ar₆₀₁ in Formula 601 may be a substituted or unsubstituted anthracene group.

In other embodiments, the electron transport region may include a compound represented by Formula 601-1: 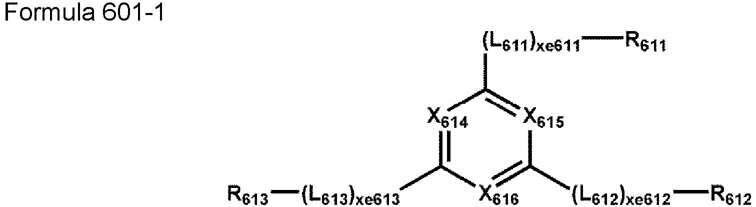 wherein, in Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ may each be the same as described herein with respect to L₆₀₁,
xe611 to xe613 may each be the same as described herein with respect to xe1,
R₆₁₁ to R₆₁₃ may each be the same as described herein with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

The electron transport region may include one of Compounds ET1 to ET46, 2,9-dimethyl-4,7-diphenyl-1,10-phenanthroline (BCP), 4,7-diphenyl-1,10-phenanthroline (Bphen), Alq3, BAlq, TAZ, NTAZ, or any combination thereof:

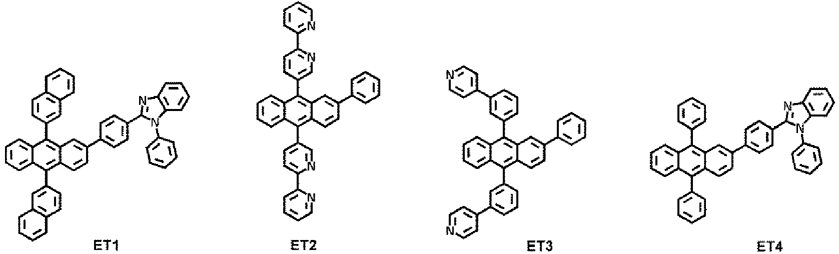

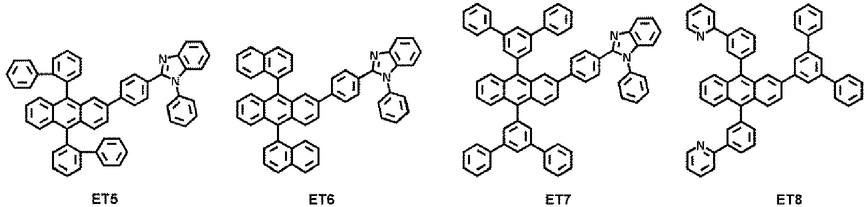

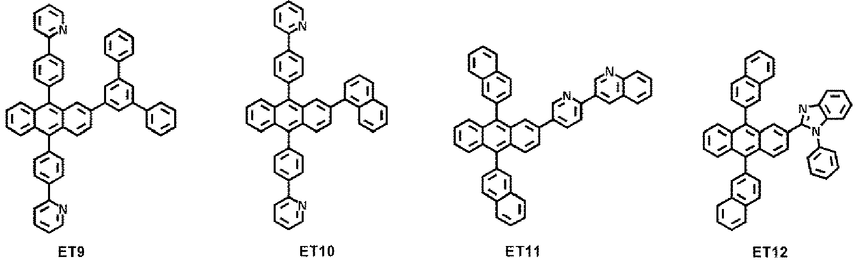

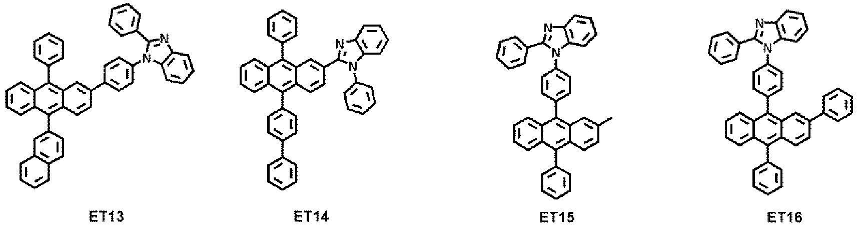

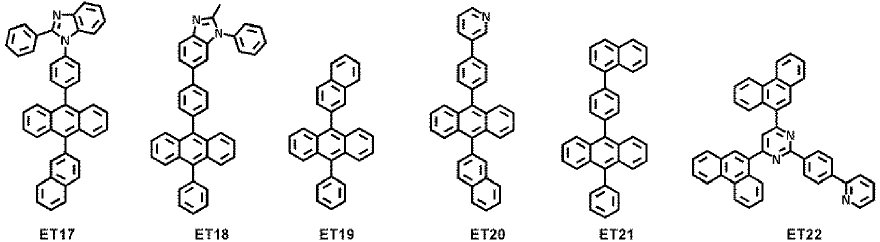

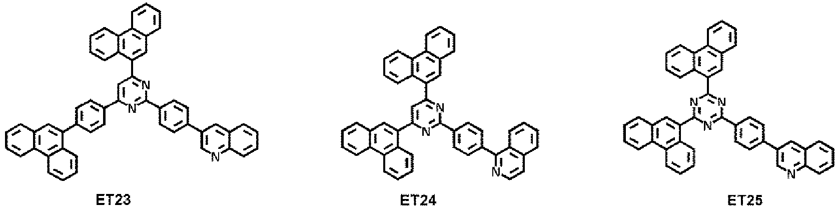

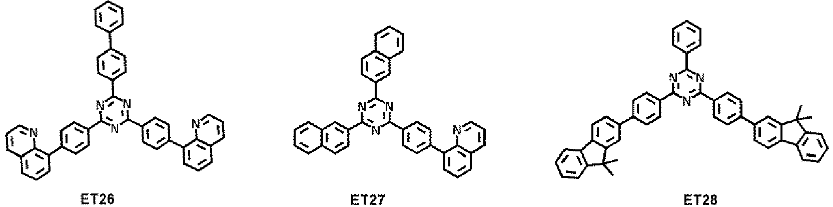

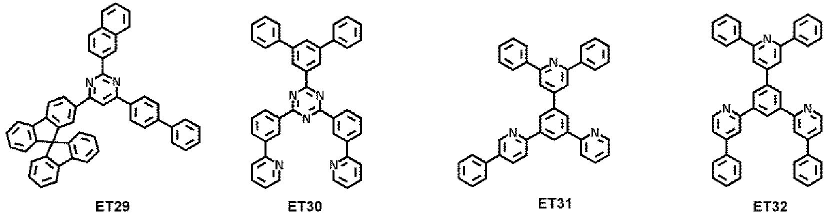

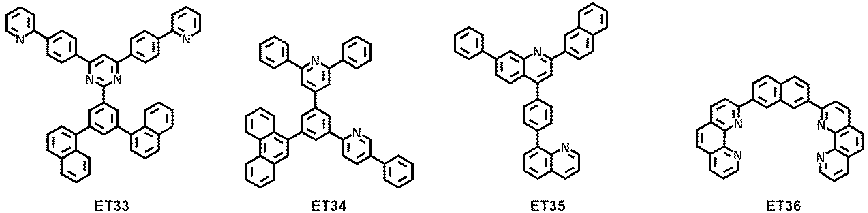

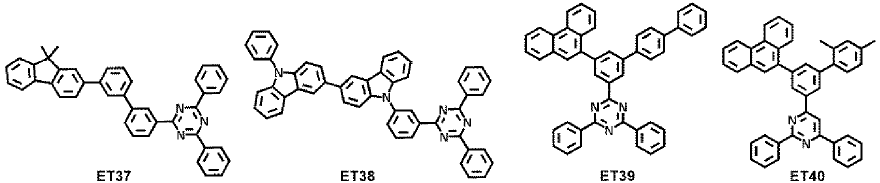

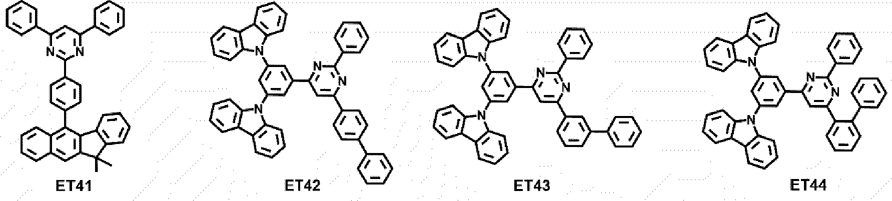

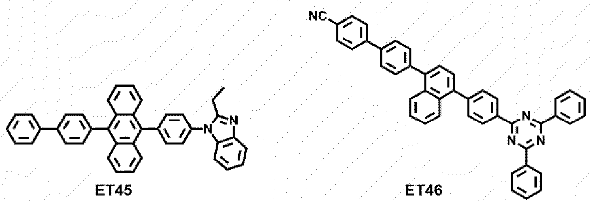

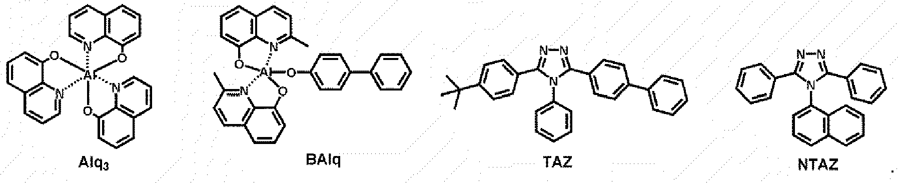

A thickness of the electron transport region may be from about 100 Å to about 5,000 Å, for example, about 160 Å to about 4,000 Å. When the electron transport region includes a buffer layer, a hole-blocking layer, an electron control layer, an electron transport layer, or any combination thereof, the thickness of the buffer layer, the hole-blocking layer, or the electron control layer may each independently be from about 20 Å to about 1000 Å, for example, about 30 Å to about 300 Å, and the thickness of the electron transport layer may be from about 100 Å to about 1000 Å, for example, about 150 Å to about 500 Å. When the thickness of the buffer layer, the hole-blocking layer, the electron control layer, the electron transport layer, and/or the electron transport layer are within these ranges, suitable or satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, the metal-containing material may include a Li complex. The Li complex may include, for example, Compound ET-D1 (LiQ) and/or ET-D2:

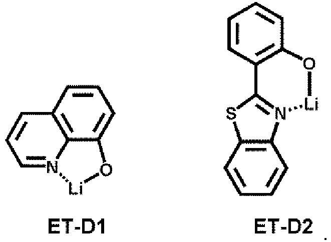

The electron transport region may include an electron injection layer that facilitates the injection of electrons from the second electrode 150. The electron injection layer may be in direct contact (e.g., physical contact) with the second electrode 150.

The electron injection layer may have: i) a single-layered structure consisting of a single layer consisting of a single material, ii) a single-layered structure consisting of a single layer consisting of a plurality of different materials, or iii) a multi-layered structure including a plurality of layers including different materials.

The electron injection layer may include an alkali metal, alkaline earth metal, a rare earth metal, an alkali metal-containing compound, alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (for example, fluorides, chlorides, bromides, and/or iodides), and/or tellurides of the alkali metal, the alkaline earth metal, and the rare earth metal, or any combination thereof.

The alkali metal-containing compound may include: alkali metal oxides, such as Li₂O, Cs₂O, and/or K₂O; alkali metal halides, such as LiF, NaF, CsF, KF, Lil, Nal, CsI, KI, Rbl; or any combination thereof. The alkaline earth metal-containing compound may include an alkaline earth metal compound, such as BaO, SrO, CaO, BaₓSr₁₋ₓO (wherein x is a real number satisfying the condition of 0<x<1), BaₓCa₁₋ₓO (wherein x is a real number satisfying the condition of 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include lanthanide metal telluride. Examples of the lanthanide metal telluride include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include i) one selected from metal ions of the alkali metal, the alkaline earth metal, and the rare earth metal and ii) as a ligand linked to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material (for example, a compound represented by Formula 601).

In one or more embodiments, the electron injection layer may include (e.g., consist of): i) an alkali metal-containing compound (for example, an alkali metal halide); or ii) a) an alkali metal-containing compound (for example, an alkali metal halide), and b) an alkali metal, an alkaline earth metal, a rare earth metal, or any combination thereof. For example, the electron injection layer may be a KI:Yb co-deposited layer, an RbI:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be uniformly or non-uniformly dispersed in a matrix including the organic material.

A thickness of the electron injection layer may be in a range of about 1 Å to about 100 Å, and, for example, about 3 Å to about 90 Å. When the thickness of the electron injection layer is within the ranges described above, suitable or satisfactory electron injection characteristics may be obtained without a substantial increase in driving voltage.

### Second electrode 150

The second electrode 150 may be on the interlayer 130 having a structure as described above. The second electrode 150 may be a cathode, which is an electron injection electrode, and as the material for the second electrode 150, a metal, an alloy, an electrically conductive compound, or any combination thereof, each having a low-work function, may be used.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure consisting of a single layer, or a multi-layered structure including a plurality of layers.

### Second capping layer 170

The second capping layer 170 contains an amine-containing compound as described in the present specification. The amine-containing compound is the same as described in the present specification.

### Electronic apparatus

The light-emitting device may be included in various suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be in at least one direction in which light emitted from the light-emitting device travels. For example, the light emitted from the light-emitting device may be blue light, green light, or white light. For more details on the light-emitting device, related description provided above may be referred to. In one or more embodiments, the color conversion layer may include a quantum dot.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be located among the subpixel areas to define each of the subpixel areas.

The color filter may further include a plurality of color filter areas and light-shielding patterns located among the color filter areas, and the color conversion layer may further include a plurality of color conversion areas and light-shielding patterns located among the color conversion areas.

The plurality of color filter areas (or the plurality of color conversion areas) may include a first area that may emit a first color light, a second area that may emit a second color light, and/or a third area that may emit a third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In some embodiments, the first area may include a red quantum dot, the second area may include a green quantum dot, and the third area may not include a quantum dot. For more details on the quantum dot, related descriptions provided herein may be referred to. The first area, the second area, and/or the third area may each further include a scatterer (e.g., a light scatterer).

For example, the light-emitting device may emit a first light, the first area may absorb the first light to emit a first-first color light, the second area may absorb the first light to emit a second-first color light, and the third area may absorb the first light to emit a third-first color light. In some embodiments, the first-first color light, the second-first color light, and the third-first color light may have different maximum emission wavelengths. For example, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer, wherein any one selected from the source electrode and the drain electrode may be electrically connected to any one selected from the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, that may emit a or the like.

The electronic apparatus may further include a sealing portion for sealing the light-emitting device. The sealing portion may be between the color filter and/or the color conversion layer and the light-emitting device. The sealing portion allows light from the light-emitting device to be extracted to the outside, and concurrently (e.g., simultaneously) prevents or reduces penetration of ambient air and/or moisture into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

Various suitable functional layers may be additionally on the sealing portion, in addition to the color filter and/or the color conversion layer, according to the use of the electronic apparatus. Examples of the functional layers may include a touch screen layer, a polarizing layer, and the like. The touch screen layer may be a pressure-sensitive touch screen layer, a capacitive touch screen layer, and/or an infrared touch screen layer. The authentication apparatus may be, for example, a biometric authentication apparatus that authenticates an individual by using biometric information of a living body (for example, fingertips, pupils, etc.).

The authentication apparatus may further include, in addition to the light-emitting device as described above, a biometric information collector.

The electronic apparatus may be applied to various suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, various suitable measuring instruments, meters (for example, meters for a vehicle, an aircraft, and/or a vessel), projectors, and/or the like.

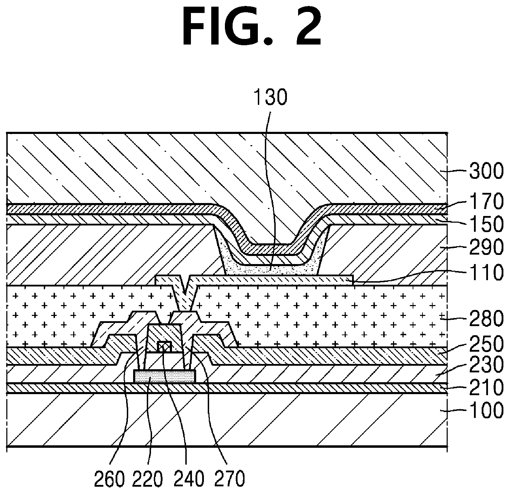

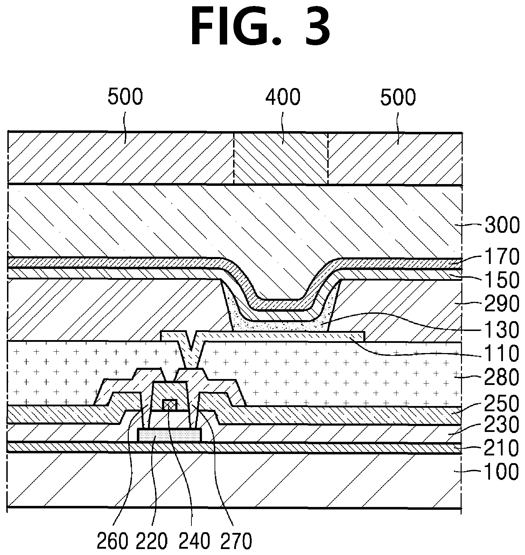

### Description of FIGS. 2 and 3

FIG. 2 is a cross-sectional view showing a light-emitting apparatus according to an embodiment of the present disclosure.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, and/or a metal substrate. A buffer layer 210 may be on the substrate 100. The buffer layer 210 may prevent or reduce penetration of impurities through the substrate 100 and may provide a flat surface on the substrate 100.

A TFT may be on the buffer layer 210. The TFT may include an activation layer 220, a gate electrode 240, a source electrode 260, and a drain electrode 270.

The activation layer 220 may include an inorganic semiconductor such as silicon and/or polysilicon, an organic semiconductor, and/or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270, to insulate from one another.

The source electrode 260 and the drain electrode 270 may be on the interlayer insulating film 250. The interlayer insulating film 250 and the gate insulating film 230 may expose the source region and the drain region of the activation layer 220, and the source electrode 260 and the drain electrode 270 may be in contact (e.g., physical contact) with the exposed portions of the source region and the drain region of the activation layer 220.

The TFT is electrically connected to a light-emitting device to drive the light-emitting device, and is covered and protected by a passivation layer 280. The passivation layer 280 may include an inorganic insulating film, an organic insulating film, or any combination thereof. A light-emitting device is provided on the passivation layer 280. The light-emitting device may include a first electrode 110, an interlayer 130, and a second electrode 150.

The first electrode 110 may be on the passivation layer 280. The passivation layer 280 may expose a portion of the drain electrode 270, not fully covering the drain electrode 270, and the first electrode 110 may be connected to the exposed portion of the drain electrode 270.

A pixel defining layer 290 including an insulating material may be on the first electrode 110. The pixel defining layer 290 may expose a certain region of the first electrode 110, and an interlayer 130 may be formed in the exposed region of the first electrode 110. The pixel defining layer 290 may be a polyimide and/or polyacrylic organic film. In some embodiments, at least some layers of the interlayer 130 may extend beyond the upper portion of the pixel defining layer 290 in the form of a common layer.

A second electrode 150 may be on the interlayer 130, and a second capping layer 170 may be additionally on the second electrode 150. The second capping layer 170 may cover the second electrode 150.

The encapsulation portion 300 may be on the second capping layer 170. The encapsulation portion 300 may be on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or any combination thereof; or any combination of the inorganic films and the organic films.

FIG. 3 shows a cross-sectional view showing a light-emitting apparatus according to an embodiment of the present disclosure.

The light-emitting apparatus of FIG. 3 is substantially the same as the light-emitting apparatus of FIG. 2, except that a light-shielding pattern 500 and a functional region 400 are additionally on the encapsulation portion 300. The functional region 400 may be i) a color filter area, ii) a color conversion area, or iii) a combination of the color filter area and the color conversion area. In an embodiment, the light-emitting device included in the light-emitting apparatus of FIG. 3 may be a tandem light-emitting device.

### Manufacturing method

The layers included in the hole transport region, the emission layer, and the layers included in the electron transport region may be formed in a certain region by using various suitable methods such as vacuum deposition, spin coating, casting, Langmuir-Blodgett (LB) deposition, ink-jet printing, laser-printing, laser-induced thermal imaging, and/or the like.

When layers constituting the hole transport region, an emission layer, and layers constituting the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of Terms

The term "C₃-C₆₀ carbocyclic group," as used herein, refers to a cyclic group consisting of carbon only as a ring-forming atom and having three to sixty carbon atoms, and the term "C₁-C₆₀ heterocyclic group," as used herein, refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed together with each other. For example, the C₁-C₆₀ heterocyclic group has 3 to 61 ring-forming atoms.

The term "cyclic group," as used herein, may include the C₃-C₆₀ carbocyclic group, and the C₁-C₆₀ heterocyclic group.

The term "π electron-rich C₃-C₆₀ cyclic group," as used herein, refers to a cyclic group that has three to sixty carbon atoms and does not include *-N=*' as a ring-forming moiety, and the term "π electron-deficient nitrogen-containing C₁-C₆₀ cyclic group," as used herein, refers to a heterocyclic group that has one to sixty carbon atoms and includes *-N=*' as a ring-forming moiety.

For example,
the C₃-C₆₀ carbocyclic group may be i) group T1 or ii) a condensed cyclic group in which two or more groups T1 are condensed together with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) group T2, ii) a condensed cyclic group in which two or more groups T2 are condensed together with each other, or iii) a condensed cyclic group in which at least one group T2 and at least one group T1 are condensed together with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) group T1, ii) a condensed cyclic group in which two or more groups T1 are condensed together with each other, iii) group T3, iv) a condensed cyclic group in which two or more groups T3 are condensed together with each other, or v) a condensed cyclic group in which at least one group T3 and at least one group T1 are condensed together with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) group T4, ii) a condensed cyclic group in which two or more groups T4 are condensed together with each other, iii) a condensed cyclic group in which at least one group T4 and at least one group T1 are condensed together with each other, iv) a condensed cyclic group in which at least one group T4 and at least one group T3 are condensed together with each other, or v) a condensed cyclic group in which at least one group T4, at least one group T1, and at least one group T3 are condensed together with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
group T3 may be a furan group, a thiophene group, a 1H-pyrrole group, a silole group, or a borole group, and
group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group," "the C₃-C₆₀ carbocyclic group," "the C₁-C₆₀ heterocyclic group," "the π electron-rich C₃-C₆₀ cyclic group," or "the π electron-deficient nitrogen-containing C₁-C₆₀ cyclic group," as used herein, refer to a group condensed to any cyclic group, a monovalent group, or a polyvalent group (for example, a divalent group, a trivalent group, a tetravalent group, etc.) according to the structure of a formula for which the corresponding term is used. For example, the "benzene group" may be a benzo group, a phenyl group, a phenylene group, or the like, which may be easily understood by one of ordinary skill in the art according to the structure of a formula including the "benzene group."

Examples of the monovalent C₃-C₆₀ carbocyclic group and the monovalent C₁-C₆₀ heterocyclic group include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the monovalent C₁-C₆₀ heterocyclic group include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group," as used herein, refers to a linear or branched aliphatic hydrocarbon monovalent group that has one to sixty carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group," as used herein, refers to a divalent group having substantially the same structure as the C₁-C₆₀ alkyl group.

The term "C₂-C₆₀ alkenyl group," as used herein, refers to a monovalent hydrocarbon group having at least one carbon-carbon double bond at a main chain (e.g., in the middle) or at a terminal end (e.g., the terminus) of the C₂-C₆₀ alkyl group, and examples thereof include an ethenyl group, a propenyl group, and a butenyl group. The term "C₂-C₆₀ alkenylene group," as used herein, refers to a divalent group having substantially the same structure as the C₂-C₆₀ alkenyl group.

The term "C₂-C₆₀ alkynyl group," as used herein, refers to a monovalent hydrocarbon group having at least one carbon-carbon triple bond at a main chain (e.g., in the middle) or at a terminal end (e.g., the terminus) of the C₂-C₆₀ alkyl group, and examples thereof include an ethynyl group and a propynyl group. The term "C₂-C₆₀ alkynylene group," as used herein, refers to a divalent group having substantially the same structure as the C₂-C₆₀ alkynyl group.

The term "C₁-C₆₀ alkoxy group," as used herein, refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₃-C₁₀ cycloalkyl group," as used herein, refers to a monovalent saturated hydrocarbon cyclic group having 3 to 10 carbon atoms, and examples thereof include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group," as used herein, refers to a divalent group having substantially the same structure as the C₃-C₁₀ cycloalkyl group.

The term "C₁-C₁₀ heterocycloalkyl group," as used herein, refers to a monovalent cyclic group of 1 to 10 carbon atoms, further including, in addition to carbon atoms, at least one heteroatom, as ring-forming atoms, and examples thereof include a 1,2,3,4-oxatriazolidinyl group, a tetrahydrofuranyl group, and a tetrahydrothiophenyl group. The term "C₁-C₁₀ heterocycloalkylene group," as used herein, refers to a divalent group having substantially the same structure as the C₁-C₁₀ heterocycloalkyl group.

The term "C₃-C₁₀ cycloalkenyl group," as used herein, refers to a monovalent cyclic group that has three to ten carbon atoms and at least one carbon-carbon double bond in the ring thereof and no aromaticity (e.g., is not aromatic), and examples thereof include a cyclopentenyl group, a cyclohexenyl group, and a cycloheptenyl group. The term "C₃-C₁₀ cycloalkenylene group," as used herein, refers to a divalent group having substantially the same structure as the C₃-C₁₀ cycloalkenyl group.

The term "C₁-C₁₀ heterocycloalkenyl group," as used herein, refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group," as used herein, refers to a divalent group having substantially the same structure as the C₁-C₁₀ heterocycloalkenyl group.

The term "C₆-C₆₀ aryl group," as used herein, refers to a monovalent group having a carbocyclic aromatic system of 6 to 60 carbon atoms, and the term "C₆-C₆₀ arylene group," as used herein, refers to a divalent group having a carbocyclic aromatic system of 6 to 60 carbon atoms. Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the rings may be condensed together with each other.

The term "C₁-C₆₀ heteroaryl group," as used herein, refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group," as used herein, refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed together with each other.

The term "monovalent non-aromatic condensed polycyclic group," as used herein, refers to a monovalent group (for example, having 8 to 60 carbon atoms) having two or more rings condensed to each other, only carbon atoms as ring-forming atoms, and no aromaticity in its entire molecular structure (e.g., is not aromatic when considered as a whole). Examples of the monovalent non-aromatic condensed polycyclic group include an indenyl group, a fluorenyl group, a spiro-bifluorenyl group, a benzofluorenyl group, an indenophenanthrenyl group, and an indeno anthracenyl group. The term "divalent non-aromatic condensed polycyclic group," as used herein, refers to a divalent group having substantially the same structure as the monovalent non-aromatic condensed polycyclic group described above.

The term "monovalent non-aromatic condensed heteropolycyclic group," as used herein, refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure (e.g., is not aromatic when considered as a whole). Examples of the monovalent non-aromatic condensed heteropolycyclic group include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphtho silolyl group, a benzofurodibenzofuranyl group, a benzofurodibenzothiophenyl group, and a benzothienodibenzothiophenyl group. The term "divalent non-aromatic condensed heteropolycyclic group," as used herein, refers to a divalent group having substantially the same structure as the monovalent non-aromatic condensed heteropolycyclic group described above.

The term "C₆-C₆₀ aryloxy group," as used herein, indicates -OA₁₀₂ (wherein A₁₀₂ is the C₆-C₆₀ aryl group), and the term "C₆-C₆₀ arylthio group," as used herein, indicates -SA₁₀₃ (wherein A₁₀₃ is the C₆-C₆₀ aryl group).

The term "C₇-C₆₀ aryl alkyl group," as used herein, refers to -A₁₀₄A₁₀₅ (where A₁₀₄ may be a C₁-C₅₄ alkylene group, and A₁₀₅ may be a C₆-C₅₉ aryl group), and the term "C₂-C₆₀ heteroaryl alkyl group," as used herein, refers to -A₁₀₆A₁₀₇ (where A₁₀₆ may be a C₁-C_{S9} alkylene group, and A₁₀₇ may be a C₁-C₅₉ heteroaryl group).

The term "R₁₀ₐ," as used herein, refers to:
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃, and Q₃₁ to Q₃₃ in the present specification may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

The term "heteroatom," as used herein, refers to any suitable atom other than a carbon atom. Examples of the heteroatom include O, S, N, P, Si, B, Ge, Se, and any combinations thereof.

The term "third-row transition metal," as used herein, includes hafnium (Hf), tantalum (Ta), tungsten (W), rhenium (Re), osmium (Os), iridium (Ir), platinum (Pt), gold (Au), and the like.

"Ph," as used herein, refers to a phenyl group, "Me," as used herein, refers to a methyl group, "Et," as used herein, refers to an ethyl group, "ter-Bu" or "Bu^{t}," as used herein, refers to a tert-butyl group, and "OMe," as used herein, refers to a methoxy group.

The term "biphenyl group," as used herein, refers to "a phenyl group substituted with a phenyl group." In other words, the "biphenyl group" is a substituted phenyl group having a C₆-C₆₀ aryl group as a substituent.

The term "terphenyl group," as used herein, refers to "a phenyl group substituted with a biphenyl group". In other words, the "terphenyl group" is a substituted phenyl group having, as a substituent, a C₆-C₆₀ aryl group substituted with a C₆-C₆₀ aryl group.

* and *', as used herein, unless defined otherwise, each refer to a binding site to a neighboring atom in a corresponding formula or moiety.

Hereinafter, a light-emitting device according to embodiments will be described in more detail with reference to Examples.

### Examples

### Evaluation Example 1

According to the method in Table 1, the HOMO energy level, LUMO energy level, band gap and triplet (T₁) energy of each of Compounds PD01, PD02, PD04, PD05, PD06, PD07, PD09, A01, A02, and A03 were evaluated. The results are shown in Table 2.

**Table 1**

| | |
|---|---|
| HOMO energy level evaluation method | By using cyclic voltammetry (CV) (electrolyte: 0.1 M Bu₄NPF₆/solvent: dimethylforamide (DMF)/electrode: 3-electrode system (working electrode: GC, reference electrode: Ag/AgCl, and auxiliary electrode: Pt)), the potential (V)-current (A) graph of each compound was obtained, and then, from the oxidation onset of the graph, the HOMO energy level of each compound was calculated. |
| LUMO energy level evaluation method | By using cyclic voltammetry (CV) (electrolyte: 0.1 M Bu₄NPF₆/solvent: dimethylforamide (DMF)/electrode: 3-electrode system (working electrode: GC, reference electrode: |
| | Ag/AgCl, and auxiliary electrode: Pt)), the potential (V)-current (A) graph of each compound was obtained, and then, from the reduction onset of the graph, the LUMO energy level of each compound was calculated. |
| Band gap evaluation method | The absolute value of the difference between HOMO energy level and LUMO energy level was calculated |
| Triplet (T₁) energy | A mixture of 2-methyl-THF(2-MeTHF) and each compound (each compound was dissolved to a concentration of 10 µM in 3 mL of 2-MeTHF) was put into a quartz cell, which was then placed in a cryostat containing liquid nitrogen (77 K)(Oxford, DN). Then, the phosphorescent spectrum thereof was measured using a luminescence measuring instrument (PTI, Quanta Master 400), and then the triplet energy level was measured from the peak wavelength of the phosphorescent spectrum. |

**Table 2**

| | HOMO (eV) | LUMO (eV) | Band gap (eV) | T₁ (eV) |
|---|---|---|---|---|
| BD01 | -4.98 | -2.48 | 2.50 | 2.38 |
| PD02 | -5.2 | -2.55 | 2.65 | 2.23 |
| PD04 | -4.84 | -2.35 | 2.45 | 2.340 |
| PD05 | -5.01 | -2.35 | 2.68 | 2.38 |
| PD06 | -4.85 | -2.35 | 2.052 | 2.320 |
| PD07 | -4.86 | -2.34 | 2.52 | 2.32 |
| PD09 | -4.80 | -2.31 | 2.49 | 2.29 |
| A01 | -4.93 | -1.97 | 2.96 | 2.34 |
| A02 | -4.84 | -1.94 | 2.90 | 2.31 |
| A03 | -5.21 | -2.41 | 2.80 | 2.11 |

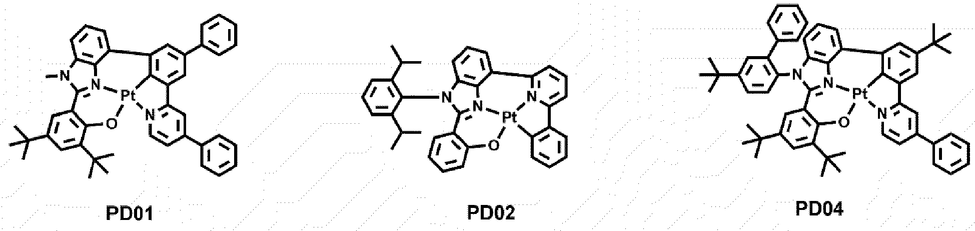

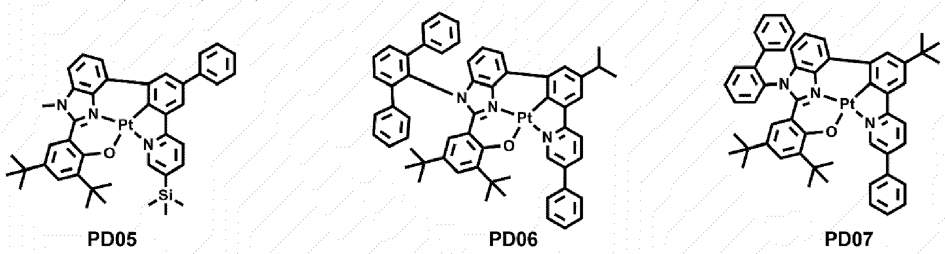

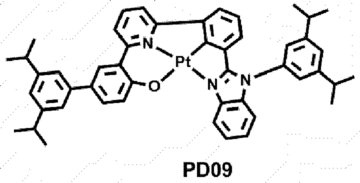

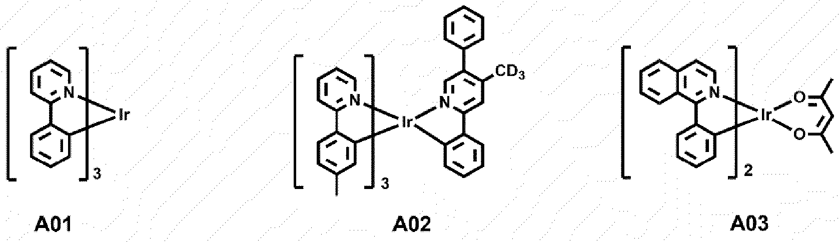

### Evaluation Example 2

PMMA in CH₂Cl₂ solution and Compound PD01 (4 wt% to PMMA) were mixed together, and then, the resultant obtained therefrom was coated on a quartz substrate using a spin coater, and then heat treated in an oven at 80 °C, followed by cooling to room temperature to manufacture a film PD01 having a thickness of 40 nm. Films PD02, PD04, PD05, PD06, PD07, PD09, A01, A02, and A03 were prepared in substantially the same manner as used to prepare film PD01, except that Compounds PD02, PD04, PD05, PD06, PD07, PD09, A01, A02, and A03 were each used instead of Compound PD01.

The emission spectrum of each of films PD01, PD02, PD04, PD05, PD06, PD07, PD09, A01, A02, and A03 were measured by using a Quantaurus-QY Absolute PL quantum yield spectrometer of Hamamatsu Inc. (equipped with a xenon light source, a monochromator, a photonic multichannel analyzer, and an integrating sphere, and using PLQY measurement software (Hamamatsu Photonics, Ltd., Shizuoka, Japan)). During measurement, the excitation wavelength was scanned from 320 nm to 380 nm at 10 nm intervals, and the spectrum measured at the excitation wavelength of 340 nm was used to obtain the maximum emission wavelength (emission peak wavelength) and FWHM of the compound included in each film. Results thereof are summarized in Table 3.

**Table 3**

| Film No. | Compound included in film (4 wt% in PMMA) | Maximum emission wavelength (nm) | FWHM (nm) |
|---|---|---|---|
| PD01 | PD01 | 526 | 32 |
| PD02 | PD02 | 543 | 25 |
| PD04 | PD04 | 527 | 53 |
| PD05 | PD05 | 525 | 59 |
| PD06 | PD06 | 535 | 60 |
| PD07 | PD07 | 528 | 53 |
| PD09 | PD09 | 533 | 50 |
| A01 | A01 | 516 | 62 |
| A02 | A02 | 517 | 66 |
| A03 | A03 | 633 | 46 |

From Table 3, it can be seen that Compounds PD01, PD02, PD04, PD05, PD06, PD07, and PD09 emit green light having a relatively small FWHM compared to Compounds A01 to A03.

### Evaluation Example 3

Compound CP01 was deposited on a glass substrate to prepare film CP01 having a thickness of 60 nm. Then, for the film CP01, the refractive index of Compound CP01 with respect to light having a wavelength of 530 nm was measured according to the Cauchy Film Model by using an Ellipsometer M-2000 (JA Woollam) at a temperature of 25 °C and in 50% relative humidity. Results thereof are shown in Table 4. This experiment was performed on each of Compounds CP02, CP03, CP04, CP06, CP09, CP10, CP11, B01, and B02, and results thereof are shown in Table 4.

**Table 4**

| Film no. | Compound included in film | Refractive index for light having a wavelength of 530 nm |
|---|---|---|
| CP01 | CP01 | 1.997 |
| CP04 | CP04 | 1.951 |
| CP06 | CP06 | 2.009 |
| CP09 | CP09 | 1.951 |
| CP10 | CP10 | 1.974 |
| CP11 | CP11 | 1.951 |
| B01 | B01 | 1.757 |
| B02 | B02 | 1.844 |

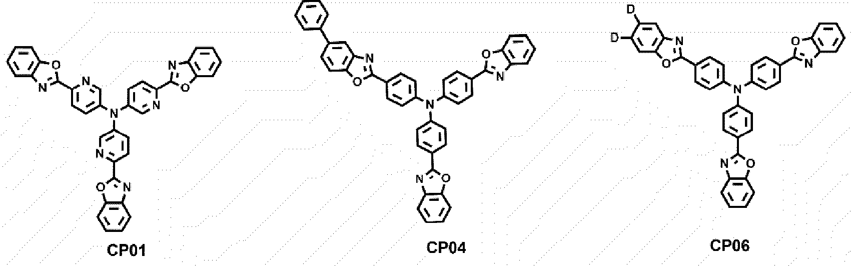

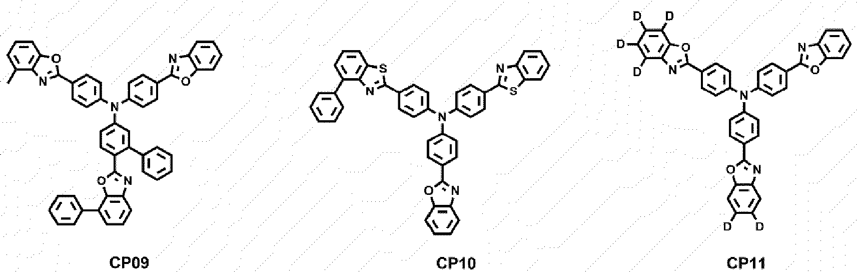

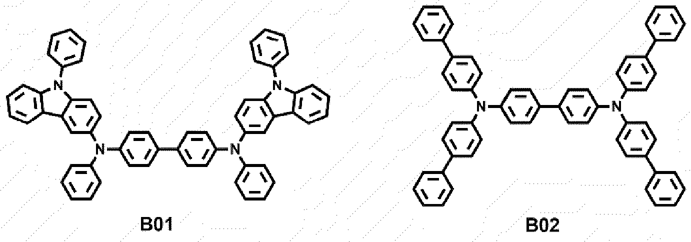

### Example 1

A glass substrate (available from Corning Co., Ltd) on which an ITO anode (15 Ohms per square centimeter (Ω/cm²)) having a thickness of 1,200 Å was formed was cut to a size of 50 millimeters (mm)×50 mm×0.7 mm, sonicated in isopropyl alcohol and pure water for 5 minutes in each solvent, cleaned with ultraviolet rays for 30 minutes, and then ozone, and was mounted on a vacuum deposition apparatus.

HT3 was vacuum-deposited on the ITO anode to form a hole transport layer having a thickness of 600 Å, and HT40 was vacuum-deposited on the hole transport layer to form an emission auxiliary layer having a thickness of 250 Å.

Compound H125, Compound H126, and Compound PD01 (first emitter) were vacuum-deposited on the emission auxiliary layer at the weight ratio of 45 : 45 : 10 to form an emission layer having a thickness of 300 Å.

Compound ET37 was vacuum-deposited on the emission layer to form a buffer layer having a thickness of 50 Å, and ET46 and LiQ were vacuum-deposited on the buffer layer at the weight ratio of 5 : 5 to form an electron transport layer having a thickness of 310 Å. Subsequently, Yb was vacuum-deposited on the electron transport layer to form an electron injection layer having a thickness of 15 Å, and then, Ag and Mg were vacuum-deposited thereon to form a cathode having a thickness of 100 Å.

Subsequently, Compound CP04 was vacuum-deposited on the cathode to form a capping layer having a thickness of 700 Å to complete the manufacturing of an organic light-emitting device.

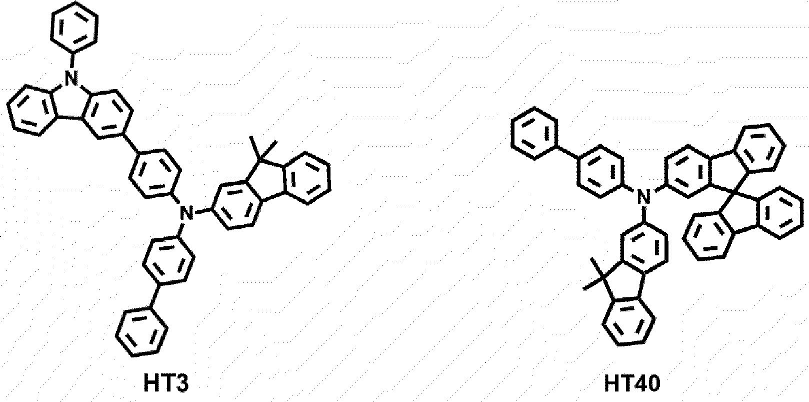

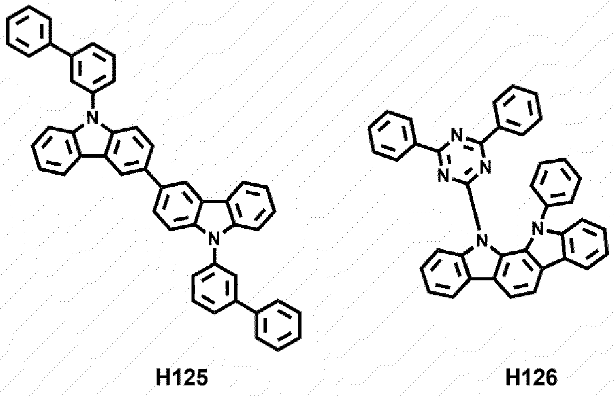

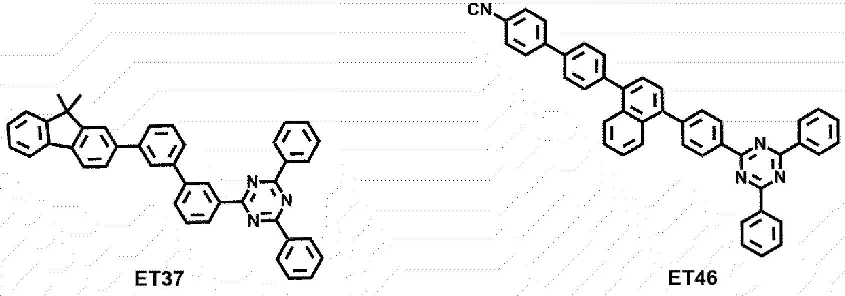

### Examples 2 to 8 and Comparative Examples 1 to 6, 8, 9, 11, 12, 14, 15, and 17 to 20

Organic light-emitting devices were manufactured in substantially the same manner as in Example 1, except that each of the compounds shown in Table 5 was used as a material for forming the first emitter in the emission layer or a material for forming the capping layer.

### Comparative Examples 7, 10, 13, and 16

Organic light-emitting devices were manufactured in substantially the same manner as in Example 1, except that each of the compound shown in Table 5 was used as a material for forming the first emitter in the emission layer, and the capping layer was not formed.

### Evaluation Example 4

The color purity (CIEx and CIEy coordinates) at 400 cd/m², frontal (0°) luminescence efficiency (cd/A), and lateral (45°) luminescence efficiency (cd/A) of the organic light-emitting devices manufactured according to Examples 1 to 8 and Comparative Examples 1 and 20 were evaluated by using a luminance meter (Minolta Cs-1000A). Results thereof are shown in Tables 6 to 9. Meanwhile, the RCR values calculated with reference to Table 4 are also summarized in Table 5.

**Table 5**

| | First emitter | Material for capping layer | Refractive index of material for capping layer with respect to light having a wavelength of 530 nm | CIEx | CIEy | RCR value |
|---|---|---|---|---|---|---|
| Example 1 | PD01 | CP04 | 1.951 | 0.246 | 0.722 | 37.01 |
| Example 2 | PD01 | CP06 | 2.009 | 0.246 | 0.723 | 35.99 |
| Example 3 | PD05 | CP04 | 1.951 | 0.240 | 0.721 | 36.96 |
| Example 4 | PD05 | CP06 | 2.009 | 0.249 | 0.716 | 35.64 |
| Example 5 | PD07 | CP04 | 1.951 | 0.243 | 0.723 | 37.06 |
| Example 6 | PD07 | CP06 | 2.009 | 0.249 | 0.717 | 35.69 |
| Example 7 | PD09 | CP04 | 1.951 | 0.248 | 0.723 | 37.06 |
| Example 8 | PD09 | CP06 | 2.009 | 0.244 | 0.721 | 35.89 |
| Comparative Example 1 | A01 | B01 | 1.757 | 0.249 | 0.711 | 40.47 |
| Comparative Example 2 | A02 | B01 | 1.757 | 0.245 | 0.707 | 40.24 |
| Comparative Example 3 | A01 | B02 | 1.844 | 0.249 | 0.713 | 38.67 |
| Comparative Example 4 | A02 | B02 | 1.844 | 0.249 | 0.708 | 38.39 |
| Comparative Example 5 | PD01 | B01 | 1.757 | 0.246 | 0.722 | 41.09 |
| Comparative Example 6 | PD01 | B02 | 1.844 | 0.246 | 0.723 | 39.21 |
| Comparative Example 7 | PD01 | - | - | 0.249 | 0.716 | - |
| Comparative Example 8 | PD05 | B01 | 1.757 | 0.240 | 0.721 | 41.04 |
| Comparative Example 9 | PD05 | B02 | 1.844 | 0.240 | 0.716 | 38.83 |
| Comparative Example 10 | PD05 | - | - | 0.245 | 0.707 | - |
| Comparative Example 11 | PD07 | B01 | 1.757 | 0.243 | 0.723 | 41.15 |
| Comparative Example 12 | PD07 | B02 | 1.844 | 0.243 | 0.717 | 38.88 |
| Comparative Example 13 | PD07 | - | - | 0.250 | 0.710 | - |
| Comparative Example 14 | PD09 | B01 | 1.757 | 0.248 | 0.723 | 41.15 |
| Comparative Example 15 | PD09 | B02 | 1.844 | 0.248 | 0.721 | 39.10 |
| Comparative Example 16 | PD09 | - | - | 0.250 | 0.715 | - |
| Comparative Example 17 | A01 | CP04 | 1.951 | 0.249 | 0.711 | 36.44 |
| Comparative Example 18 | A02 | CP04 | 1.951 | 0.245 | 0.707 | 36.24 |
| Comparative Example 19 | A01 | CP06 | 2.009 | 0.249 | 0.711 | 35.39 |
| Comparative Example 20 | A02 | CP06 | 2.009 | 0.245 | 0.708 | 35.24 |

**Table 6**

| | First emitter | Material for capping layer | Frontal (0°) luminescence efficiency (cd/A) | Lateral (45°) luminescence efficiency (cd/A) |
|---|---|---|---|---|
| Example 1 | PD01 | CP04 | 180.1 | 83.7 |
| Example 2 | PD01 | CP06 | 174.7 | 80.9 |
| Comparative Example 1 | A01 | B01 | 150.3 | 86.6 |
| Comparative Example 2 | A02 | B01 | 144.6 | 82.8 |
| Comparative Example 3 | A01 | B02 | 153.1 | 88.5 |
| Comparative Example 4 | A02 | B02 | 147.3 | 84.5 |
| Comparative Example 5 | PD01 | B01 | 151.6 | 75.8 |
| Comparative Example 6 | PD01 | B02 | 153.0 | 76.5 |
| Comparative Example 7 | PD01 | - | 147.7 | 77.0 |
| Comparative Example 17 | A01 | CP04 | 168.7 | 87.7 |
| Comparative Example 18 | A02 | CP04 | 164.2 | 83.7 |
| Comparative Example 19 | A01 | CP06 | 166.2 | 86.4 |
| Comparative Example 20 | A02 | CP06 | 162.4 | 82.8 |

**Table 7**

| | First emitter | Material for capping layer | Frontal (0°) luminescence efficiency (cd/A) | Lateral (45°) luminescence efficiency (cd/A) |
|---|---|---|---|---|
| Example 3 | PD05 | CP04 | 171.4 | 97.6 |
| Example 4 | PD05 | CP06 | 167.1 | 97.5 |
| Comparative Example 1 | A01 | B01 | 150.3 | 86.6 |
| Comparative Example 2 | A02 | B01 | 144.6 | 82.8 |
| Comparative Example 3 | A01 | B02 | 153.1 | 88.5 |
| Comparative Example 4 | A02 | B02 | 147.3 | 84.5 |
| Comparative Example 8 | PD05 | B01 | 144.7 | 88.2 |
| Comparative Example 9 | PD05 | B02 | 145.4 | 88.6 |
| Comparative Example 10 | PD05 | - | 144.8 | 92.1 |
| Comparative Example 17 | A01 | CP04 | 168.7 | 87.7 |
| Comparative Example 18 | A02 | CP04 | 164.2 | 83.7 |
| Comparative Example 19 | A01 | CP06 | 166.2 | 86.4 |
| Comparative Example 20 | A02 | CP06 | 162.4 | 82.8 |

**Table 8**

| | First emitter | Material for capping layer | Frontal (0°) luminescence efficiency (cd/A) | Lateral (45°) luminescence efficiency (cd/A) |
|---|---|---|---|---|
| Example 5 | PD07 | CP04 | 181.7 | 95.6 |
| Example 6 | PD07 | CP06 | 176.8 | 97.9 |
| Comparative Example 1 | A01 | B01 | 150.3 | 86.6 |
| Comparative Example 2 | A02 | B01 | 144.6 | 82.8 |
| Comparative Example 3 | A01 | B02 | 153.1 | 88.5 |
| Comparative Example 4 | A02 | B02 | 147.3 | 84.5 |
| Comparative Example 11 | PD07 | B01 | 154.4 | 88.0 |
| Comparative Example 12 | PD07 | B02 | 155.2 | 88.4 |
| Comparative Example 13 | PD07 | - | 152.1 | 92.1 |
| Comparative Example 17 | A01 | CP04 | 168.7 | 87.7 |
| Comparative Example 18 | A02 | CP04 | 164.2 | 83.7 |
| Comparative Example 19 | A01 | CP06 | 166.2 | 86.4 |
| Comparative Example 20 | A02 | CP06 | 162.4 | 82.8 |

**Table 9**

| | First emitter | Material for capping layer | Frontal (0°) luminescence efficiency (cd/A) | Lateral (45°) luminescence efficiency (cd/A) |
|---|---|---|---|---|
| Example 7 | PD09 | CP04 | 192.0 | 79.9 |
| Example 8 | PD09 | CP06 | 185.6 | 79.3 |
| Comparative Example 1 | A01 | B01 | 150.3 | 86.6 |
| Comparative Example 2 | A02 | B01 | 144.6 | 82.8 |
| Comparative Example 3 | A01 | B02 | 153.1 | 88.5 |
| Comparative Example 4 | A02 | B02 | 147.3 | 84.5 |
| Comparative Example 14 | PD09 | B01 | 161.1 | 75.7 |
| Comparative Example 15 | PD09 | B02 | 161.6 | 75.9 |
| Comparative Example 16 | PD09 | - | 153.4 | 73.8 |
| Comparative Example 17 | A01 | CP04 | 168.7 | 87.7 |
| Comparative Example 18 | A02 | CP04 | 164.2 | 83.7 |
| Comparative Example 19 | A01 | CP06 | 166.2 | 86.4 |
| Comparative Example 20 | A02 | CP06 | 162.4 | 82.8 |

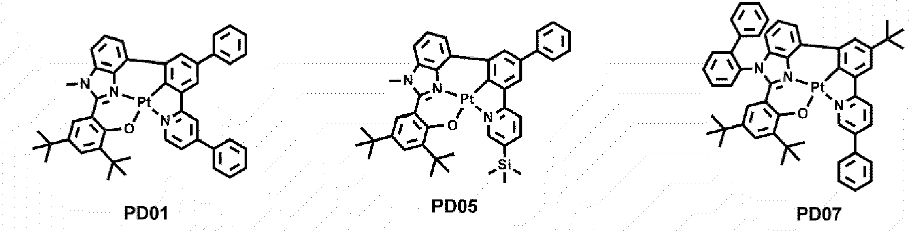

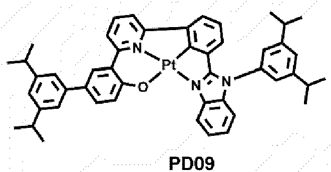

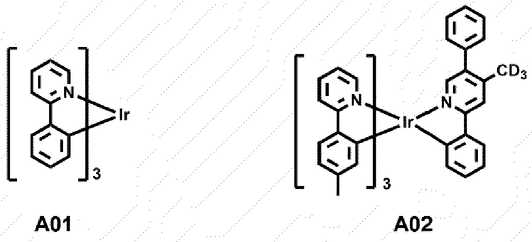

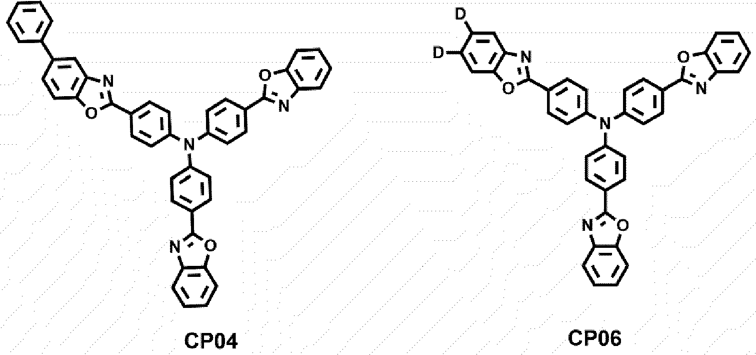

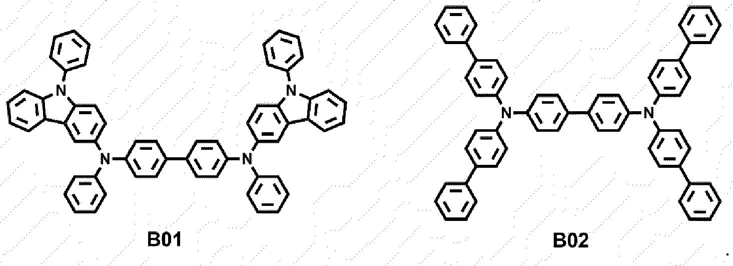

1) From Tables 5 and 6, it can be seen that the organic light-emitting devices of Examples 1 and 2 including the first emitter including platinum (emitting green light having a maximum emission wavelength in a range of 520 nm to 550 nm) and having an RCR value of 38 or less, had an equivalent level of lateral luminescence efficiency and improved frontal luminescence efficiency, compared to the organic light-emitting devices of Comparative Examples 1 to 7 and 17 to 20,
2) from Tables 5 and 7, it can be seen that the organic light-emitting devices of Examples 3 and 4 including the first emitter including platinum (emitting green light having a maximum emission wavelength in a range of 520 nm to 550 nm) and having an RCR value of 38 or less, had an equivalent level of lateral luminescence efficiency and improved frontal luminescence efficiency, compared to the organic light-emitting devices of Comparative Examples 1 to 4, 8 to 10 and 17 to 20,
3) from Tables 5 and 8, it can be seen that the organic light-emitting devices of Examples 3 and 4 including the first emitter including platinum (emitting green light having a maximum emission wavelength in a range of 520 nm to 550 nm) and having an RCR value of 38 or less, had an equivalent level of lateral luminescence efficiency and improved frontal luminescence efficiency, compared to the organic light-emitting devices of Comparative Examples 1 to 4, 11 to 13, and 17 to 20, and
4) from Tables 5 and 9, it can be seen that the organic light-emitting devices of Examples 5 and 6 including the first emitter including platinum (emitting green light having a maximum emission wavelength in a range of 520 nm to 550 nm) and having an RCR value of 38 or less, had an equivalent level of lateral luminescence efficiency and improved frontal luminescence efficiency, compared to the organic light-emitting devices of Comparative Examples 1 to 4 and 14 to 20.

Because the light-emitting device of embodiments of the present disclosure has excellent frontal luminescence efficiency and lateral luminescence efficiency at the same time, a high-quality electronic apparatus can be manufactured using the same.

While one or more embodiments have been described with reference to the figures, it will be understood by those of ordinary skill in the art that various changes in form and details may be made therein without departing from the scope of the present disclosure as defined by the following claims.

## Claims

1. A light-emitting device (10) comprising:
a first electrode (110);
a second electrode (150) facing the first electrode (110);
an interlayer (130) between the first electrode (110) and the second electrode (150) and comprising an emission layer; and
a capping layer (170),
wherein the emission layer comprises a first emitter,
the first emitter emits a first light having a first emission spectrum,
the capping layer (170) is in a path along which the first light travels,
an emission peak wavelength of the first light is about 520 nm to about 550 nm,
the first emitter comprises platinum and a first ligand bound to the platinum,the capping layer (170) comprises an amine-containing compound, and
the amine-containing compound comprises a benzoxazole group, a benzothiazole group, a naphthooxazole group, a naphthothiazole group, or any combination thereof
**characterized in that**
the first emitter satisfies at least two selected from Condition A to Condition C:
Condition A
the first ligand is a tetradentate ligand, and the number of cyclometallated rings formed by the chemical bond between the platinum and the first ligand is three;
Condition B
the platinum is chemically bonded to a carbon, a nitrogen, and an oxygen of the first ligand; and
Condition C.
the first ligand comprises an imidazole group, a benzimidazole group, a naphthoimidazole group, or any combination thereof,
wherein the first emitter is an organometallic compound represented by Formula 1: 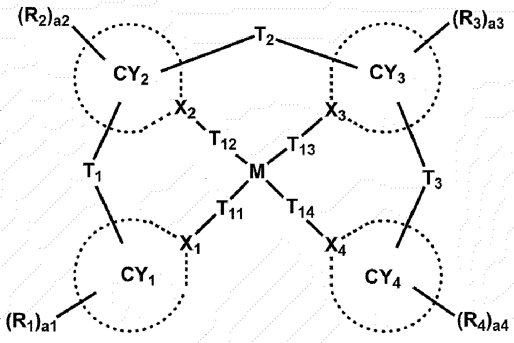
a value of a ratio of CIEy to a reflective index (RCR value) of the first light extracted to the outside through the capping layer (170) is 38 or less, and
the RCR value is calculated according to Equation 1: $CIEy / R \left(cap\right) \times 100$ Equation 1
wherein, in Equation 1,
CIEy is a y coordinate value of the CIE color coordinates of the first light extracted to the outside through the capping layer (170), and
R(cap) is the refractive index of the amine-containing compound with respect to a second light having a wavelength within ± 20 nm of the emission peak wavelength of the first light,
the amine-containing compound is a compound represented by Formula 8: 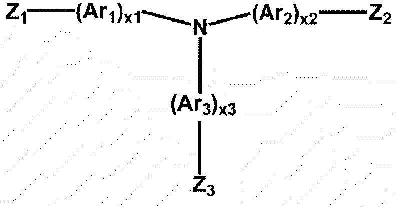
wherein, in Formula 1 and 8:
M is Pt,
X1 to X4 is each independently N or C,
T11 to T14 is each independently a chemical bond, O, S, B(R'), N(R'), P(R'), C(R')(R"), Si(R')(R"), Ge(R')(R"), C(=O), B(R')(R"), N(R')(R"), or P(R')(R"),
When T11 is a chemical bond, X1 and M is directly bonded to each other, when T12 is a chemical bond, X2 and M is directly bonded to each other, when T13 is a chemical bond, X3 and M is directly bonded to each other, when T14 is a chemical bond, X4 and M is directly bonded to each other,
Two of the bonds selected from a bond between X1 or T11 and M, a bond between X2 or T12 and M, a bond between X3 or T13 and M, and a bond between X4 or T14 and M are coordinate bonds, and the other two bonds are covalent bonds,
T1 is a single bond, a double bond, *-N(R5)-*', *-B(R5)-*', *-P(R5)-*', *-C(R5a)(R5b)-*', *-Si(R5a)(R5b)-*', *-Ge(R5a)(R5b)-*', *-S-*', *-Se-*', *-O-*', *-C(=O)-*', *-S(=O)-*', *-S(=O)2-*', *-C(R5)=*', *=C(R5)-*', *-C(R5a)=C(R5b)-*', *-C(=S)-*', or *-C≡C-*',
T2 is a single bond, a double bond, *-N(R6)-*', *-B(R6)-*', *-P(R6)-*', *-C(R6a)(R6b)-*', *-Si(R6a)(R6b)-*', *-Ge(R6a)(R6b)-*', *-S-*', *-Se-*', *-O-*', *-C(=O)-*', *-S(=O)-*', *-S(=O)2-*', *-C(R6)=*', *=C(R6)-*', *-C(R6a)=C(R6b)-*', *-C(=S)-*', or *-C≡C-*',
T3 is a single bond, a double bond, *-N(R7)-*', *-B(R7)-*', *-P(R7)-*', *-C(R7a)(R7b)-*', *-Si(R7a)(R7b)-*', *-Ge(R7a)(R7b)-*', *-S-*', *-Se-*', *-O-*', *-C(=O)-*', *-S(=O)-*', *-S(=O)2-*', *-C(R7)=*', *=C(R7)-*', *-C(R7a)=C(R7b)-*', *-C(=S)-*', or *-C≡C-*',
ring CY1 to ring CY4 is independently a C3-C60 carbocyclic group or a C1-C60 heterocyclic group,
Ar1 to Ar3 and Z1 to Z3 is each independently a C3-C60 carbocyclic group unsubstituted or substituted with at least one R10a, or a C1-C60 heterocyclic group unsubstituted or substituted with at least one R10a,
x1 to x3 is each independently one selected from an integer from 0 to 10,
i) when x1 is 0, *-(Ar1)x1-*' is a single bond, ii) when x2 is 0, *-(Ar2)x2-*' is a single bond, and iii) when x3 is 0, *-(Ar3)x3-*' is a single bond,
R1 to R7, R5a, R5b, R6a, R6b, R7a, R7b, R', and R" is each independently hydrogen, deuterium, -F, -Cl, -Br, -I, a hydroxyl group, a cyano group, a nitro group, a C1-C60 alkyl group unsubstituted or substituted with at least one R10a, a C2-C60 alkenyl group unsubstituted or substituted with at least one R10a, a C2-C60 alkynyl group unsubstituted or substituted with at least one R10a, a C1-C60 alkoxy group unsubstituted or substituted with at least one R10a, a C3-C60 carbocyclic group unsubstituted or substituted with at least one R10a, a C1-C60 heterocyclic group unsubstituted or substituted with at least one R10a, a C6-C60 aryloxy group unsubstituted or substituted with at least one R10a, a C6-C60 arylthio group unsubstituted or substituted with at least one R10a, a C7-C60 aryl alkyl group unsubstituted or substituted with at least one R10a, a C2-C60 heteroaryl alkyl group unsubstituted or substituted with at least one R10a,-C(Q1)(Q2)(Q3), -Si(Q1)(Q2)(Q3), -N(Q1)(Q2), - B(Q1)(Q2), -C(=O)(Q1), -S(=O)2(Q1), or -P(=O)(Q1)(Q2),
a1 to a4 is each independently one selected from an integer from 0 to 20,
* and *' each indicate a binding site to an adjacent atom,
Each of i) two groups of R1(s) in the number of a1, ii) two groups of R2(s) in the number of a2, iii) two groups of R3(s) in the number of a3, iv) two groups of R4(s) in the number of a4, v) R5a and R5b, vi) R6a and R6b, and vii) R7a and R7b, is optionally bonded to each other via a single bond, a double bond, or a first linking group to form a C3-C60 carbocyclic group unsubstituted or substituted with at least one R10a or a C1-C60 heterocyclic group unsubstituted or substituted with at least one R10a,
R10a is:
deuterium, -F, -Cl, -Br, -I, a hydroxyl group, a cyano group, or a nitro group,
a C1-C60 alkyl group, a C2-C60 alkenyl group, a C2-C60 alkynyl group, or a C1-C60 alkoxy group, each unsubstituted or substituted with deuterium, -F, -Cl, -Br, -I, a hydroxyl group, a cyano group, a nitro group, a C3-C60 carbocyclic group, a C1-C60 heterocyclic group, a C6-C60 aryloxy group, a C6-C60 arylthio group, a C7-C60 aryl alkyl group, a C2-C60 heteroaryl alkyl group, - Si(Q11)(Q12)(Q13), -N(Q11)(Q12), -B(Q11)(Q12), -C(=O)(Q11), -S(=O)2(Q11), -P(=O)(Q11)(Q12), or any combination thereof,
a C3-C60 carbocyclic group, a C1-C60 heterocyclic group, a C6-C60 aryloxy group, a C6-C60 arylthio group, a C7-C60 aryl alkyl group, or a C2-C60 heteroaryl alkyl group, each unsubstituted or substituted with deuterium, -F, -Cl, -Br, -I, a hydroxyl group, a cyano group, a nitro group, a C1-C60 alkyl group, a C2-C60 alkenyl group, a C2-C60 alkynyl group, a C1-C60 alkoxy group, a C3-C60 carbocyclic group, a C1-C60 heterocyclic group, a C6-C60 aryloxy group, a C6-C60 arylthio group, a C7-C60 aryl alkyl group, a C2-C60 heteroaryl alkyl group, -Si(Q21)(Q22)(Q23), -N(Q21)(Q22), -B(Q21)(Q22), -C(=O)(Q21), - S(=O)2(Q21), -P(=O)(Q21)(Q22), or any combination thereof; or
-Si(Q31)(Q32)(Q33), -N(Q31)(Q32), -B(Q31)(Q32), -C(=O)(Q31), - S(=O)2(Q31), or -P(=O)(Q31)(Q32),
Q1 to Q3, Q11 to Q13, Q21 to Q23, and Q31 to Q33 is each independently: hydrogen; deuterium; -F; -Cl; -Br; -I; a hydroxyl group; a cyano group; a nitro group; or a C1-C60 alkyl group, a C2-C60 alkenyl group, a C2-C60 alkynyl group, a C1-C60 alkoxy group, a C3-C60 carbocyclic group, or a C1-C60 heterocyclic group, each unsubstituted or substituted with deuterium, - F, a cyano group, a C1-C60 alkyl group, a C1-C60 alkoxy group, a phenyl group, a biphenyl group, or any combination thereof.

2. The light-emitting device (10) of claim 1, wherein an emission peak wavelength of the first light is from about 525 nm to about 545 nm.

3. The light-emitting device (10) of claim 1 or 2, wherein a full width at half maximum of the first light is from about 15 nm to about 60 nm.

4. The light-emitting device (10) of at least one of claims 1 to 3, wherein the first light is a green light.

5. The light-emitting device (10) of at least one of claim 1 to 4, wherein the RCR value of the first light extracted to the outside through the capping layer (170) is from about 32.0 to about 38.0.

6. The light-emitting device (10) of at least one of claims 1 to 5, wherein CIEy is from about 0.715 to about 0.740.

7. The light-emitting device (10) of at least one of claims 1 to 6, wherein:
the second light has a wavelength of 530 nm.

8. The light-emitting device (10) of at least one of claims 1 to 7, wherein:
R(cap) is from about 1.85 to about 2.5.

9. An electronic apparatus comprising the light-emitting device (10) of at least one of claims 1 to 8.

10. The electronic apparatus of claim 9, comprising a color filter, a color conversion layer, a touch screen layer, a polarizing layer, or any combination thereof.

11. A consumer product, comprising the light-emitting device of at least one of claims 1 to 8.

12. The consumer product of claim 11, being one selected from a flat panel display, a curved display, a computer monitor, a medical monitor, a TV, a billboard, indoor or outdoor illuminations and/or a signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual and/or augmented reality displays, vehicles, a video wall including multiple displays tiled together, a theater or stadium screen, a phototherapy device, and/or a signage.

## Patentansprüche

1. Lichtemittierende Vorrichtung (10), umfassend:
eine erste Elektrode (110);
eine zweite Elektrode (150), die der ersten Elektrode (110) zugewandt ist;
eine Zwischenschicht (130) zwischen der ersten Elektrode (110) und der zweiten Elektrode (150) und eine Emissionsschicht umfassend; und
eine Deckschicht (170),
wobei die Emissionsschicht einen ersten Emitter umfasst,
der erste Emitter ein erstes Licht mit einem ersten Emissionsspektrum emittiert, sich die Deckschicht (170) in einem Pfad befindet, auf dem sich das erste Licht bewegt,
eine Emissionspeak-Wellenlänge des ersten Lichts etwa 520 nm bis etwa 550 nm beträgt,
der erste Emitter Platin und einen ersten Liganden, der an das Platin gebunden ist, umfasst, die Deckschicht (170) eine aminhaltige Verbindung umfasst und die aminhaltige Verbindung eine Benzoxazolgruppe, eine Benzothiazolgruppe, eine Naphthooxazolgruppe, eine Naphthothiazolgruppe oder eine Kombination daraus umfasst,
**dadurch gekennzeichnet, dass**
der erste Emitter mindestens zwei erfüllt, die aus Bedingung A bis Bedingung C ausgewählt sind:
Bedingung A
der erste Ligand ist ein vierzähniger Ligand und die Anzahl an cyclometallierten Ringen, die durch die chemische Bindung zwischen dem Platin und dem ersten Liganden gebildet werden, beträgt drei;
Bedingung B
das Platin ist chemisch an einen Kohlenstoff, einen Stickstoff und einen Sauerstoff des ersten Liganden gebunden; und
Bedingung C
der erste Ligand umfasst eine Imidazolgruppe, eine Benzimidazolgruppe, eine Naphthoimidazolgruppe oder eine Kombination daraus,
wobei der erste Emitter eine organometallische Verbindung ist, die durch die Formel 1 dargestellt ist: 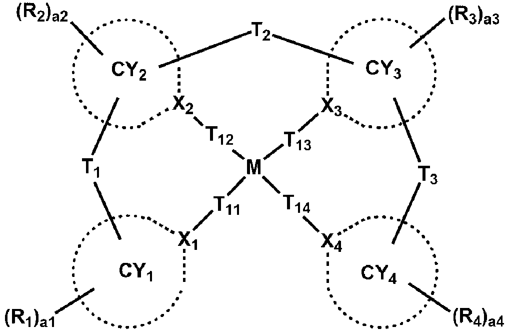
ein Wert eines Verhältnisses von CIEy zu einem Reflexionsindex (RCR-Wert) des ersten Lichts, das durch die Deckschicht (170) nach außen extrahiert wird, 38 oder weniger beträgt und
der RCR-Wert gemäß der Gleichung 1 berechnet wird: $CIEy / R \left(cap\right) \times 100$ Gleichung 1
wobei in Gleichung 1
CIEy ein Wert der y-Koordinate der CIE-Farbkoordinaten des ersten Lichts, das durch die Deckschicht (170) nach außen extrahiert wird, ist und
R(cap) der Brechungsindex der aminhaltigen Verbindung in Bezug auf ein zweites Licht mit einer Wellenlänge innerhalb ± 20 nm der Emissionspeak-Wellenlänge des ersten Lichts ist,
die aminhaltige Verbindung eine Verbindung ist, die durch die Formel 8 dargestellt ist: 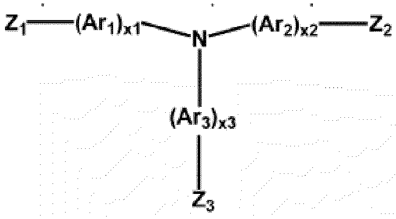
wobei in Formel 1 und 8:
M Pt ist,
X1 bis X4 jeweils unabhängig N oder C sind,
T11 bis T14 jeweils unabhängig eine chemische Bindung, O, S, B(R'), N(R'), P(R'), C(R')(R"), Si(R')(R"), Ge(R')(R"), C(=O), B(R')(R"), N(R')(R") oder P(R')(R") sind,
wenn T11 eine chemische Bindung ist, X1 und M direkt aneinandergebunden sind, wenn T12 eine chemische Bindung ist, X2 und M direkt aneinandergebunden sind, wenn T13 eine chemische Bindung ist, X3 und M direkt aneinandergebunden sind, wenn T14 eine chemische Bindung ist, X4 und M direkt aneinandergebunden sind,
zwei der Bindungen, die aus einer Bindung zwischen X1 oder T11 und M, einer Bindung zwischen X2 oder T12 und M, einer Bindung zwischen X3 oder T13 und M und einer Bindung zwischen X4 oder T14 und M ausgewählt sind,
Koordinatenbindungen sind und die anderen beiden Bindungen kovalente Bindungen sind,
T1 eine Einfachbindung, eine Doppelbindung, *-N(R5)-*', *-B(R5)-*', *-P(R5)-*', *-C(R5a)(R5b)-*', *-Si(R5a)(R5b)-*', *-Ge(R5a)(R5b)-*', *-S-*', *-Se-*', *-O-*', *-C(=O)-*', *-S(=O)-*', *-S(=O)2-*', *-C(R5)=*', *=C(R5)-*', *-C(R5a)=C(R5b)-*', *-C(=S)-*' oder *-C≡C-*' ist,
T2 eine Einfachbindung, eine Doppelbindung, *-N(R6)-*', *-B(R6)-*', *-P(R6)-*', *-C(R6a)(R6b)-*', *-Si(R6a)(R6b)-*', *-Ge(R6a)(R6b)-*', *-S-*', *-Se-*', *-O-*', *-C(=O)-*', *-S(=O)-*', *-S(=O)2-*', *-C(R6)=*', *=C(R6)-*', *-C(R6a)=C(R6b)-*', *-C(=S)-*' oder *-C≡C-*' ist,
T3 eine Einfachbindung, eine Doppelbindung, *-N(R7)-*', *-B(R7)-*', *-P(R7)-*', *-C(R7a)(R7b)-*', *-Si(R7a)(R7b)-*', *-Ge(R7a)(R7b)-*', *-S-*', *-Se-*', *-O-*', *-C(=O)-*', *-S(=O)-*', *-S(=O)2-*', *-C(R7)=*', *=C(R7)-*', *-C(R7a)=C(R7b)-*', *-C(=S)-*' oder *-C≡C-*' ist,
Ring CY1 bis Ring CY4 unabhängig eine carbocyclische C3-C60-Gruppe oder eine heterocyclische C1-C60-Gruppe sind,
Ar1 bis Ar3 und Z1 bis Z3 jeweils unabhängig eine carbocyclische C3-C60-Gruppe, die unsubstituiert oder mit mindestens einem R10a substituiert ist, oder eine heterocyclische C1-C60-Gruppe, die unsubstituiert oder mit mindestens einem R10a substituiert ist, sind,
x1 bis x3 jeweils unabhängig eines sind, das aus einer ganzen Zahl von 0 bis 10 ausgewählt ist,
i) wenn x1 0 ist, *-(Ar1)x1-*' eine Einfachbindung ist, ii) wenn x2 0 ist, *-(Ar2)x2-*' eine Einfachbindung ist, und iii) wenn x3 0 ist, *-(Ar3)x3-*' eine Einfachbindung ist,
R1 bis R7, R5a, R5b, R6a, R6b, R7a, R7b, R' und R" jeweils unabhängig Wasserstoff, Deuterium, -F, -Cl, -Br, -I, eine Hydroxylgruppe, eine Cyanogruppe, eine Nitrogruppe, eine C1-C60-Alkylgruppe, die unsubstituiert oder mit mindestens einem R10a substituiert ist, eine C2-C60-Alkenylgruppe, die unsubstituiert oder mit mindestens einem R10a substituiert ist, eine C2-C60-Alkinylgruppe, die unsubstituiert oder mit mindestens einem R10a substituiert ist, eine C1-C60-Alkoxygruppe, die unsubstituiert oder mit mindestens einem R10a substituiert ist, eine carbocyclische C3-C60-Gruppe, die unsubstituiert oder mit mindestens einem R10a substituiert ist, eine heterocyclische C1-C60-Gruppe, die unsubstituiert oder mit mindestens einem R10a substituiert ist, eine C6-C60-Aryloxygruppe, die unsubstituiert oder mit mindestens einem R10a substituiert ist, eine C6-C60-Arylthiogruppe, die unsubstituiert oder mit mindestens einem R10a substituiert ist, eine C7-C60-Arylalkylgruppe, die unsubstituiert oder mit mindestens einem R10a substituiert ist, eine C2-C60-Heteroarylalkylgruppe, die unsubstituiert oder mit mindestens einem R10a substituiert ist, -C(Q1)(Q2)(Q3), -Si(Q1)(Q2)(Q3), -N(Q1)(Q2), - B(Q1)(Q2), - C(=O)(Q1), -S(=O)2(Q1) oder -P(=O)(Q1)(Q2) sind,
a1 bis a4 jeweils unabhängig eines sind, das aus einer ganzen Zahl von 0 bis 20 ausgewählt ist,
* und *' jeweils eine Bindungsstelle an ein angrenzendes Atom angeben,
jedes von i) zwei Gruppen von R1(s) in der Reihe von a1, ii) zwei Gruppen von R2(s) in der Reihe von a2, iii) zwei Gruppen von R3(s) in der Reihe von a3, iv) zwei Gruppen von R4(s) in der Reihe von a4, v) R5a und R5b, vi) R6a und R6b und vii) R7a und R7b gegebenenfalls über eine Einfachbindung, eine Doppelbindung oder eine erste Verknüpfungsgruppe aneinandergebunden ist, um eine carbocyclische C3-C60-Gruppe, die unsubstituiert oder mit mindestens einem R10a substituiert ist, oder eine heterocyclische C1-C60-Gruppe, die unsubstituiert oder mit mindestens einem R10a substituiert ist, zu bilden,
R10a Folgendes ist:
Deuterium, -F, -Cl, -Br, -I, eine Hydroxylgruppe, eine Cyanogruppe oder eine Nitrogruppe,
eine C1-C60-Alkylgruppe, eine C2-C60-Alkenylgruppe, eine C2-C60-Alkinylgruppe oder eine C1-C60-Alkoxygruppe, jeweils unsubstituiert oder mit Deuterium, -F, -Cl, -Br, -I, einer Hydroxylgruppe, einer Cyanogruppe, einer Nitrogruppe, einer carbocyclischen C3-C60-Gruppe, einer heterocyclischen C1-C60-Gruppe, einer C6-C60-Aryloxygruppe, einer C6-C60-Arylthiogruppe, einer C7-C60-Arylalkylgruppe, einer C2-C60-Heteroarylalkylgruppe, - Si(Q11)(Q12)(Q13), -N(Q11)(Q12), -B(Q11)(Q12), -C(=O)(Q11), -S(=O)2(Q11), - P(=O)(Q11)(Q12) oder einer Kombination daraus substituiert,
eine carbocyclische C3-C60-Gruppe, eine heterocyclische C1-C60-Gruppe,
eine C6-C60-Aryloxygruppe, eine C6-C60-Arylthiogruppe, eine C7-C60-Arylalkylgruppe oder eine C2-C60-Heteroarylalkylgruppe, jeweils unsubstituiert oder mit Deuterium, -F, -Cl, -Br, -I, einer Hydroxylgruppe, einer Cyanogruppe,
einer Nitrogruppe, einer C1-C60-Alkylgruppe, einer C2-C60-Alkenylgruppe,
einer C2-C60-Alkinylgruppe, einer C1-C60-Alkoxygruppe, einer carbocyclischen C3-C60-Gruppe, einer heterocyclischen C1-C60-Gruppe, einer C6-C60-Aryloxygruppe, einer C6-C60-Arylthiogruppe, einer C7-C60-Arylalkylgruppe,
einer C2-C60-Heteroarylalkylgruppe, -Si(Q21)(Q22)(Q23), -N(Q21)(Q22), - B(Q21)(Q22), -C(=O)(Q21), - S(=O)2(Q21), -P(=O)(Q21)(Q22) oder einer Kombination daraus substituiert; oder
-Si(Q31)(Q32)(Q33), -N(Q31)(Q32), -B(Q31)(Q32), -C(=O)(Q31), -S(=O)2(Q31) oder -P(=O)(Q31)(Q32),
Q1 bis Q3, Q11 bis Q13, Q21 bis Q23 und Q31 bis Q33 jeweils unabhängig Folgendes sind: Wasserstoff; Deuterium; -F; -Cl; -Br; -I; eine Hydroxylgruppe;
eine Cyanogruppe; eine Nitrogruppe; oder eine C1-C60-Alkylgruppe, eine C2-C60-Alkenylgruppe, eine C2-C60-Alkinylgruppe, eine C1-C60-Alkoxygruppe, eine carbocyclische C3-C60-Gruppe oder eine heterocyclische C1-C60-Gruppe, jeweils unsubstituiert oder mit Deuterium, -F, einer Cyanogruppe, einer C1-C60-Alkylgruppe, einer C1-C60-Alkoxygruppe, einer Phenylgruppe, einer Biphenylgruppe oder einer beliebigen Kombination daraus substituiert.

2. Lichtemittierende Vorrichtung (10) nach Anspruch 1, wobei eine Emissionspeak-Wellenlänge des ersten Lichts von etwa 525 bis etwa 545 nm beträgt.

3. Lichtemittierende Vorrichtung (10) nach Anspruch 1 oder 2, wobei eine volle Breite bei halbem Maximum des ersten Lichts von etwa 15 nm bis etwa 60 nm beträgt.

4. Lichtemittierende Vorrichtung (10) nach mindestens einem der Ansprüche 1 bis 3, wobei das erste Licht ein grünes Licht ist.

5. Lichtemittierende Vorrichtung (10) nach mindestens einem der Ansprüche 1 bis 4, wobei der RCR-Wert des ersten Lichts, das durch die Deckschicht (170) nach außen extrahiert wird, von etwa 32,0 bis etwa 38,0 beträgt.

6. Lichtemittierende Vorrichtung (10) nach mindestens einem der Ansprüche 1 bis 5, wobei CIEy von etwa 0,715 bis etwa 0,740 beträgt.

7. Lichtemittierende Vorrichtung (10) nach mindestens einem der Ansprüche 1 bis 6, wobei:
das zweite Licht eine Wellenlänge von 530 nm aufweist.

8. Lichtemittierende Vorrichtung (10) nach mindestens einem der Ansprüche 1 bis 7, wobei:
R(cap) von etwa 1,85 bis etwa 2,5 beträgt.

9. Elektronische Einrichtung, umfassend die lichtemittierende Vorrichtung (10) nach mindestens einem der Ansprüche 1 bis 8.

10. Elektronische Einrichtung nach Anspruch 9, umfassend einen Farbfilter, eine Farbumwandlungsschicht, eine Touchscreenschicht, eine Polarisierungsschicht oder eine beliebige Kombination daraus.

11. Verbraucherprodukt, umfassend die lichtemittierende Vorrichtung nach mindestens einem der Ansprüche 1 bis 8.

12. Verbraucherprodukt nach Anspruch 11, wobei eines ausgewählt ist aus einem Flachbilddisplay, einem gebogenen Display, einem Computermonitor, einem medizinischen Monitor, einem TV, einer Werbetafel, Innen- oder Außenbeleuchtungen und/oder einer Signalleuchte, einem Head-up-Display, einem vollständig oder teilweise transparenten Display, einem flexiblen Display, einem rollbaren Display, einem faltbaren Display, einem dehnbaren Display, einem Laserdrucker, einem Telefon, einem Mobiltelefon, einem Tablet, einem Phablet, einem Personal Digital Assistant (PDA), einer tragbaren Vorrichtung, Laptop-Computern, Digitalkameras, Camcordern, Bildsuchern, Mikrodisplays, 3D-Displays, Virtual- und/oder Augmented-Reality-Displays, Fahrzeugen, einer Videowand, an der mehrere Displays zusammengefügt sind, einem Theater- oder Stadionbildschirm, einer Lichttherapievorrichtung und/oder einer Lichtwerbung.

## Revendications

1. Dispositif émetteur de lumière (10) comprenant :
une première électrode (110) ;
une deuxième électrode (150) faisant face à la première électrode (110) ;
une couche intermédiaire (130) entre la première électrode (110) et la deuxième électrode (150) et comprenant une couche d'émission ; et
une couche de recouvrement (170),
dans lequel la couche d'émission comprend un premier émetteur,
le premier émetteur émet une première lumière ayant un premier spectre d'émission,
la couche de recouvrement (170) se trouve dans un trajet le long duquel la première lumière se propage,
une longueur d'onde de pic d'émission de la première lumière est d'environ 520 nm à environ 550 nm,
le premier émetteur comprend du platine et un premier ligand lié au platine, la couche de recouvrement (170) comprend un composé contenant une amine, et
le composé contenant une amine comprend un groupe benzoxazole, un groupe benzothiazole, un groupe naphtooxazole, un groupe naphtothiazole, ou une quelconque de leurs combinaisons
**caractérisé en ce que**
le premier émetteur satisfait au moins deux conditions choisies parmi une condition A jusqu'à une condition C :
Condition A
le premier ligand est un ligand tétradentate, et le nombre de cycles cyclométallés formés par la liaison chimique entre le platine et le premier ligand est de trois ;
Condition B
le platine est chimiquement lié à un carbone, un azote et un oxygène du premier ligand ; et
Condition C
le premier ligand comprend un groupe imidazole, un groupe benzimidazole, un groupe naphtoimidazole, ou une quelconque de leurs combinaisons,
dans lequel le premier émetteur est un composé organométallique représenté par la formule 1 : 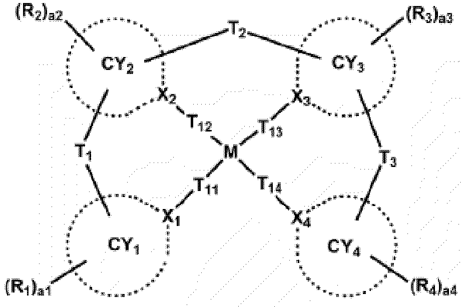
une valeur d'un rapport entre CIEy et un indice de réflexion (valeur RCR) de la première lumière extraite vers l'extérieur à travers la couche de recouvrement (170) est de 38 ou moins, et
la valeur RCR est calculée selon l'équation 1 : $CIEy / R \left(cap\right) \times 100$ Équation 1.
dans lequel, dans l'équation 1,
CIEy est une valeur de coordonnée y des coordonnées chromatiques CIE de la première lumière extraite vers l'extérieur à travers la couche de recouvrement (170), et
R(cap) est l'indice de réfraction du composé contenant une amine par rapport à une deuxième lumière ayant une longueur d'onde à près de ± 20 nm de la longueur d'onde de pic d'émission de la première lumière,
le composé contenant une amine est un composé représenté par la formule 8 : 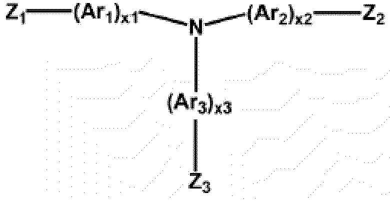
dans lequel, dans les formules 1 et 8 :
M est Pt,
X1 à X4 sont chacun indépendamment N ou C,
T11 à T14 sont chacun indépendamment une liaison chimique, O, S, B(R'), N(R'), P(R'), C(R')(R"), Si(R')(R"), Ge(R')(R"), C(=O), B(R')(R"), N(R')(R") ou P(R')(R"),
lorsque T11 est une liaison chimique, X1 et M sont directement liés l'un à l'autre, lorsque T12 est une liaison chimique, X2 et M sont directement liés l'un à l'autre, lorsque T13 est une liaison chimique, X3 et M sont directement liés l'un à l'autre, lorsque T14 est une liaison chimique, X4 et M sont directement liés l'un à l'autre, deux des liaisons choisies parmi une liaison entre X1 ou T11 et M, une liaison entre X2 ou T12 et M, une liaison entre X3 ou T13 et M, et une liaison entre X4 ou T14 et M sont des liaisons de coordination, et les deux autres liaisons sont des liaisons covalentes,
T1 est une liaison simple, une liaison double, *-N(R5)-*', *-B(R5)-*', *-P(R5)-*', *-C(R5a)(R5b)-*', *-Si(R5a)(R5b)-*', *-Ge(R5a)(R5b)-*', *-S-*', *-Se-*', *-O-*', *-C(=O)-*', *-S(=O)-*', *-S(=O)2-*', *-C(R5)=*', *=C(R5)-*', *-C(R5a)=C(R5b)-*', *-C(=S)-*', ou *-C≡C-*',
T2 est une liaison simple, une liaison double, *-N(R6)-*', *-B(R6)-*', *-P(R6)-*', *-C(R6a)(R6b)-*', *-Si(R6a)(R6b)-*', *-Ge(R6a)(R6b)-*', *-S-*', *-Se-*', *-O-*', *-C(=O)-*', *-S(=O)-*', *-S(=O)2-*', *-C(R6)=*', *=C(R6)-*', *-C(R6a)=C(R6b)-*', *-C(=S)-*', ou *-C≡C-*',
T3 est une liaison simple, une liaison double, *-N(R7)-*', *-B(R7)-*', *-P(R7)-*', *-C(R7a)(R7b)-*', *-Si(R7a)(R7b)-*', *-Ge(R7a)(R7b)-*', *-S-*', *-Se-*', *-O-*', *-C(=O)-*', *-S(=O)-*', *-S(=O)2-*', *-C(R7)=*', *=C(R7)-*', *-C(R7a)=C(R7b)-*', *-C(=S)-*', ou *-C≡C-*',
cycle CY1 à cycle CY4 sont indépendamment un groupe carbocyclique en C3 à C60 ou un groupe hétérocyclique en C1 à C60,
Ar1 à Ar3 et Z1 à Z3 sont chacun indépendamment un groupe carbocyclique en C3 à C60 non substitué ou substitué par au moins un R10a, ou un groupe hétérocyclique en C1 à C60 non substitué ou substitué par au moins un R10a,
x1 à x3 sont chacun indépendamment un nombre choisi parmi un nombre entier de 0 à 10,
i) lorsque x1 est 0, *-(Ar1)x1-*' est une liaison simple, ii) lorsque x2 est 0, *-(Ar2)x2-*' est une liaison simple, et iii) lorsque x3 est 0, *-(Ar3)x3-*' est une liaison simple,
R1 à R7, R5a, R5b, R6a, R6b, R7a, R7b, R' et R" sont chacun indépendamment hydrogène, deutérium, -F, -Cl, -Br, -I, un groupe hydroxyle, un groupe cyano, un groupe nitro, un groupe alkyle en C1 à C60 non substitué ou substitué par au moins un R10a, un groupe alcényle en C2 à C60 non substitué ou substitué par au moins un R10a, un groupe alcynyle en C2 à C60 non substitué ou substitué par au moins un R10a, un groupe alcoxy en C1 à C60 non substitué ou substitué par au moins un R10a, un groupe carbocyclique en C3 à C60 non substitué ou substitué par au moins un R10a, un groupe hétérocyclique en C1 à C60 non substitué ou substitué par au moins un R10a, un groupe aryloxy en C6 à C60 non substitué ou substitué par au moins un R10a, un groupe arylthio en C6 à C60 non substitué ou substitué par au moins un R10a, un groupe arylalkyle en C7 à C60 non substitué ou substitué par au moins un R10a, un groupe hétéroarylalkyle en C2 à C60 non substitué ou substitué par au moins un R10a, - C(Q1)(Q2)(Q3), -Si(Q1)(Q2)(Q3), -N(Q1)(Q2), -B(Q1)(Q2), -C(=O)(Q1), -S(=O)2(Q1), ou -P(=O)(Q1)(Q2),
a1 à a4 sont chacun indépendamment choisis parmi un nombre entier de 0 à 20, * et *' indiquent chacun un site de liaison à un atome adjacent,
chacun parmi i) deux groupes de R1 dans le nombre de a1, ii) deux groupes de R2 dans le nombre de a2, iii) deux groupes de R3 dans le nombre de a3, iv) deux groupes de R4 dans le nombre de a4, v) R5a et R5b, vi) R6a et R6b, et vii) R7a et R7b, est facultativement lié aux autres via une liaison simple, une liaison double ou un premier groupe de liaison pour former un groupe carbocyclique en C3 à C60 non substitué ou substitué par au moins un R10a ou un groupe hétérocyclique en C1 à C60 non substitué ou substitué par au moins un R10a,
R10a est :
deutérium, -F, -Cl, -Br, -I, un groupe hydroxyle, un groupe cyano ou un groupe nitro,
un groupe alkyle en C1 à C60, un groupe alcényle en C2 à C60, un groupe alcynyle en C2 à C60 ou un groupe alcoxy en C1 à C60, chacun non substitué ou substitué par deutérium, -F, - Cl, -Br, -I, un groupe hydroxyle, un groupe cyano, un groupe nitro, un groupe carbocyclique en C3 à C60, un groupe hétérocyclique en C1 à C60, un groupe aryloxy en C6 à C60, un groupe arylthio en C6 à C60, un groupe arylalkyle en C7 à C60, un groupe hétéroarylalkyle en C2 à C60, -Si(Q11)(Q12)(Q13), -N(Q11)(Q12), -B(Q11)(012), -C(=O)(Q11), -S(=O)2(Q11), -P(=O)(Q11)(Q12), ou une quelconque de leurs combinaison,
un groupe carbocyclique en C3 à C60, un groupe hétérocyclique en C1 à C60, un groupe aryloxy en C6 à C60, un groupe arylthio en C6 à C60, un groupe arylalkyle en C7 à C60 ou un groupe hétéroarylalkyle en C2 à C60, chacun non substitué ou substitué par deutérium, -F, -Cl, - Br, -I, un groupe hydroxyle, un groupe cyano, un groupe nitro, un groupe alkyle en C1 à C60, un groupe alcényle en C2 à C60, un groupe alcynyle en C2 à C60, un groupe alcoxy en C1 à C60, un groupe carbocyclique en C3 à C60, un groupe hétérocyclique en C1 à C60, un groupe aryloxy en C6 à C60, un groupe arylthio en C6 à C60, un groupe arylalkyle en C7 à C60, un groupe hétéroarylalkyle en C2 à C60, -Si(Q21)(Q22)(Q23), -N(Q21)(Q22), -B(Q21)(Q22), -C(=O)(Q21), -S(=O)2(Q21), -P(=O)(Q21)(Q22), ou une quelconque de leurs combinaisons ; ou -Si(Q31)(Q32)(Q33), -N(Q31)(Q32), -B(Q31)(Q32), -C(=O)(Q31), - S(=O)2(Q31), ou -P(=O)(Q31)(Q32),
Q1 à Q3, Q11 à Q13, Q21 à Q23 et Q31 à Q33 sont chacun indépendamment : hydrogène ; deutérium ; -F ; -Cl ; -Br ; -I ; un groupe hydroxyle ; un groupe cyano ; un groupe nitro ; ou un groupe alkyle en C1 à C60, un groupe alcényle en C2 à C60, un groupe alcynyle en C2 à C60, un groupe alcoxy en C1 à C60, un groupe carbocyclique en C3 à C60 ou un groupe hétérocyclique en C1 à C60, chacun non substitué ou substitué par deutérium, -F, un groupe cyano, un groupe alkyle en C1 à C60, un groupe alcoxy en C1 à C60, un groupe phényle, un groupe biphényle, ou une quelconque de leurs combinaisons.

2. Dispositif émetteur de lumière (10) selon la revendication 1, dans lequel une longueur d'onde de pic d'émission de la première lumière est d'environ 525 nm à environ 545 nm.

3. Dispositif émetteur de lumière (10) selon la revendication 1 ou 2, dans lequel une largeur totale à mi-hauteur de la première lumière est d'environ 15 nm à environ 60 nm.

4. Dispositif émetteur de lumière (10) selon au moins l'une des revendications 1 à 3, dans lequel la première lumière est une lumière verte.

5. Dispositif émetteur de lumière (10) selon au moins l'une des revendications 1 à 4, dans lequel la valeur RCR de la première lumière extraite vers l'extérieur à travers la couche de recouvrement (170) est d'environ 32,0 à environ 38,0.

6. Dispositif émetteur de lumière (10) selon au moins l'une des revendications 1 à 5, dans lequel CIEy est d'environ 0,715 à environ 0,740.

7. Dispositif émetteur de lumière (10) selon au moins l'une des revendications 1 à 6, dans lequel :
la deuxième lumière a une longueur d'onde de 530 nm.

8. Dispositif émetteur de lumière (10) selon au moins l'une des revendications 1 à 7, dans lequel :
R(cap) est d'environ 1,85 à environ 2,5.

9. Appareil électronique comprenant le dispositif émetteur de lumière (10) d'au moins l'une des revendications 1 à 8.

10. Appareil électronique selon la revendication 9, comprenant un filtre de couleur, une couche de conversion de couleur, une couche d'écran tactile, une couche polarisante, ou une quelconque de leurs combinaisons.

11. Produit de consommation, comprenant le dispositif émetteur de lumière d'au moins l'une des revendications 1 à 8.

12. Produit de consommation selon la revendication 11, qui est un choisi parmi un écran plat, un écran incurvé, un moniteur, un moniteur médical, un téléviseur, un panneau d'affichage, des éclairages intérieurs ou extérieurs et/ou un feu de signalisation, un affichage tête haute, un écran entièrement ou partiellement transparent, un écran flexible, un écran enroulable, un écran pliable, un écran extensible, une imprimante laser, un téléphone, un téléphone mobile, une tablette, une phablette, un assistant numérique personnel (PDA), un dispositif habitronique, des ordinateurs portables, des appareils photo numériques, des caméscopes, des viseurs, des microécrans, des écrans 3D, des écrans de réalité virtuelle et/ou augmentée, des véhicules, un mur vidéo incluant de multiples écrans assemblés, un écran de cinéma ou de stade, un dispositif de photothérapie et/ou une signalisation.
